# EUROPEAN PATENT APPLICATION

(11) **EP 4 835 569 A1**
(43) Date of publication of application: **04.11.2026**
(21) Application number: 24912383.7
(22) Date of filing: 11.12.2024
(51) Int. Cl.: G03F 7/004, G02B 5/20

(54) **PHOTOSENSITIVE COMPOSITION, FILM, OPTICAL FILTER, OPTICAL FILTER MANUFACTURING METHOD, SOLID-STATE IMAGING ELEMENT, AND IMAGE DISPLAY DEVICE**

(30) Priority: 25.12.2023 JP 2023218105
(71) Applicant: FUJIFILM Corporation, Tokyo 106-8620 (JP)
(72) Inventor: ORITA, Ryoji, Haibara-gun, Shizuoka 421-0396 (JP); MATSUDA, Tomoki, Haibara-gun, Shizuoka 421-0396 (JP)
(74) Representative: HGF
(86) International application number: PCT/JP2024/043852
(87) International publication number: WO 2025/142494

(57) **Abstract**

Provided are a photosensitive composition contains a coloring material, a resin, a polymerizable compound, a photopolymerization initiator, a solvent, and a compound A represented by Formula (1); a film formed of the photosensitive composition; an optical filter; a method for manufacturing an optical filter; a solid-state imaging element; and an image display device.

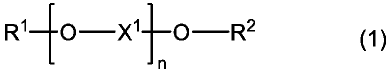

## Description

### BACKGROUND OF THE INVENTION

### 1. Field of the Invention

The present invention relates to a photosensitive composition containing a coloring material. In addition, the present invention relates to a film formed of the photosensitive composition, an optical filter, a method for manufacturing an optical filter, a solid-state imaging element, and an image display device.

### 2. Description of the Related Art

In recent years, as a digital camera, a mobile phone with a camera, and the like have been further spreading, there has been a greatly increasing demand for a solid-state imaging element such as a charge coupled device (CCD) image sensor. A color filter has been used as a key device in a display or an optical element. The color filter normally includes pixels of three primary colors of red, green, and blue, and acts to separate transmitted light into the three primary colors.

Pixels of each color of the color filter are manufactured by forming a pattern using a photosensitive composition containing a coloring material by a photolithography method.

As disclosed in JP2022-063556A, a photosensitive composition containing a coloring material, a resin, a polymerizable compound, a photopolymerization initiator, and a solvent is used.

### SUMMARY OF THE INVENTION

In recent years, higher resolution of a solid-state imaging element including an optical filter such as a color filter has also been promoted. Therefore, further miniaturization of a size of the pixel has been studied for the optical filter such as the color filter.

In a case where a pixel is formed by forming a pattern using a photosensitive composition by a photolithography method or the like, chipping may occur on a surface of the pixel during the formation of the pixel, and there is a tendency that the chipping is likely to occur on the surface of the pixel as the size of the pixel is miniaturized.

Therefore, an object of the present invention is to provide a photosensitive composition capable of forming a pixel in which occurrence of chipping is suppressed. Another object of the present invention is to provide a film, an optical filter, a method for manufacturing an optical filter, a solid-state imaging element, and an image display device.

According to the studies of the present inventor, it has been found that the above-described objects can be achieved by a photosensitive composition described later, thereby completing the present invention. As a result, the present invention provides the following aspects.
<1> A photosensitive composition comprising:
   a coloring material;
   a resin;
   a polymerizable compound;
   a photopolymerization initiator;
   a solvent; and
   a compound A represented by Formula (1), 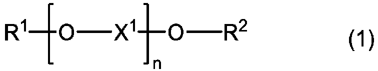
   in Formula (1), R¹ and R² each independently represent a hydrogen atom, an alkyl group having 1 to 6 carbon atoms, an aryl group having 6 to 12 carbon atoms, a group having 1 to 6 carbon atoms, which includes an acid group, or a group having 1 to 6 carbon atoms, which includes an amino group, X¹ represents a linear or branched alkylene group, n represents an integer of 1 or more, and in a case where n is 2 or more, a plurality of X¹'s may be the same or different from each other.
<2> The photosensitive composition according to <1>, in which at least one of X¹'s in Formula (1) is an ethylene group, and R¹ and R² are each independently a hydrogen atom or an alkyl group having 1 to 6 carbon atoms.
<3> The photosensitive composition according to <1>, in which X¹ in Formula (1) is an ethylene group, and R¹ and R² are each independently a hydrogen atom or an alkyl group having 1 to 6 carbon atoms.
<4> The photosensitive composition according to any one of <1> to <3>, in which R¹ and R² in Formula (1) are hydrogen atoms.
<5> The photosensitive composition according to any one of <1> to <4>, in which a molecular weight of the compound A is 150 to 2,000.
<6> The photosensitive composition according to any one of <1> to <5>, in which a content of the compound A in the photosensitive composition is 0.01% to 5.0% by mass.
<7> The photosensitive composition according to any one of <1> to <6>, in which a content of the coloring material is 55% by mass or more with respect to a total solid content of the photosensitive composition.
<8> A film formed of the photosensitive composition according to any one of <1> to <7>.
<9> An optical filter comprising: the film according to <8>.
<10> A method for manufacturing an optical filter, comprising:
   forming a composition layer on a support using the photosensitive composition according to any one of <1> to <7>; and
   forming a pattern on the composition layer by a photolithography method.
<11> A solid-state imaging element comprising: the film according to <8>.
<12> An image display device comprising: the film according to <8>.

According to the present invention, it is possible to provide a photosensitive composition capable of forming a pixel in which occurrence of chipping is suppressed. In addition, according to the present invention, it is possible to provide a film, an optical filter, a method for manufacturing an optical filter, a solid-state imaging element, and an image display device.

### BRIEF DESCRIPTION OF THE DRAWINGS

FIG. 1 is a side cross-sectional view showing an embodiment of a support.
FIG. 2 is a plan view of the support of FIG. 1 as seen from directly above.

### DESCRIPTION OF THE PREFERRED EMBODIMENTS

Hereinafter, the contents of the present disclosure will be described in detail.

In the present specification, "to" is used to mean that numerical values described before and after "to" are included as a lower limit value and an upper limit value, respectively.

In the present specification, unless specified as a substituted group or as an unsubstituted group, a group (atomic group) denotes not only a group (atomic group) having no substituent but also a group (atomic group) having a substituent. For example, an "alkyl group" includes not only an alkyl group having no substituent (unsubstituted alkyl group), but also an alkyl group having a substituent (substituted alkyl group).

In the present specification, unless specified otherwise, "exposure" denotes not only exposure using light but also drawing using a corpuscular beam such as an electron beam or an ion beam. Examples of the light used for exposure include an actinic ray or radiation, for example, a bright light spectrum of a mercury lamp, a far ultraviolet ray represented by excimer laser, an extreme ultraviolet ray (EUV light), an X-ray, or an electron beam.

In the present specification, "(meth)acrylate" denotes either or both of acrylate and methacrylate, "(meth)acryl" denotes either or both of acryl and methacryl, and "(meth)acryloyl" denotes either or both of acryloyl and methacryloyl.

In the structural formulae of the present specification, Me represents a methyl group, Et represents an ethyl group, Bu represents a butyl group, and Ph represents a phenyl group.

In the present specification, a weight-average molecular weight and a number-average molecular weight are values in terms of polystyrene through measurement by a gel permeation chromatography (GPC) method.

In the present specification, the total solid content refers to the total mass of components excluding a solvent from the entire components of the composition.

In the present specification, a pigment means a coloring material which is hardly dissolved in a solvent.

In the present specification, the term "step" includes not only an independent step but also a step that cannot be clearly distinguished from other steps, as long as the intended action of the step is achieved.

### <Photosensitive composition>

A photosensitive composition according to an embodiment of the present invention contains a coloring material, a resin, a polymerizable compound, a photopolymerization initiator, a solvent, and a compound A represented by Formula (1).

The photosensitive composition according to the embodiment of the present invention can form a pixel in which occurrence of chipping is suppressed. The reason for obtaining such an effect is presumed as follows. The reason is presumed that the photosensitive composition according to the embodiment of the present invention contains the compound A represented by Formula (1), and thus it is possible to impart moderate flexibility to a film obtained from the compound A represented by Formula (1), and as a result, it is possible to suppress the occurrence of chipping during development.

In addition, as a content of the coloring material in the total solid content of the photosensitive composition is increased, there is a tendency that, in a case of forming a pattern by a photolithography method to form a pixel, chipping is likely to occur in the pixel. However, with the photosensitive composition according to the embodiment of the present invention, even in a case where the content of the coloring material in the total solid content of the photosensitive composition is large, the occurrence of chipping can be suppressed. Therefore, in a case of forming a pattern by a photolithography method using the photosensitive composition having the high content of the coloring material in the total solid content of the photosensitive composition to form a pixel, the effect of the present invention is more remarkably exhibited.

In addition, in recent years, it has been studied to form a pixel in a region partitioned by a partition wall on a support having a partition wall. However, in a case where the pixel is formed in the region partitioned by the partition wall, there is a tendency that chipping is likely to occur in the pixel as compared with a case where the pixel is formed on a support in which the partition wall is not present. With the photosensitive composition according to the embodiment of the present invention, even in a case where a pixel is formed in a region partitioned by a partition wall on a support having a partition wall, the occurrence of chipping can be suppressed. Therefore, in a case of forming a pixel in a region partitioned by a partition wall, the effect of the present invention is more remarkably exhibited in the photosensitive composition according to the embodiment of the present invention.

The photosensitive composition according to the embodiment of the present invention is different from a photosensitive composition in which the compound A represented by Formula (1) is contained in the composition as a result of containing, in the photosensitive composition, a processed pigment obtained by treating, for example, a pigment or the like with the compound A represented by Formula (1), in that the photosensitive composition according to the embodiment of the present invention contains the compound A represented by Formula (1) in the photosensitive composition by further adding the compound A represented by Formula (1) in addition to the coloring material, the resin, the polymerizable compound, the photopolymerization initiator, and the solvent.

The photosensitive composition according to the embodiment of the present invention is preferably used as a photosensitive composition for an optical filter. Examples of the optical filter include a color filter, an infrared transmitting filter, and an infrared cut filter, and a color filter is preferable.

Examples of the color filter include a filter having a colored pixel which transmits light having a specific wavelength. Examples of the colored pixel include a red pixel, a blue pixel, a green pixel, a yellow pixel, a cyan pixel, and a magenta pixel. The colored pixel of the color filter can be formed of a photosensitive composition containing a chromatic coloring material.

A maximal absorption wavelength of the infrared cut filter is preferably in a wavelength range of 700 to 1800 nm, more preferably in a wavelength range of 700 to 1300 nm, and still more preferably in a wavelength range of 700 to 1000 nm. In addition, in the infrared cut filter, a transmittance in the entire wavelength range of 400 to 650 nm is preferably 70% or more, more preferably 80% or more, and still more preferably 90% or more. In addition, the transmittance at at least one point in a wavelength range of 700 to 1800 nm is preferably 20% or less. In addition, in the infrared cut filter, (absorbance Amax/absorbance A550), which is a ratio of an absorbance Amax at a maximal absorption wavelength to an absorbance A550 at a wavelength of 550 nm, is preferably 20 to 500, more preferably 50 to 500, still more preferably 70 to 450, and particularly preferably 100 to 400. The infrared cut filter can be formed of a photosensitive composition containing an infrared absorbing coloring material.

The infrared transmitting filter is a filter which transmits at least a part of infrared rays. As the infrared transmitting filter, a filter which shields at least a part of visible light and transmits at least a part of infrared rays is preferable. Preferred examples of the infrared transmitting filter include filters satisfying spectral characteristics in which the maximum value of a transmittance in a wavelength range of 400 to 640 nm is 20% or less (preferably 15% or less and more preferably 10% or less) and the minimum value of a transmittance in a wavelength range of 1100 to 1300 nm is 70% or more (preferably 75% or more and more preferably 80% or more). The infrared transmitting filter is preferably a filter which satisfies any one of the following spectral characteristics (1) to (5).
(1): filter in which the maximum value of a transmittance in a wavelength range of 400 to 640 nm is 20% or less (preferably 15% or less and more preferably 10% or less) and the minimum value of a transmittance in a wavelength range of 800 to 1500 nm is 70% or more (preferably 75% or more and more preferably 80% or more).
(2): filter in which the maximum value of a transmittance in a wavelength range of 400 to 750 nm is 20% or less (preferably 15% or less and more preferably 10% or less) and the minimum value of a transmittance in a wavelength range of 900 to 1500 nm is 70% or more (preferably 75% or more and more preferably 80% or more).
(3): filter in which the maximum value of a transmittance in a wavelength range of 400 to 830 nm is 20% or less (preferably 15% or less and more preferably 10% or less) and the minimum value of a transmittance in a wavelength range of 1000 to 1500 nm is 70% or more (preferably 75% or more and more preferably 80% or more).
(4): filter in which the maximum value of a transmittance in a wavelength range of 400 to 950 nm is 20% or less (preferably 15% or less and more preferably 10% or less) and the minimum value of a transmittance in a wavelength range of 1100 to 1500 nm is 70% or more (preferably 75% or more and more preferably 80% or more).
(5): filter in which the maximum value of a transmittance in a wavelength range of 400 to 1050 nm is 20% or less (preferably 15% or less and more preferably 10% or less) and the minimum value of a transmittance in a wavelength range of 1200 to 1500 nm is 70% or more (preferably 75% or more and more preferably 80% or more).

A concentration of solid contents of the photosensitive composition according to the embodiment of the present invention is preferably 5% to 30% by mass. The lower limit is preferably 7.5% by mass or more and more preferably 10% by mass or more. The upper limit is preferably 25% by mass or less, more preferably 20% by mass or less, and still more preferably 15% by mass or less.

Hereinafter, each of the components used in the photosensitive composition according to the embodiment of the present invention will be described.

### <<Coloring material>>

The photosensitive composition according to the embodiment of the present invention contains a coloring material. Examples of the coloring material include a white coloring material, a black coloring material, a chromatic coloring material, and an infrared absorbing coloring material. In the present invention, the white coloring material includes not only a pure white coloring material but also includes a bright gray (for example, grayish-white, light gray, and the like) coloring material close to white.

The coloring material may be a pigment or a dye. The pigment and the dye may be used in combination. The pigment may be an inorganic pigment or an organic pigment, but from the viewpoint of many color variations, ease of dispersion, safety, and the like, an organic pigment is preferable. A pigment derivative can also be used as the coloring material. In a case where a pigment is used as the coloring material, it is preferable to use the pigment and the pigment derivative in combination.

An average primary particle diameter of the pigment and the pigment derivative is preferably 1 to 200 nm. The lower limit is preferably 5 nm or more and more preferably 10 nm or more. The upper limit is preferably 180 nm or less, more preferably 150 nm or less, and still more preferably 100 nm or less. In the present specification, the primary particle diameter of the pigment and the pigment derivative can be determined from a photograph obtained by observing primary particles of the pigment and the pigment derivative with a transmission electron microscope. Specifically, a projected area of the primary particles of the pigment is determined, and the corresponding equivalent circle diameter is calculated as the primary particle diameter of the pigment. In addition, the average primary particle diameter in the present invention is an arithmetic average of the primary particle diameters with respect to 400 primary particles of the pigment. In addition, the primary particles of the pigment refer to particles which are independent without aggregation. The same applies to the average primary particle diameter of the pigment derivative.

A crystallite size of the pigment and the pigment derivative, as determined from a half-width of a peak derived from any crystal plane in an X-ray diffraction spectrum obtained using CuKα radiation as an X-ray source, is preferably 0.1 to 100 nm, more preferably 0.5 to 50 nm, still more preferably 1 to 30 nm, and particularly preferably 5 to 25 nm.

A specific surface area of the pigment and the pigment derivative is preferably 1 to 300 m²/g. The lower limit thereof is preferably 10 m²/g or more, and more preferably 30 m²/g or more. The upper limit thereof is preferably 250 m²/g or less, and more preferably 200 m²/g or less. The value of the specific surface area can be measured according to determination of the specific surface area of solids by gas adsorption (DIN 66131) in accordance with the Brunauer, Emmett, and Teller (BET) method.

The coloring material contained in the photosensitive composition according to the embodiment of the present invention preferably includes a chromatic coloring material, and more preferably includes a chromatic coloring material and a pigment derivative. In addition, the chromatic coloring material preferably includes a pigment (chromatic pigment).

### (Chromatic coloring material)

Examples of the chromatic coloring material include a coloring material having a maximal absorption wavelength in a wavelength range of 400 to 700 nm. Examples thereof include a green coloring material, a red coloring material, a yellow coloring material, a violet coloring material, a blue coloring material, and an orange coloring material.

Examples of the red coloring material include a diketopyrrolopyrrole compound, an anthraquinone compound, an azo compound, a naphthol compound, an azomethine compound, a xanthene compound, a quinacridone compound, a perylene compound, and a thioindigo compound. The diketopyrrolopyrrole compound, the anthraquinone compound, or the azo compound is preferable, and the diketopyrrolopyrrole compound is more preferable. In addition, the red coloring material is preferably a pigment (red pigment), and more preferably a diketopyrrolopyrrole pigment.

Specific examples of the red coloring material include red pigments such as Color Index (C. I. ) Pigment Red 1, 2, 3, 4, 5, 6, 7, 9, 10, 14, 17, 22, 23, 31, 38, 41, 48:1, 48:2, 48:3, 48:4, 49, 49:1, 49:2, 52:1, 52:2, 53:1, 57:1, 60:1, 63:1, 66, 67, 81:1, 81:2, 81:3, 83, 88, 90, 105, 112, 119, 122, 123, 144, 146, 149, 150, 155, 166, 168, 169, 170, 171, 172, 175, 176, 177, 178, 179, 184, 185, 187, 188, 190, 200, 202, 206, 207, 208, 209, 210, 216, 220, 224, 226, 242, 246, 254, 255, 264, 269, 270, 272, 279, 291, 294, 295, 296, and 297. In addition, as the red coloring material, compounds described in paragraph No. 0034 of WO2022/085485A and brominated diketopyrrolopyrrole compounds described in JP2020-085947A can also be used.

The red coloring material is preferably C. I. Pigment Red 122, 177, 224, 254, 255, 264, 269, 272, or 291, more preferably C. I. Pigment Red 254, 264, or 272, and still more preferably C. I. Pigment Red 254 or 264.

Examples of the green coloring material include a phthalocyanine compound and a squarylium compound, and the phthalocyanine compound is preferable. In addition, the green coloring material is preferably a pigment (green pigment), and more preferably a phthalocyanine pigment.

Specific examples of the green coloring material include green pigments such as C. I. Pigment Green 7, 10, 36, 37, 58, 59, 62, 63, 64, 65, and 66. In addition, a halogenated zinc phthalocyanine pigment having an average number of halogen atoms in one molecule of 10 to 14, an average number of bromine atoms in one molecule of 8 to 12, and an average number of chlorine atoms in one molecule of 2 to 5 can also be used as the green coloring material. Specific examples thereof include the compounds described in WO2015/118720A. In addition, as the green coloring material, compounds described in paragraph No. 0029 of WO2022/085485A, aluminum phthalocyanine compounds described in JP2020-070426A, diarylmethane compounds described in JP2020-504758A, or the like can also be used.

The green coloring material is preferably C. I. Pigment Green 7, 36, 58, 62, or 63.

Examples of the orange coloring material include a diketopyrrolopyrrole compound and an azo compound. The orange coloring material is preferably a pigment (orange pigment). Specific examples of the orange coloring material include orange pigments such as C. I. Pigment Orange 2, 5, 13, 16, 17:1, 31, 34, 36, 38, 43, 46, 48, 49, 51, 52, 55, 59, 60, 61, 62, 64, 71, and 73.

Examples of the yellow coloring material include an azo compound, an azomethine compound, an isoindoline compound, a pteridine compound, a quinophthalone compound, and a perylene compound. The yellow coloring material is preferably a pigment (yellow pigment). Specific examples of the yellow coloring material include yellow pigments such as C. I. Pigment Yellow 1, 2, 3, 4, 5, 6, 10, 11, 12, 13, 14, 15, 16, 17, 18, 20, 24, 31, 32, 34, 35, 35:1, 36, 36:1, 37, 37:1, 40, 42, 43, 53, 55, 60, 61, 62, 63, 65, 73, 74, 77, 81, 83, 86, 93, 94, 95, 97, 98, 100, 101, 104, 106, 108, 109, 110, 113, 114, 115, 116, 117, 118, 119, 120, 123, 125, 126, 127, 128, 129, 137, 138, 139, 147, 148, 150, 151, 152, 153, 154, 155, 156, 161, 162, 164, 166, 167, 168, 169, 170, 171, 172, 173, 174, 175, 176, 177, 179, 180, 181, 182, 185, 187, 188, 193, 194, 199, 213, 214, 215, 228, 231, 232, 233, 234, 235, and 236.

As the yellow coloring material, an azobarbiturate nickel complex having the following structure can also be used.

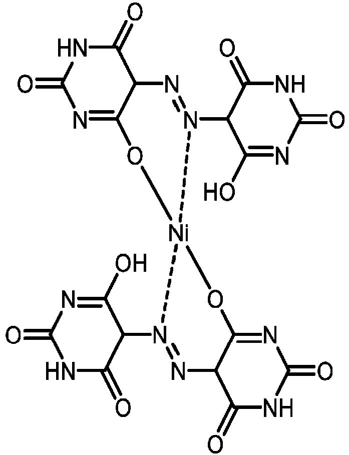

As the yellow coloring material, compounds described in paragraph Nos. 0031 to 0033 of WO2022/085485A, methine dyes described in JP2019-073695A, and methine dyes described in JP2019-073696A can be used.

Examples of the violet coloring material include an oxazine compound, a quinacridone compound, a perylene compound, and an indigo compound; and an oxazine compound is preferable. The violet coloring material is preferably a pigment (violet pigment). Specific examples of the violet coloring material include violet pigments such as C. I. Pigment Violet 1, 19, 23, 27, 32, 37, 42, 60, and 61.

Examples of the blue coloring material include a phthalocyanine compound and a squarylium compound, and a phthalocyanine compound is preferable. The blue coloring material is preferably a pigment (blue pigment). Specific examples of the blue coloring material include blue pigments such as C. I. Pigment Blue 1, 2, 15, 15:1, 15:2, 15:3, 15:4, 15:6, 16, 22, 29, 60, 64, 66, 79, 80, 87, and 88. In addition, as the blue coloring material, an aluminum phthalocyanine compound having a phosphorus atom can also be used. Specific examples thereof include the compounds described in paragraph Nos. 0022 to 0030 of JP2012-247591A and paragraph No. 0047 of JP2011-157478A.

A dye can also be used as the chromatic coloring material. As the dye, a known dye can be used without any particular limitation. Examples thereof include a pyrazoleazo-based dye, an anilinoazo-based dye, a triarylmethane-based dye, an anthraquinone-based dye, an anthrapyridone-based dye, a benzylidene-based dye, an oxonol-based dye, a pyrazolotriazoleazo-based dye, a pyridoneazo-based dye, a cyanine-based dye, a phenothiazine-based dye, a pyrrolopyrazoleazomethine-based dye, a xanthene-based dye, a phthalocyanine-based dye, a benzopyran-based dye, an indigo-based dye, and a pyrromethene-based dye.

A coloring agent multimer can also be used as the chromatic coloring material. The coloring agent multimer is preferably a dye which is used after being dissolved in a solvent. In addition, the coloring agent multimer may form a particle. In a case where the coloring agent multimer is a particle, the coloring agent multimer is usually used in a state of being dispersed in a solvent. The coloring agent multimer in the particle state can be obtained by, for example, emulsion polymerization, and specific examples thereof include the compounds and production methods described in JP2015-214682A. The coloring agent multimer has two or more coloring agent structures in one molecule, and preferably has three or more coloring agent structures in one molecule. The upper limit is particularly not limited, but may be 100 or less. A plurality of coloring agent structures included in one molecule may be the same coloring agent structure or different coloring agent structures. A weight-average molecular weight (Mw) of the coloring agent multimer is preferably 2,000 to 50,000. The lower limit is more preferably 3,000 or more and still more preferably 6,000 or more. The upper limit is more preferably 30,000 or less and still more preferably 20,000 or less. As the coloring agent multimer, compounds described in JP2011-213925A, JP2013-041097A, JP2015-028144A, JP2015-030742A, WO2016/031442A, or the like can also be used.

As the chromatic coloring material, the triarylmethane dye polymers described in KR10-2020-0028160A, the xanthene compounds described in JP2020-117638A, the phthalocyanine compounds described in WO2020/174991A, the isoindoline compounds or salts thereof described in JP2020-160279A, the compound represented by Formula 1 described in KR10-2020-0069442A, the compound represented by Formula 1 described in KR10-2020-0069730A, the compound represented by Formula 1 described in KR10-2020-0069070A, the compound represented by Formula 1 described in KR10-2020-0069067A, the compound represented by Formula 1 described in KR10-2020-0069062A, the halogenated zinc phthalocyanine pigment described in JP6809649B, the isoindoline compounds described in JP2020-180176A, the phenothiazine-based compounds described in JP2021-187913A, the halogenated zinc phthalocyanine described in WO2022/004261A, or the halogenated zinc phthalocyanine described in WO2021/250883A can be used. The chromatic coloring material may be rotaxane, the coloring agent skeleton may be used in a cyclic structure of the rotaxane, may be used in a rod-like structure, or may be used in both structures. As the chromatic coloring material, the quinophthalone compound represented by Formula 1 in KR10-2020-0030759A, the polymeric dye described in KR10-2020-0061793A, the chromatic coloring material described in JP2022-029701A, the isoindoline compound described in WO2022/014635A, the aluminum phthalocyanine compound described in WO2022/024926A, the compound described in JP2022-045895A, the compound described in WO2022/050051A, the compound described in JP2020-090676A, the compound described in JP2020-055956A, the compound described in JP2021-031681A, the compound described in JP2022-056354A, the compound described in US2021/0355327A, the compound described in WO2022/065357A, the compound described in JP2020-045436A, the compound described in KR10-2021-0146726A, the compound described in JP2018-178039A, the compound described in CN113881244A, the compound described in CN113881245A, the compound described in CN113881246A, the compound described in JP2022-104822A, the compound described in JP2022-096701A, the compound described in JP2020-023652A, the green pigment described on pages 80 to 84 of Color Association Journal (published in 2022), the compound described in JP2022-143135A, the compound described in JP2022-140287A, the compound described in WO2022/136308A, the perylene compound described in CN113061349A, the cyan pigment described in KR10-2017-0018993A, the isoindoline compound described in JP2020-180176A, the compound described in JP2023-013209A, the compound described in JP2023-013166A, the xanthene compound described in WO2023/286526A, the compound described in JP2021-155746A, the compound described in JP2021-155747A, the compound described in JP2021-155748A, the compound described in JP2021-155749A, the compound described in WO2018/051876A, the compound described in JP2020-083981A, the compound described in JP2023-056463A, the compound described in JP2023-515473A, the dioxane compound described in JP2022-549530A, the pigment preparation described in JP2022-061494A, the diketopyrrolopyrrole pigment described in JP2023-057917A, the diketopyrrolopyrrole compound described in JP2023-061273A, the phthalocyanine described in JP2023-519314A, the quinophthalone described in JP2023-080419A, or the like can also be used.

The chromatic coloring material may be used in a combination of two or more kinds thereof. In addition, in a case where the chromatic coloring material is used in combination of two or more kinds thereof, the combination of two or more chromatic coloring materials may form black. Examples of such a combination include the following aspects (1) to (7). In a case where the photosensitive composition contains two or more kinds of the chromatic coloring materials and exhibits black by a combination of two or more kinds of the chromatic coloring materials, the photosensitive composition according to the embodiment of the present invention can be preferably used as a photosensitive composition for forming an infrared transmitting filter.
(1) aspect in which a red coloring material and a blue coloring material are contained.
(2) aspect in which a red coloring material, a blue coloring material, and a yellow coloring material are contained.
(3) aspect in which a red coloring material, a blue coloring material, a yellow coloring material, and a violet coloring material are contained.
(4) aspect in which a red coloring material, a blue coloring material, a yellow coloring material, a violet coloring material, and a green coloring material are contained.
(5) aspect in which a red coloring material, a blue coloring material, a yellow coloring material, and a green coloring material are contained.
(6) aspect in which a red coloring material, a blue coloring material, and a green coloring material are contained.
(7) aspect in which a yellow coloring material and a violet coloring material are contained.

### (White coloring material)

Examples of the white coloring material include inorganic pigments such as titanium oxide, strontium titanate, barium titanate, zinc oxide, magnesium oxide, zirconium oxide, aluminum oxide, barium sulfate, silica, talc, mica, aluminum hydroxide, calcium silicate, aluminum silicate, and zinc sulfide. As the white coloring material, white pigments described in paragraph Nos. 0040 to 0043 of WO2022/085485A can be used.

### (Black coloring material)

The black coloring material is not particularly limited, and a known black coloring material can be used. The black coloring material may be an inorganic black coloring material or an organic black coloring material. The black coloring material is preferably a pigment. In the present specification, the black coloring material means a coloring material which exhibits absorption over the entire wavelength range of 400 to 700 nm.

Examples of the inorganic black coloring material include carbon black, titanium black, and graphite; and carbon black or titanium black is preferable and titanium black is more preferable. The titanium black is black particles containing a titanium atom, and is preferably lower titanium oxide or titanium oxynitride. As the titanium black, the titanium black described in paragraph No. 0044 of WO2022/085485A can be used. As the inorganic black coloring material, the zirconium nitride powder described in JP2023-048173A can also be used.

Examples of an organic black coloring material include a bisbenzofuranone compound, an azomethine compound, a perylene compound, and an azo compound. Among these, a bisbenzofuranone compound or a perylene compound is preferable. As the organic black coloring material, the compound described in paragraph No. 0166 of WO2022/065215A can be used. In addition, as the organic black coloring material, the perylene black (Lumogen Black FK4280 or the like) described in paragraphs 0016 to 0020 of JP2017-226821A or the black azo pigment described in JP2022-121935A may be used.

As the black coloring material, the black coloring material described in 294 to 307 of Vol. 96, No. 9 of Color Association Journal in 2023 can also be used.

### (Infrared absorbing coloring material)

The infrared absorbing coloring material is preferably a compound having a maximal absorption wavelength on a longer wavelength side than a wavelength of 700 nm. The infrared absorbing coloring material is preferably a compound having a maximal absorption wavelength in a range of more than 700 nm and 1800 nm or less, more preferably a compound having a maximal absorption wavelength in a range of more than 700 nm and 1400 nm or less, still more preferably a compound having a maximal absorption wavelength in a range of more than 700 nm and 1200 nm or less, and particularly preferably a compound having a maximal absorption wavelength in a range of more than 700 nm and 1000 nm or less. In addition, in the infrared absorbing coloring material, A¹/A², which is a ratio of an absorbance A¹ at a wavelength of 500 nm to an absorbance A² at the maximal absorption wavelength, is preferably 0.08 or less and more preferably 0.04 or less. In addition, the infrared absorbing coloring material is preferably a pigment, and more preferably an organic pigment.

Examples of the infrared absorbing coloring material include a pyrrolo pyrrole compound, a cyanine compound, a squarylium compound, a phthalocyanine compound, a naphthalocyanine compound, a quaterrylene compound, a merocyanine compound, a croconium compound, an oxonol compound, an iminium compound, a dithiol compound, a triarylmethane compound, a pyrromethene compound, an azomethine compound, an anthraquinone compound, a dibenzofuranone compound, a dithiolene metal complex, a metal oxide, and a metal boride. Specific examples thereof include the compounds described in paragraph No. 0114 of WO2022/065215A. In addition, as the infrared absorbing coloring material, the compounds described in paragraph No. 0121 of WO2022/065215A, the squarylium compounds described in JP2020-075959A, the copper complexes described in KR10-2019-0135217A, the croconic acid compounds described in JP2021-195515A, the infrared absorbing coloring agents described in JP2022-022070A, the croconium compounds described in WO2019/021767A, the compounds described in JP2019-127549A, the compounds described in WO2022/059619A, the compounds described in JP2022-151682A, the squarylium compounds described in JP2022-188858A, the compounds described in JP2022-184710A, the compounds described in JP2022-189736A, the squarylium compounds described in JP2023-004570A, the squarylium compounds described in WO2019/230660A, the compounds described in WO2020/218615A, the diiminium compounds described in JP2023-068643A, the squarylium compounds described in JP2023-052770A, the phthalocyanine compounds described in KR10-2022-0163680A, the indigo monoboron complexes described in JP2023-073064A, the phthalocyanine compounds described in JP2022-066025A, the phthalocyanine compounds described in JP2020-041127A, the indigo compounds described in JP2023-073064A, the indigo compounds described in KR10-2023-0016355A, the squarylium compounds described in WO2019/230570A, and the diiminium compounds described in JP2023-095824A can also be used.

### (Pigment derivative)

Examples of the pigment derivative include a compound having a coloring agent structure and an acid group or a basic group.

Examples of the above-described coloring agent structure include a quinoline coloring agent structure, a benzimidazolone coloring agent structure, a benzoisoindole coloring agent structure, a benzothiazole coloring agent structure, an iminium coloring agent structure, a squarylium coloring agent structure, a croconium coloring agent structure, an oxonol coloring agent structure, a pyrrolopyrrole coloring agent structure, a diketopyrrolopyrrole coloring agent structure, an azo coloring agent structure, an azomethine coloring agent structure, a phthalocyanine coloring agent structure, a naphthalocyanine coloring agent structure, an anthraquinone coloring agent structure, a quinacridone coloring agent structure, a dioxazine coloring agent structure, a perinone coloring agent structure, a perylene coloring agent structure, a thiazine indigo coloring agent structure, a thioindigo coloring agent structure, an isoindoline coloring agent structure, an isoindolinone coloring agent structure, a quinophthalone coloring agent structure, a dithiol coloring agent structure, a triarylmethane coloring agent structure, and a pyrromethene coloring agent structure.

Examples of the acid group included in the pigment derivative include a carboxy group, a sulfo group, a phosphoric acid group, a boronic acid group, an imidic acid group, and salts of these. Examples of an atom or atomic group constituting the salts include alkali metal ions (Li⁺, Na⁺, K⁺, and the like), alkaline earth metal ions (Ca²⁺, Mg²⁺, and the like), an ammonium ion, an imidazolium ion, a pyridinium ion, and a phosphonium ion. As the imidic acid group, -SO₂NHSO₂R^{X1}, -CONHSO₂R^{X2}, -CONHCOR^{X3}, or -SO₂NHCOR^{X4} is preferable, -SO₂NHSO₂R^{X1}, -CONHSO₂R^{X2}, or -SO₂NHCOR^{X4} is more preferable, and -SO₂NHSO₂R^{X1} or -CONHSO₂R^{X2} is still more preferable. R^{X1} to R^{X4} each independently represent an alkyl group or an aryl group. The alkyl group and the aryl group represented by R^{X1} to R^{X4} may have a substituent. As the substituent, a halogen atom is preferable and a fluorine atom is more preferable. R^{X1} to R^{X4} are each independently preferably an alkyl group having a fluorine atom or an aryl group having a fluorine atom, and more preferably an alkyl group having a fluorine atom. The alkyl group containing a fluorine atom preferably has 1 to 10 carbon atoms, more preferably 1 to 5 carbon atoms, and still more preferably 1 to 3 carbon atoms. The aryl group including a fluorine atom preferably has 6 to 20 carbon atoms, more preferably has 6 to 12 carbon atoms, and still more preferably has 6 carbon atoms.

Examples of the basic group included in the pigment derivative include an amino group, a pyridinyl group or a salt thereof, a salt of an ammonium group, and a phthalimidomethyl group. Examples of the atom or atomic group constituting the salt include a hydroxide ion, a halogen ion, a carboxylate ion, a sulfonate ion, and a phenoxide ion.

Examples of the amino group include a group represented by -NR^{x11}R^{x12} and a cyclic amino group.

In the group represented by -NR^{x11}R^{x12}, R^{x11} and R^{x12} each independently represent a hydrogen atom, an alkyl group, or an aryl group, and an alkyl group is preferable. That is, the amino group is preferably a dialkylamino group. The alkyl group preferably has 1 to 10 carbon atoms, more preferably 1 to 5 carbon atoms, and still more preferably 1 to 3 carbon atoms. The alkyl group may be linear, branched, or cyclic, and it is preferably linear or branched and more preferably linear. The alkyl group may have a substituent. Examples of the substituent include the above-mentioned substituent T. The aryl group preferably has 6 to 30 carbon atoms, more preferably has 6 to 20 carbon atoms, and still more preferably has 6 to 12 carbon atoms. The aryl group may have a substituent. Examples of the substituent include the above-mentioned substituent T.

Examples of the cyclic amino group include a pyrrolidine group, a piperidine group, a piperazine group, and a morpholine group. These groups may further have a substituent.

A content of the coloring material in the total solid content of the photosensitive composition is preferably 50% by mass or more, and more preferably 55% by mass or more.

The coloring material used in the photosensitive composition according to the embodiment of the present invention is preferably a coloring material containing a pigment, and more preferably a coloring material containing a pigment and a pigment derivative. In addition, the pigment is preferably a chromatic pigment. A content of the pigment in the coloring material is preferably 20% to 100% by mass, more preferably 50% to 100% by mass, and still more preferably 70% to 100% by mass. A content of the pigment derivative is preferably 1 to 30 parts by mass and more preferably 3 to 20 parts by mass with respect to 100 parts by mass of the pigment. The total content of the pigment and the pigment derivative in the coloring material is preferably 25% to 100% by mass, more preferably 55% to 100% by mass, and still more preferably 75% to 100% by mass.

The photosensitive composition according to the embodiment of the present invention may contain only one kind of coloring material or two or more kinds of coloring materials. In a case where two or more kinds of the coloring materials are included, a total amount thereof is preferably within the range.

### <<Polymerizable compound>>

The photosensitive composition according to the embodiment of the present invention contains a polymerizable compound. Examples of the polymerizable compound include a compound having an ethylenically unsaturated bond-containing group. Examples of the ethylenically unsaturated bond-containing group include a vinyl group, a (meth)allyl group, and a (meth)acryloyl group. The polymerizable compound is preferably a radically polymerizable compound.

Any chemical forms of a monomer, a prepolymer, an oligomer, and the like may be used as the polymerizable compound, but a monomer is preferable. A molecular weight of the polymerizable compound is preferably 100 to 2,500. The upper limit thereof is preferably 2,000 or less and more preferably 1,500 or less. The lower limit thereof is preferably 150 or more and more preferably 250 or more.

From the viewpoint of storage stability of the photosensitive composition, an ethylenically unsaturated bond-containing group value (hereinafter, referred to as a C=C value) of the polymerizable compound is preferably 2 to 14 mmol/g. The lower limit thereof is preferably 3 mmol/g or more, more preferably 4 mmol/g or more, and still more preferably 5 mmol/g or more. The upper limit is preferably 12 mmol/g or less, more preferably 10 mmol/g or less, and still more preferably 8 mmol/g or less. The C=C value of the polymerizable compound is obtained by dividing the number of ethylenically unsaturated bond-containing groups included in one molecule of the polymerizable compound by the molecular weight of the polymerizable compound.

The polymerizable compound is preferably a compound including 3 or more ethylenically unsaturated bond-containing groups, more preferably a compound including 3 to 15 ethylenically unsaturated bond-containing groups, and still more preferably a compound including 3 to 6 ethylenically unsaturated bond-containing groups. In addition, the polymerizable compound is preferably a trifunctional to pentadecafunctional (meth)acrylate compound, and more preferably a trifunctional to hexafunctional (meth)acrylate compound. Specific examples of the polymerizable compound include the compounds described in paragraph Nos. 0075 to 0083 of WO2022/065215A and the compounds described in Taiwan Patent Application Publication No. 201832008.

As the polymerizable compound, dipentaerythritol tri(meth)acrylate (as a commercially available product, KAYARAD D-330 manufactured by Nippon Kayaku Co., Ltd.), dipentaerythritol tetra(meth)acrylate (as a commercially available product, KAYARAD D-320 manufactured by Nippon Kayaku Co., Ltd.), dipentaerythritol penta(meth)acrylate (as a commercially available product, KAYARAD D-310 manufactured by Nippon Kayaku Co., Ltd.), dipentaerythritol hexa(meth)acrylate (as a commercially available product, KAYARAD DPHA manufactured by Nippon Kayaku Co., Ltd., NK ESTER A-DPH-12E manufactured by Shin-Nakamura Chemical Co., Ltd.), or a compound having a structure in which these (meth)acryloyl groups are bonded through an ethylene glycol and/or a propylene glycol residue (for example, SR454 and SR499 which are commercially available products from Sartomer Company Inc.) is preferable. In addition, as the polymerizable compound, diglycerin ethylene oxide (EO)-modified (meth)acrylate (as a commercially available product, M-460 manufactured by TOAGOSEI CO., LTD.), pentaerythritol tetraacrylate (NK ESTER A-TMMT manufactured by Shin-Nakamura Chemical Co., Ltd.), 1,6-hexanediol diacrylate (KAYARAD HDDA manufactured by Nippon Kayaku Co., Ltd.), RP-1040 (manufactured by Nippon Kayaku Co., Ltd.), ARONIX TO-2349 (manufactured by TOAGOSEI CO., LTD.), NK OLIGO UA-7200 (manufactured by Shin-Nakamura Chemical Co., Ltd.), DPHA-40H (manufactured by Nippon Kayaku Co., Ltd.), UA-306H, UA-306T, UA-306I, AH-600, T-600, AI-600, and LINC-202UA (manufactured by KYOEISHA CHEMICAL Co., Ltd.), 8UH-1006 and 8UH-1012 (manufactured by Taisei Fine Chemical Co., Ltd.), LIGHT ACRYLATE POB-A0 (manufactured by KYOEISHA CHEMICAL Co., Ltd.), ARONIX MT-3041 and 3042 (manufactured by TOAGOSEI CO., LTD., polymerizable compounds containing an amine), ARONIX M-510 and 520 (manufactured by TOAGOSEI CO., LTD., polymerizable compounds having an acidic group), Etercure 6361-100 (manufactured by Eternal Materials Co., Ltd., a polymerizable compound having a hyperbranched structure), EBECRYL 80 (a tetrafunctional monomer containing an amine, manufactured by Daicel-Allnex Ltd.), EBECRYL 7100 (a bifunctional monomer containing an amine, manufactured by Daicel-Allnex Ltd.), CN371NS (a bifunctional monomer containing an amine, manufactured by Arkema S.A.), HOA-MPL (2-acryloyloxyethyl-phthalic acid, manufactured by KYOEISHA CHEMICAL Co., Ltd.), HOA-MPE (2-acryloyloxyethyl-2-hydroxyethyl-phthalic acid, manufactured by KYOEISHA CHEMICAL Co., Ltd.), a polymerizable compound having a dendrimer structure or a hyperbranched structure, described in JP2023-043479A, a polymerizable compound described in JP2023-529984A, or the like can also be used.

A content of the polymerizable compound in the total solid content of the photosensitive composition is preferably 1% to 30% by mass. The upper limit thereof is preferably 20% by mass or less, more preferably 15% by mass or less, and still more preferably 10% by mass or less. The lower limit thereof is preferably 3% by mass or more, and more preferably 5% by mass or more.

The photosensitive composition according to the embodiment of the present invention may contain only one kind of the polymerizable compound, or may contain two or more kinds thereof. In a case of containing two or more kinds of the polymerizable compounds, it is preferable that the total content thereof is within the above-described range.

### <<Resin>>

The photosensitive composition according to the embodiment of the present invention contains a resin. The resin is blended in, for example, an application for dispersing the pigment in the photosensitive composition or an application as a binder. A resin mainly used for dispersing a pigment or the like in the photosensitive composition is also referred to as a dispersant. However, such applications of the resin are merely exemplary, and the resin can also be used for other purposes in addition to such applications.

A weight-average molecular weight (Mw) of the resin is preferably 3,000 to 2,000,000. The upper limit is preferably 1,000,000 or less and more preferably 500,000 or less. The lower limit is preferably 4,000 or more and more preferably 5,000 or more.

Examples of the resin include a (meth)acrylic resin, an epoxy resin, a (meth)acrylamide resin, an ene-thiol resin, a polycarbonate resin, a polyether resin, a polyarylate resin, a polysulfone resin, a polyethersulfone resin, a polyphenylene resin, a polyarylene ether phosphine oxide resin, a polyimide resin, a polyamidoimide resin, a polyolefin resin, a cyclic olefin resin, a polyester resin, a styrene resin, and a siloxane resin. In addition, as the resin, the resins described in paragraph Nos. 0091 to 0099 of WO2022/065215A, the block polyisocyanate resin described in JP2016-222891A, the resin described in JP2020-122052A, the resin described in JP2020-111656A, the resin described in JP2020-139021A, the resin described in JP2017-138503A, which includes a constitutional unit having a ring structure in the main chain and a constitutional unit having a biphenyl group in the side chain, the resins described in paragraphs 0199 to 0233 of JP2020-186373A, the alkali-soluble resin described in JP2020-186325A, the resin represented by Formula 1, described in KR10-2020-0078339A, the copolymer containing an epoxy group and an acid group, described in WO2022/030445A, the resin described in JP2018-135514A, the copolymer described in JP2020-041046A, the resin described in JP2023-033156A, the resin described in JP2023-030386A, the resin described in JP2023-027753A, the resin described in JP2020-139021A, the resin described in JP2023-074038A, and the resin described in JP2023-079666A can also be used.

As the resin, it is preferable to use a resin having an acid group. Examples of the acid group include a carboxy group, a phosphoric acid group, a sulfo group, and a phenolic hydroxy group.

An acid value of the resin having an acid group is preferably 30 to 500 mgKOH/g. The lower limit thereof is preferably 40 mgKOH/g or more, and more preferably 50 mgKOH/g or more. The upper limit thereof is preferably 400 mgKOH/g or less, more preferably 300 mgKOH/g or less, and still more preferably 200 mgKOH/g or less. A weight-average molecular weight (Mw) of the resin having an acid group is preferably 5,000 to 100,000 and more preferably 5,000 to 50,000. A number-average molecular weight (Mn) of the resin having an acid group is preferably 1,000 to 20,000.

The resin having an acid group preferably includes a repeating unit having an acid group in the side chain, and more preferably includes 5 to 70 mol% of repeating units having an acid group in the side chain with respect to the total repeating units of the resin. The upper limit of the content of the repeating unit having an acid group in the side chain is preferably 50 mol% or less and more preferably 30 mol% or less. The lower limit of the content of the repeating unit having an acid group in the side chain is preferably 10 mol% or more and more preferably 20 mol% or more.

With regard to the resin having an acid group, reference can be made to the description in paragraph Nos. 0558 to 0571 of JP2012-208494A (paragraph Nos. 0685 to 0700 of the corresponding US2012/0235099A) and the description in paragraph Nos. 0076 to 0099 of JP2012-198408A, the contents of which are incorporated herein by reference. A commercially available product can also be used as the resin having an acid group. In addition, a method of introducing the acid group into the resin is not particularly limited, and examples thereof include the method described in JP6349629B. Further, examples of the method of introducing the acid group into the resin include a method of introducing an acid group by reacting an acid anhydride with a hydroxy group generated by a ring-opening reaction of an epoxy group.

The photosensitive composition according to the embodiment of the present invention preferably includes a resin having a basic group. The resin having a basic group is preferably a resin including a repeating unit having a basic group in the side chain, more preferably a copolymer having a repeating unit having a basic group in the side chain and a repeating unit not having a basic group, and still more preferably a block copolymer having a repeating unit having a basic group in the side chain and a repeating unit not having a basic group. The resin having a basic group can also be used as a dispersant. An amine value of the resin having a basic group is preferably 5 to 300 mgKOH/g. The lower limit is preferably 10 mgKOH/g or more and more preferably 20 mgKOH/g or more. The upper limit thereof is preferably 200 mgKOH/g or less and more preferably 100 mgKOH/g or less.

Examples of a commercially available product of the resin having a basic group include DISPERBYK-161, 162, 163, 164, 166, 167, 168, 174, 182, 183, 184, 185, 2000, 2001, 2050, 2150, 2163, 2164, and BYK-LPN 6919 (all of which are manufactured by BYK-Chemie), SOLSPERSE 11200, 13240, 13650, 13940, 24000, 26000, 28000, 32000, 32500, 32550, 32600, 33000, 34750, 35100, 35200, 37500, 38500, 39000, 53095, 56000, and 7100 (all of which are manufactured by Lubrizol Japan Ltd.), and Efka PX 4300, 4330, 4046, 4060, and 4080 (all of which are manufactured by BASF). In addition, as the resin having a basic group, block copolymer (B) described in paragraph Nos. 0063 to 0112 of JP2014-219665A, block copolymer A1 described in paragraph Nos. 0046 to 0076 of JP2018-156021A, and a vinyl resin having a basic group, described in paragraph Nos. 0150 to 0153 of JP2019-184763A, can also be used, the contents of which are incorporated herein by reference.

It is also preferable that the photosensitive composition according to the embodiment of the present invention includes the resin having an acid group and the resin having a basic group, respectively. According to this aspect, the storage stability of the photosensitive composition can be further improved. In a case where the resin having an acid group and the resin having a basic group are used in combination, a content of the resin having a basic group is preferably 20 to 500 parts by mass, more preferably 30 to 300 parts by mass, and still more preferably 50 to 200 parts by mass with respect to 100 parts by mass of the resin having an acid group.

As the resin, a resin having an aromatic carboxy group is also preferably used. In the resin having an aromatic carboxy group, the aromatic carboxy group may be included in a main chain of the repeating unit or may be included in a side chain of the repeating unit. It is preferable that the aromatic carboxy group is included in the main chain of the repeating unit. Furthermore, in the present specification, the aromatic carboxy group is a group having a structure in which one or more carboxyl groups are bonded to an aromatic ring. In the aromatic carboxy group, the number of carboxyl groups bonded to an aromatic ring is preferably 1 to 4 and more preferably 1 or 2. Examples of the resin having an aromatic carboxy group include the resins described in paragraphs 0082 to 0107 of WO2021/166858A.

As the resin, it is also preferable to use a resin having a crosslinkable group. Examples of the crosslinkable group include a (meth)acryloyl group, an epoxy group, and an oxetanyl group. In a case where the resin having a crosslinkable group is used, a content of the resin having a crosslinkable group in the resin contained in the photosensitive composition is preferably 30% by mass or more, more preferably 50% by mass or more, and still more preferably 70% by mass or more.

The photosensitive composition according to the embodiment of the present invention preferably contains a resin as a dispersant. Examples of the dispersant include an acidic dispersant (acidic resin) and a basic dispersant (basic resin). Here, the acidic dispersant (acidic resin) represents a resin in which the amount of the acid group is larger than the amount of the basic group. The acidic dispersant (acidic resin) is preferably a resin in which the amount of the acid group is 70 mol% or more in a case where a total amount of the acid group and the basic group is 100 mol%. The acid group included in the acidic dispersant (acidic resin) is preferably a carboxy group. An acid value of the acidic dispersant (acidic resin) is preferably 10 to 105 mgKOH/g. In addition, the basic dispersant (basic resin) represents a resin in which the amount of the basic group is larger than the amount of the acid group. The basic dispersant (basic resin) is preferably a resin in which the amount of the basic group is more than 50 mol% in a case where the total amount of the acid group and the basic group is 100 mol%. The basic group included in the basic dispersant is preferably an amino group.

It is also preferable that the resin used as a dispersant is a graft resin. With regard to details of the graft resin, reference can be made to the description in paragraph Nos. 0025 to 0094 of JP2012-255128A, the contents of which are incorporated herein by reference.

The resin used as the dispersant is also preferably a resin having an aromatic carboxy group. Examples of the resin having an aromatic carboxy group include those described above.

It is also preferable that the resin used as a dispersant is a polyimine-based dispersant including a nitrogen atom in at least one of the main chain or the side chain. As the polyimine-based dispersant, a resin having a main chain which has a partial structure having a functional group of pKa 14 or less, and a side chain which has 40 to 10000 atoms, in which at least one of the main chain or the side chain has a basic nitrogen atom, is preferable. The basic nitrogen atom is not particularly limited as long as it is a nitrogen atom exhibiting basicity. With regard to the polyimine-based dispersant, reference can be made to the description in paragraph Nos. 0102 to 0166 of JP2012-255128A, the contents of which are incorporated herein by reference.

It is also preferable that the resin used as a dispersant is a resin having a structure in which a plurality of polymer chains are bonded to a core part. Examples of such a resin include dendrimers (including star polymers). In addition, specific examples of the dendrimer include polymer compounds C-1 to C-31 described in paragraph Nos. 0196 to 0209 of JP2013-043962A.

It is also preferable that the resin used as a dispersant is a resin including a repeating unit having an ethylenically unsaturated bond-containing group in the side chain. The content of the repeating unit having an ethylenically unsaturated bond-containing group in the side chain is preferably 10 mol% or more, more preferably 10 to 80 mol%, and still more preferably 20 to 70 mol% with respect to the total repeating units of the resin.

As the dispersant, a resin described in JP2018-087939A, block copolymers (EB-1) to (EB-9) described in paragraph Nos. 0219 to 0221 of JP6432077B, polyethyleneimine having a polyester side chain, described in WO2016/104803A, a block copolymer described in WO2019/125940A, a block polymer having an acrylamide structural unit, described in JP2020-066687A, a block polymer having an acrylamide structural unit, described in JP2020-066688A, a dispersant described in WO2016/104803A, or the like can also be used.

The dispersant is also available as a commercially available product, and specific examples thereof include DISPERBYK series manufactured by BYK-Chemie GmbH, SOLSPERSE series manufactured by Lubrizol Japan Ltd., Efka series manufactured by BASF, and Ajispar series manufactured by Ajinomoto Fine-Techno Co., Inc. In addition, products described in paragraph No. 0129 of JP2012-137564A and products described in paragraph No. 0235 of JP2017-194662A can also be used as the dispersant.

A content of the resin in the total solid content of the photosensitive composition is preferably 1% to 60% by mass. The lower limit is preferably 5% by mass or more, more preferably 10% by mass or more, still more preferably 15% by mass or more, and particularly preferably 20% by mass or more. The upper limit is preferably 50% by mass or less and more preferably 40% by mass or less.

A content of the resin having an acid group in the total solid content of the photosensitive composition is preferably 1% to 60% by mass. The lower limit is preferably 5% by mass or more, more preferably 10% by mass or more, still more preferably 15% by mass or more, and particularly preferably 20% by mass or more. The upper limit is preferably 50% by mass or less and more preferably 40% by mass or less.

The content of the resin is preferably 100 to 1,000 parts by mass with respect to 100 parts by mass of the polymerizable compound. The lower limit thereof is preferably 150 parts by mass or more, and more preferably 200 parts by mass or more. The upper limit thereof is preferably 600 parts by mass or less and more preferably 500 parts by mass or less.

The photosensitive composition according to the embodiment of the present invention may include one kind of resin or two or more kinds of resins. In a case of including two or more kinds of resins, it is preferable that the total amount thereof is within the above-described range.

### <<Photopolymerization initiator>>

The photosensitive composition according to the embodiment of the present invention contains a photopolymerization initiator. The photopolymerization initiator is not particularly limited and can be appropriately selected from known photopolymerization initiators. For example, a compound having photosensitivity to light in a range from an ultraviolet region to a visible region is preferable. The photopolymerization initiator is preferably a photoradical polymerization initiator.

Examples of the photopolymerization initiator include a halogenated hydrocarbon derivative (for example, a compound having a triazine skeleton or a compound having an oxadiazole skeleton), an acylphosphine compound, a hexaarylbiimidazole compound, an oxime compound, an organic peroxide, a thio compound, a ketone compound, an aromatic onium salt, an α-hydroxyketone compound, and an α-aminoketone compound. From the viewpoint of the exposure sensitivity, as the photopolymerization initiator, a trihalomethyltriazine compound, a benzyldimethylketal compound, an α-hydroxyketone compound, an α-aminoketone compound, an acylphosphine compound, a phosphine oxide compound, a metallocene compound, an oxime compound, a hexaarylbiimidazole compound, an onium compound, a benzothiazole compound, a benzophenone compound, an acetophenone compound, a cyclopentadiene-benzene-iron complex, a halomethyl oxadiazole compound, or a 3-aryl-substituted coumarin compound is preferable, a compound selected from the oxime compound, the α-hydroxyketone compound, the α-aminoketone compound, and the acylphosphine compound is more preferable, and the oxime compound is still more preferable. In addition, examples of the photopolymerization initiator include compounds described in paragraphs 0065 to 0111 of JP2014-130173A, compounds described in JP6301489B, peroxide-based photopolymerization initiators described in MATERIAL STAGE 37 to 60p, vol. 19, No. 3, 2019, photopolymerization initiators described in WO2018/221177A, photopolymerization initiators described in WO2018/110179A, photopolymerization initiators described in JP2019-043864A, photopolymerization initiators described in JP2019-044030A, peroxide-based initiators described in JP2019-167313A, aminoacetophenone initiators having an oxazolidine group described in JP2020-055992A, oxime-based photopolymerization initiators described in JP2013-190459A, polymers described in JP2020-172619A, compounds represented by Formula 1 described in WO2020/152120A, compounds described in JP2021-181406A, photopolymerization initiators described in JP2022-013379A, compounds represented by Formula (1) described in JP2022-015747A, fluorine-containing fluorene oxime ester photoinitiators described in JP2021-507058A, initiators described in CN110764367A, initiators described in JP2022-518535A, initiators described in WO2021/175855A, compounds described in TW2022-00534A, compounds described in JP2022-078550A, compounds described in KR10-2017-0087330A, compounds described in WO2022/075452A, oxime ester compounds described in CN110066225A, compounds described in KR10-2022-0076157A, compounds described in paragraph Nos. 0042 to 0062 of WO2019/013112A having a triarylamine or N-arylcarbazole skeleton, oxime ester photopolymerization initiators described in JP7219378B, photopolymerization initiators described in KR10-2021-0146174A, photopolymerization initiators described in WO2019/013112A, photopolymerization initiators described in JP2023-033731A, initiators described in JP2022-515524A, initiators described in JP2023-517304A, and initiators described in CN114149517A.

Specific examples of the hexaarylbiimidazole compound include 2,2',4-tris(2-chlorophenyl)-5-(3,4-dimethoxyphenyl)-4,5-diphenyl-1,1'-biimidazole.

Examples of a commercially available product of the α-hydroxyketone compound include Omnirad 184, Omnirad 1173, Omnirad 2959, and Omnirad 127 (all of which are manufactured by IGM Resins B.V.), and Irgacure 184, Irgacure 1173, Irgacure 2959, and Irgacure 127 (all of which are manufactured by BASF). Examples of a commercially available product of the α-aminoketone compound include Omnirad 907, Omnirad 369, Omnirad 369E, and Omnirad 379EG (all of which are manufactured by IGM Resins B.V.), and Irgacure 907, Irgacure 369, Irgacure 369E, and Irgacure 379EG (all of which are manufactured by BASF). Examples of a commercially available product of the acylphosphine compound include Omnirad 819 and Omnirad TPO (both of which are manufactured by IGM Resins B.V.), Irgacure 819 and Irgacure TPO (both of which are manufactured by BASF).

Examples of the oxime compound include compounds described in paragraph Nos. 0142 of WO2022/085485A, compounds described in JP5430746B, compounds described in JP5647738B, compounds represented by General Formula (1) and compounds described in paragraphs 0022 to 0024 of JP2021-173858A, and compounds represented by General Formula (1) and compounds described in paragraphs 0117 to 0120 of JP2021-170089A. Specific examples of the oxime compound include 3-benzoyloxyiminobutane-2-one, 3-acetoxyiminobutane-2-one, 3-propionyloxyiminobutane-2-one, 2-acetoxyiminopentane-3-one, 2-acetoxyimino-1-phenylpropane-1-one, 2-benzoyloxyimino-1-phenylpropane-1-one, 3-(4-toluene sulfonyloxy)iminobutane-2-one, 2-ethoxycarbonyloxyimino-1-phenylpropane-1-one, and 1-[4-(phenylthio)phenyl]-3-cyclohexyl-propane-1,2-dione-2-(O-acetyloxime). Examples of a commercially available product thereof include Irgacure OXE01, Irgacure OXE02, Irgacure OXE03, and Irgacure OXE04 (all of which are manufactured by BASF), TR-PBG-301, TR-PBG-304, TR-PBG-305, TR-PBG-309, TR-PBG-3054, TR-PBG-3057, TR-PBG-314, TR-PBG-327, TR-PBG-345, TR-PBG-346, TR-PBG-358, TR-PBG-365, TR-PBG-380, TR-PBG-610, TR-PBG-A, and TR-PBG-B (all of which are manufactured by TRONLY), and ADEKA OPTOMER N-1919 (manufactured by ADEKA Corporation, a photopolymerization initiator 2 described in JP2012-014052A). In addition, as the oxime compound, it is also preferable to use a compound having no colorability or a compound having high transparency and being resistant to discoloration. Examples of a commercially available product thereof include ADEKA ARKLS NCI-730, NCI-831, NCI-831E, and NCI-930 (all of which are manufactured by ADEKA Corporation).

As the photopolymerization initiator, an oxime compound having a fluorene ring, an oxime compound having a skeleton in which at least one benzene ring of a carbazole ring is a naphthalene ring, an oxime compound having a fluorine atom, an oxime compound having a nitro group, an oxime compound having a benzofuran skeleton, an oxime compound in which a substituent having a hydroxy group is bonded to a carbazole skeleton, or the compounds described in paragraph Nos. 0143 to 0149 of WO2022/085485A can also be used.

As the photopolymerization initiator, a compound represented by Formula (OX-1) can also be used.

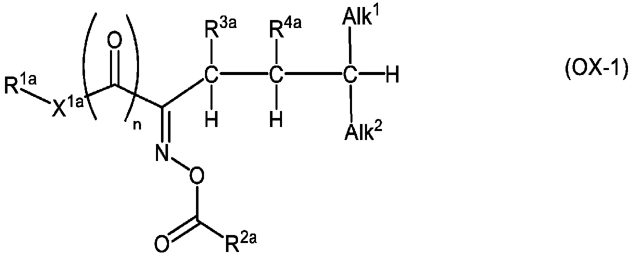

In Formula (OX-1), X^{1a} represents a divalent linking group including at least one selected from the group consisting of an aromatic ring and a heterocyclic ring,
R^{1a} represents a hydrogen atom or an acyl group,
R^{2a} represents an alkyl group or an aryl group,
R^{3a} and R^{4a} each independently represent a hydrogen atom or an alkyl group,
Alk¹ and Alk² each independently represent an alkyl group,
R^{3a} and R^{4a} may be bonded to each other to form a ring,
Alk¹ and Alk² may be bonded to each other to form a ring, and
n represents 0 or 1.

Examples of the divalent linking group represented by X^{1a} in Formula (OX-1) include a divalent aromatic ring group, a divalent heterocyclic group, a divalent group in which two or more aromatic rings are bonded through a single bond or a linking group, a divalent group in which two or more heterocyclic rings are bonded through a single bond or a linking group, and a divalent group in which an aromatic ring and a heterocyclic ring are bonded through a single bond or a linking group. Examples of the above-described linking group which bonds the aromatic rings to each other, the heterocyclic rings to each other, or the aromatic ring and the heterocyclic ring to each other include -CH₂-, -O-, -CO-, -S-, -NR^{x}-, and a group obtained by combining these groups. R^{x} represents a hydrogen atom, an alkyl group, an alkenyl group, an alkynyl group, an aryl group, or a heterocyclic group.

X^{1a} in Formula (OX-1) is preferably a group represented by any of Formulae (X-1) to (X-13), more preferably a group represented by Formula (X-1), Formula (X-2), Formula (X-4), Formula (X-6), or Formula (X-8), and still more preferably a group represented by Formula (X-2) or Formula (X-6).

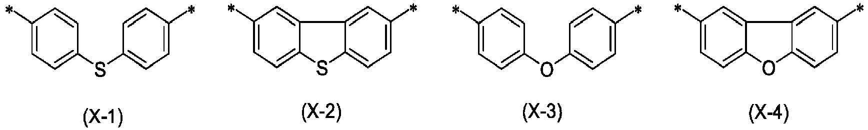

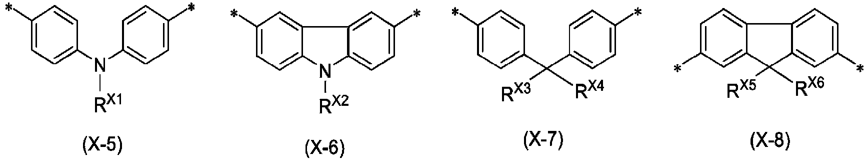

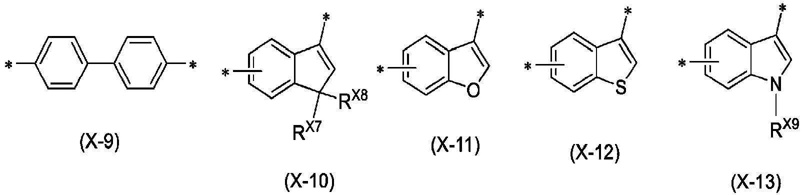

In the formulae, R^{X1} to R^{X9} each independently represent a hydrogen atom, an alkyl group, an alkenyl group, an alkynyl group, an aryl group, or a heterocyclic group, and * represents a bonding site.

The alkyl group represented by R^{X1} to R^{X9} preferably has 1 to 15 carbon atoms, and more preferably has 1 to 10 carbon atoms. The alkyl group may be linear, branched, or cyclic. The alkyl group may have a substituent. Examples of the substituent include a halogen atom, an aryl group, and a heterocyclic group.

The alkenyl group represented by R^{X1} to R^{X9} preferably has 2 to 15 carbon atoms, and more preferably has 2 to 10 carbon atoms. The alkenyl group may be linear, branched, or cyclic. The alkenyl group may have a substituent. Examples of the substituent include a halogen atom, an aryl group, and a heterocyclic group.

The alkynyl group represented by R^{X1} to R^{X9} preferably has 2 to 15 carbon atoms, and more preferably has 2 to 10 carbon atoms. The alkynyl group may be linear, branched, or cyclic. The alkynyl group may have a substituent. Examples of the substituent include a halogen atom, an aryl group, and a heterocyclic group.

The aryl group represented by R^{X1} to R^{X9} preferably has 6 to 20 carbon atoms, more preferably has 6 to 12 carbon atoms, still more preferably 6 to 10 carbon atoms, and particularly preferably 6 carbon atoms. The aryl group may have a substituent. Examples of the substituent include a halogen atom, an alkyl group, an alkenyl group, an alkynyl group, and a heterocyclic group.

The heterocyclic group represented by R^{X1} to R^{X9} is preferably a 5-membered ring or a 6-membered ring. A heteroatom included in the heterocyclic group is preferably an oxygen atom, a nitrogen atom, or a sulfur atom. The number of heteroatoms included in the heterocyclic group is preferably 1 to 3. The heterocyclic group may have a substituent. Examples of the substituent include a halogen atom, an alkyl group, an alkenyl group, an alkynyl group, and an aryl group.

R^{1a} in Formula (OX-1) represents a hydrogen atom or an acyl group, and an acyl group is preferable.

The acyl group represented by R^{1a} is preferably a group represented by -C(O)-R¹⁰¹. R¹⁰¹ represents an aryl group or a heterocyclic group, and an aryl group is preferable.

The aryl group represented by R¹⁰¹ preferably has 6 to 20 carbon atoms, and more preferably has 6 to 12 carbon atoms. The aryl group may have a substituent. Examples of the substituent include a halogen atom, an alkyl group, an alkenyl group, an alkynyl group, and a heterocyclic group. The aryl group represented by R¹⁰¹ is preferably a phenyl group, a methylphenyl group, or a naphthyl group, and more preferably a methylphenyl group or a naphthyl group.

The heterocyclic group represented by R¹⁰¹ is preferably a 5-membered ring or a 6-membered ring. A heteroatom included in the heterocyclic group is preferably an oxygen atom, a nitrogen atom, or a sulfur atom. The number of heteroatoms included in the heterocyclic group is preferably 1 to 3. The heterocyclic group may have a substituent. Examples of the substituent include a halogen atom, an alkyl group, an alkenyl group, an alkynyl group, and an aryl group.

R^{2a} in Formula (OX-1) represents an alkyl group or an aryl group, and is preferably an alkyl group for the reason that reactivity of the generated radical is high.

The alkyl group represented by R^{2a} preferably has 1 to 15 carbon atoms, more preferably has 1 to 10 carbon atoms, still more preferably has 1 to 5 carbon atoms, and even more preferably has 1 to 3 carbon atoms. The alkyl group may be linear, branched, or cyclic forms, and is preferably linear or branched and more preferably linear. The alkyl group may have a substituent, but an unsubstituted alkyl group is preferable. The alkyl group represented by R^{2a} is preferably an unsubstituted linear or branched alkyl group and more preferably an unsubstituted linear alkyl group.

The aryl group represented by R^{2a} preferably has 6 to 20 carbon atoms, more preferably has 6 to 12 carbon atoms, still more preferably 6 to 10 carbon atoms, and particularly preferably 6 carbon atoms. The aryl group may have a substituent, but an unsubstituted aryl group is preferable.

R^{3a} and R^{4a} in Formula (OX-1) each independently represent a hydrogen atom or an alkyl group, and are preferably a hydrogen atom.

The alkyl group represented by R^{3a} and R^{4a} preferably has 1 to 15 carbon atoms, more preferably has 1 to 10 carbon atoms, still more preferably has 1 to 5 carbon atoms, and even more preferably has 1 to 3 carbon atoms. The alkyl group may be linear, branched, or cyclic forms, and is preferably linear or branched and more preferably linear. The alkyl group may have a substituent, but an unsubstituted alkyl group is preferable.

R^{3a} and R^{4a} may be bonded to each other to form a ring. The ring to be formed is preferably a 5-membered ring or a 6-membered ring, and more preferably a 5-membered or 6-membered aliphatic hydrocarbon ring.

Alk¹ and Alk² in Formula (OX-1) each independently represent an alkyl group. The alkyl group preferably has 1 to 15 carbon atoms, more preferably has 1 to 10 carbon atoms, still more preferably has 1 to 5 carbon atoms, and even more preferably has 1 to 3 carbon atoms. The alkyl group may be linear, branched, or cyclic forms, and is preferably linear or branched and more preferably linear. The alkyl group may have a substituent, but an unsubstituted alkyl group is preferable.

Alk¹ and Alk² may be bonded to each other to form a ring, and it is preferable to form a ring. The ring to be formed is preferably a 5-membered ring or a 6-membered ring, more preferably a 5-membered or 6-membered aliphatic hydrocarbon ring, and still more preferably a cyclopentane ring or a cyclohexane ring.

n in Formula (OX-1) represents 0 or 1, and is preferably 0.

Specific examples of the compound represented by Formula (OX-1) include the compounds described in paragraph Nos. 0092 to 0096 of JP2012-113104A and the compounds described in paragraph No. 0041 of JP2012-189997A.

As the photopolymerization initiator, a compound represented by Formula (OX-2) can also be used.

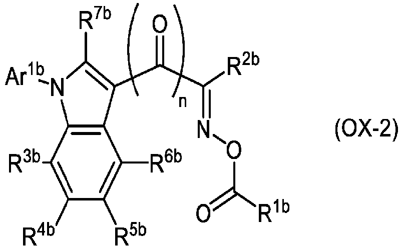

In Formula (OX-2), R^{1b} and R^{2b} each independently represent a substituent, R^{3b} to R^{7b} each independently represent a hydrogen atom or a substituent, Ar^{1b} represents an aromatic ring group or a heterocyclic group, which may have a substituent, and n represents 0 or 1.

Examples of the substituent represented by R^{1b} and R^{2b} include an alkyl group and an aryl group, and an alkyl group is preferable. The alkyl group preferably has 1 to 15 carbon atoms, and more preferably has 1 to 10 carbon atoms. The alkyl group may be linear, branched, or cyclic. The alkyl group may have a substituent. Examples of the substituent include a halogen atom, an aryl group, an alkenyl group, an alkynyl group, and a heterocyclic group. The aryl group preferably has 6 to 20 carbon atoms, more preferably has 6 to 12 carbon atoms, still more preferably 6 to 10 carbon atoms, and particularly preferably 6 carbon atoms. The aryl group may have a substituent. Examples of the substituent include a halogen atom, an alkyl group, an alkenyl group, an alkynyl group, and a heterocyclic group.

Examples of the substituent represented by R^{3b} to R^{7b} include a halogen atom, an alkyl group, and an aryl group. Examples of the alkyl group and the aryl group include groups described above.

R^{3b} to R^{7b} are preferably a hydrogen atom.

Ar^{1b} represents an aromatic ring group or a heterocyclic group, which may have a substituent, and Ar^{1b} is preferably an aromatic ring group which may have a substituent. The aromatic ring group is preferably a benzene ring group or a naphthalene ring group, and more preferably a benzene ring group. Examples of the substituent include a halogen atom, an alkyl group, an alkoxy group, an aryl group, an aryloxy group, an alkylthio group, an arylthio group, a nitro group, and an acyl group; and an acyl group is preferable. Examples of the acyl group include the above-described acyl groups.

As the photopolymerization initiator, a compound represented by Formula (OX-3) can also be used.

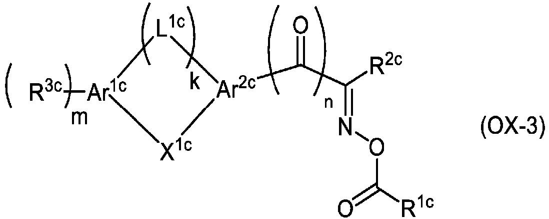

In Formula (OX-3), Ar^{1c} represents a (k+m+1)-valent aromatic ring group or a (k+m+1)-valent heterocyclic group,
Ar^{2c} represents a (k+2)-valent aromatic ring group or a (k+2)-valent heterocyclic group,
R^{1c} to R^{3c} each independently represent a substituent,
L^{1c} represents a single bond or CR^{11c}R^{12c}, R^{11c} and R^{12c} each independently represent a hydrogen atom, an alkyl group, or an aryl group,
X^{1c} represents -CH₂-, -O-, or -S-,
k represents 0 or 1, m represents an integer of 0 to 4, and n represents 0 or 1.

Examples of the substituent represented by R^{1c} and R^{2c} include an alkyl group and an aryl group, and an alkyl group is preferable. The alkyl group preferably has 1 to 15 carbon atoms, and more preferably has 1 to 10 carbon atoms. The alkyl group may be linear, branched, or cyclic. The alkyl group may have a substituent. Examples of the substituent include a halogen atom, an aryl group, an alkenyl group, an alkynyl group, and a heterocyclic group. The aryl group preferably has 6 to 20 carbon atoms, more preferably has 6 to 12 carbon atoms, still more preferably 6 to 10 carbon atoms, and particularly preferably 6 carbon atoms. The aryl group may have a substituent. Examples of the substituent include a halogen atom, an alkyl group, an alkenyl group, an alkynyl group, and a heterocyclic group.

R^{2c} is preferably an alkyl group having a branched or cyclic structure.

Examples of the substituent represented by R^{3c} include a halogen atom, an alkyl group, an alkoxy group, an aryl group, an aryloxy group, and an acyl group; and an acyl group is preferable. Examples of the acyl group include the above-described acyl groups.

L^{1c} represents a single bond or CR^{11c}R^{12c}, R^{11c} and R^{12c} each independently represent a hydrogen atom, an alkyl group, or an aryl group. The alkyl group and the aryl group in R^{11c} and R^{12c} have the same meanings as the alkyl group and the aryl group in R^{1c} and R^{2c}. In a case where k is 1, it is preferable that L^{1c} is a single bond.

X^{1c} represents -CH₂-, -O-, or -S-, and -O- or -S- is preferable.

Ar^{1c} represents a (k+m+1)-valent aromatic ring group or a (k+m+1)-valent heterocyclic group, and a (k+m+1)-valent aromatic ring group is preferable. The aromatic ring group is preferably a benzene ring group or a naphthalene ring group, and more preferably a benzene ring group.

Ar^{2c} represents a (k+2)-valent aromatic ring group or a (k+2)-valent heterocyclic group, and a (k+2)-valent aromatic ring group is preferable. The aromatic ring group is preferably a benzene ring group or a naphthalene ring group, and more preferably a benzene ring group.

k represents 0 or 1, and is preferably 0.

m represents an integer of 0 to 4, and is preferably 0 or 1 and more preferably 1.

n represents 0 or 1, and is preferably 0.

Specific examples of the oxime compound which are preferably used in the present invention are shown below, but the present invention is not limited thereto.

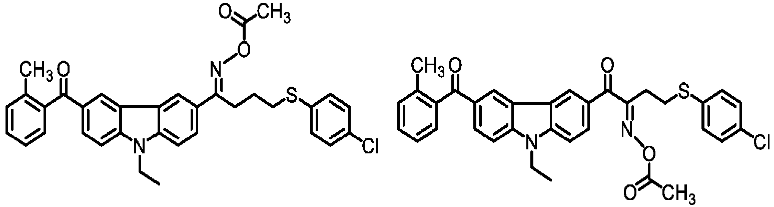

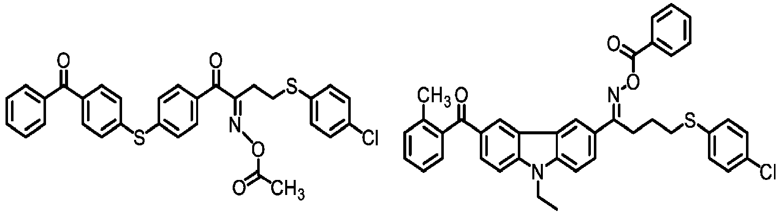

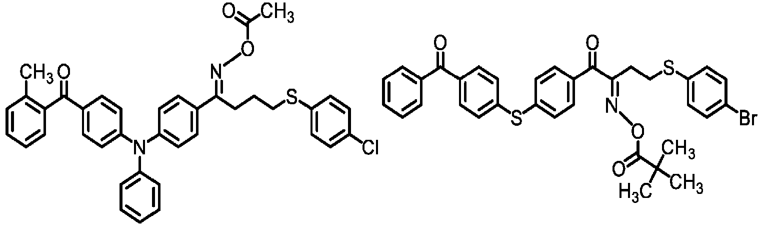

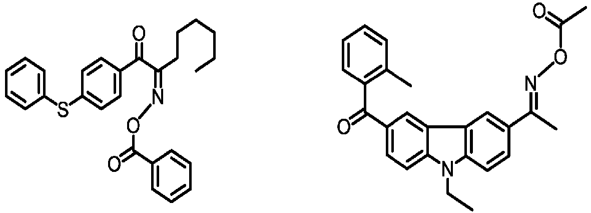

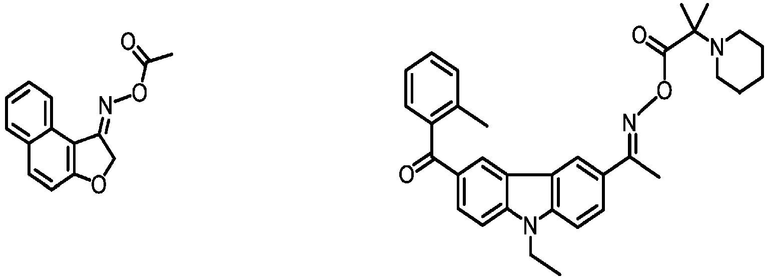

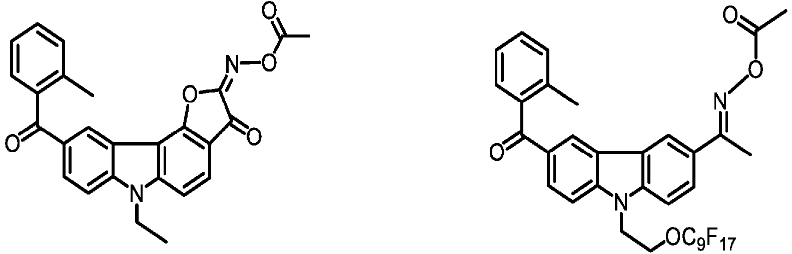

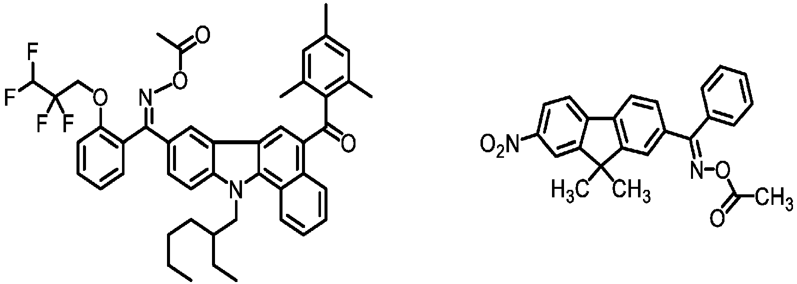

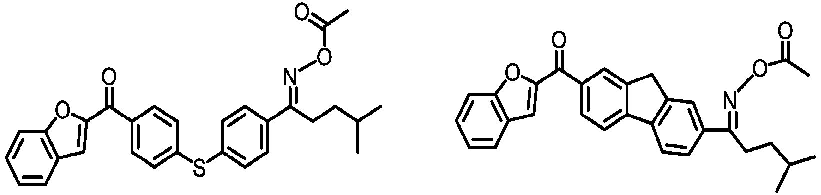

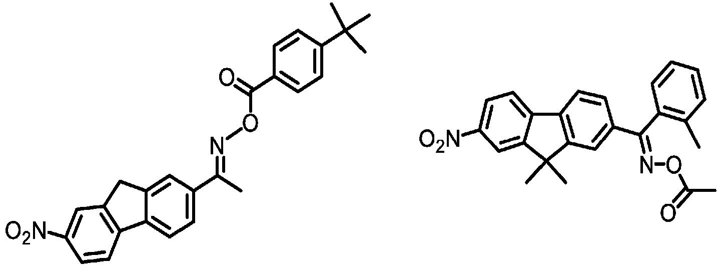

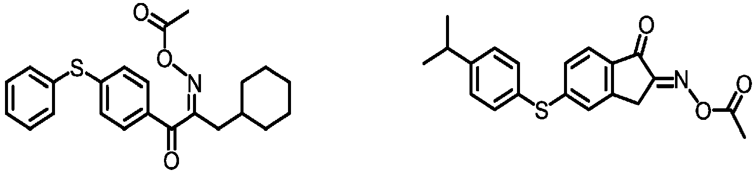

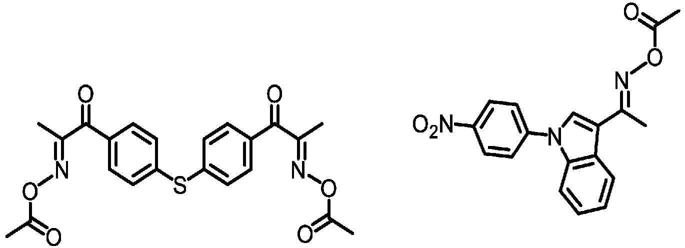

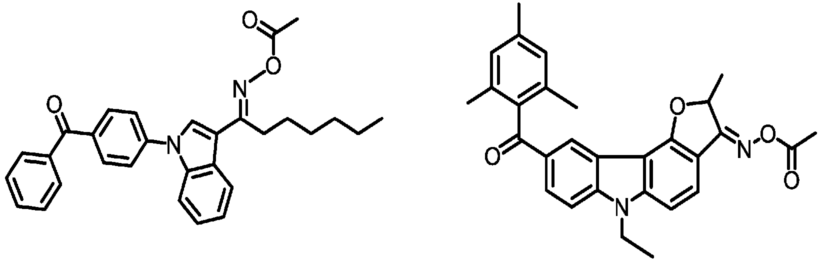

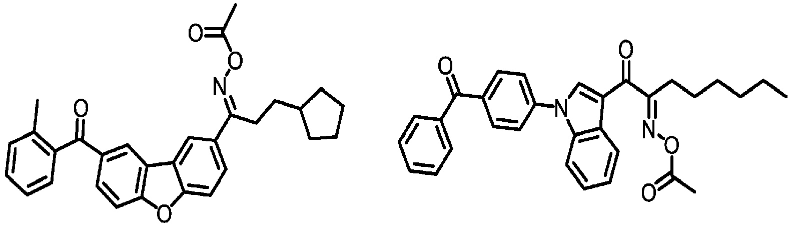

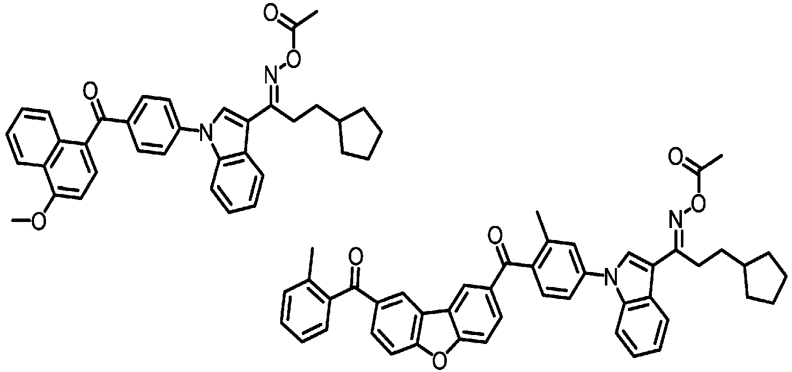

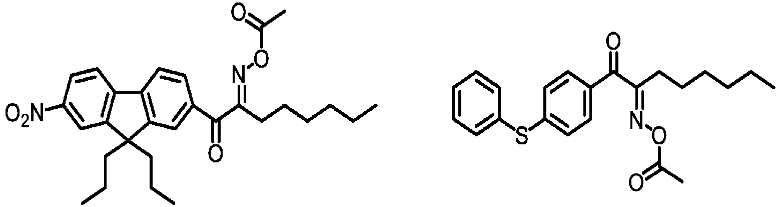

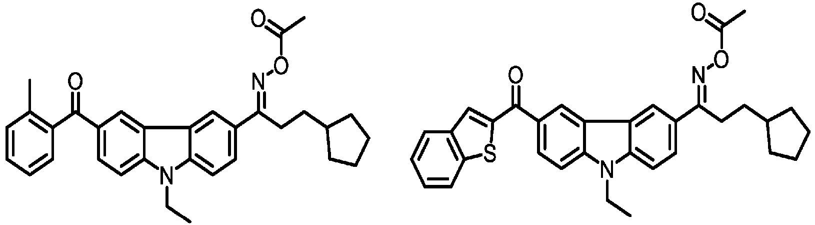

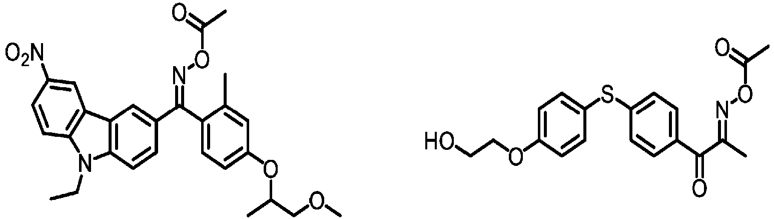

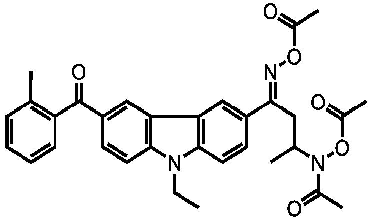

The oxime compound is preferably a compound having a maximal absorption wavelength in a wavelength in a range of 350 to 500 nm and more preferably a compound having a maximal absorption wavelength in a wavelength in a range of 360 to 480 nm. In addition, from the viewpoint of sensitivity, the molar absorption coefficient of the oxime compound at a wavelength of 365 nm or a wavelength of 405 nm is preferably high, more preferably 1,000 to 300,000, still more preferably 2,000 to 300,000, and particularly preferably 5,000 to 200,000. The molar absorption coefficient of a compound can be measured using a well-publicly known method. For example, it is preferable that the molar absorption coefficient can be measured using a spectrophotometer (Cary-5 spectrophotometer, manufactured by Varian Medical Systems, Inc.) and an ethyl acetate solvent at a concentration of 0.01 g/L.

As the photopolymerization initiator, it is also preferable to use Irgacure OXE01 (manufactured by BASF SE) and/or Irgacure OXE02 (manufactured by BASF SE) and Omnirad 2959 (manufactured by IGM Resins B.V.) in combination.

As the photopolymerization initiator, a bifunctional or tri- or higher functional photoradical polymerization initiator may be used. By using such a photoradical polymerization initiator, two or more radicals are generated from one molecule of the photoradical polymerization initiator, and as a result, good sensitivity is obtained. In addition, in a case of using a compound having an asymmetric structure, crystallinity is reduced so that solubility in a solvent or the like is improved, precipitation is to be difficult over time, and storage stability of the photosensitive composition can be improved. Specific examples of the bifunctional or tri- or higher functional photoradical polymerization initiator include the compounds described in paragraph 0148 of WO2022/065215A.

A content of the photopolymerization initiator in the total solid content of the photosensitive composition is preferably 0.1% to 20% by mass. The lower limit thereof is preferably 0.5% by mass or more, more preferably 1% by mass or more, and still more preferably 1.5% by mass or more. The upper limit is preferably 15% by mass or less and more preferably 10% by mass or less. In the photosensitive composition according to the embodiment of the present invention, the photopolymerization initiator may be used singly or in combination of two or more kinds thereof. In a case where two or more kinds thereof are used, the total amount thereof is preferably within the above-described range.

### <<Specific compound>>

The photosensitive composition according to the embodiment of the present invention contains a compound A represented by Formula (1) (hereinafter, also referred to as a specific compound).

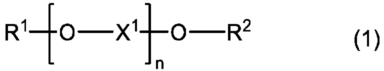

In Formula (1), R¹ and R² each independently represent a hydrogen atom, an alkyl group having 1 to 6 carbon atoms, an aryl group having 6 to 12 carbon atoms, a group having 1 to 6 carbon atoms, which includes an acid group, or a group having 1 to 6 carbon atoms, which includes an amino group, X¹ represents a linear or branched alkylene group, n represents an integer of 1 or more, and in a case where n is 2 or more, a plurality of X¹'s may be the same or different from each other.

The alkyl group represented by R¹ and R² preferably has 1 to 3 carbon atoms, and more preferably has 1 or 2 carbon atoms. The alkyl group is preferably a methyl group or an ethyl group, and from the reason that a pixel in which the occurrence of chipping is further suppressed can be formed, it is more preferably a methyl group.

The aryl group having 6 to 12 carbon atoms, represented by R¹ and R², is preferably a phenyl group or a naphthyl group and more preferably a phenyl group.

Examples of the above-described acid group in the group having 1 to 6 carbon atoms, which includes an acid group, represented by R¹ and R² include a carboxy group, a sulfonic acid group, and a phosphoric acid group.

Examples of the above-described amino group in the group having 1 to 6 carbon atoms, which includes an amino group, represented by R¹ and R² include a group represented by -NRa¹Ra². Ra¹ and Ra² each independently represent a hydrogen atom or an alkyl group having 1 to 3 carbon atoms.

From the reason that a pixel in which the occurrence of chipping is further suppressed can be formed, R¹ and R² are each independently preferably a hydrogen atom or an alkyl group having 1 to 6 carbon atoms. In addition, in addition to the above-described effect, from the reason that a photosensitive composition having favorable sensitivity during exposure can be obtained, it is preferable that one of R¹ or R² is a hydrogen atom and the other is a hydrogen atom or an alkyl group having 1 to 6 carbon atoms, and it is more preferable that R¹ and R² are hydrogen atoms. In addition, from the viewpoint of developability, at least one of R¹ or R² is preferably an alkyl group, and more preferably a methyl group.

X¹ represents a linear or branched alkylene group, and is preferably a linear alkylene group. The alkylene group preferably has 1 to 5 carbon atoms, and more preferably has 1 to 3 carbon atoms. X¹ is preferably an ethylene group.

In a case where n is 2 or more, a plurality of X¹'s may be the same or different from each other, and it is preferable that X¹'s are the same as each other. At least one of X¹'s is preferably an ethylene group, and X¹ is more preferably an ethylene group.

n in Formula (1) represents an integer of 1 or more. The upper limit thereof is preferably 500 or less, more preferably 50 or less, and still more preferably 15 or less. The lower limit thereof is preferably 2 or more, and more preferably 4 or more.

A molecular weight of the specific compound is preferably 100 to 30,000, more preferably 100 to 10,000, and still more preferably 100 to 5,000, and from the reason that a pixel in which the occurrence of chipping is further suppressed can be formed, particularly preferably 150 to 2,000. The upper limit of the molecular weight is preferably 1,000 or less, more preferably 800 or less, and still more preferably 500 or less. In the present specification, the molecular weight of the specific compound is a value calculated from a structural formula of the specific compound in a case where the molecular weight can be calculated from the structural formula; and is a value of a number-average molecular weight in a case where the molecular weight is difficult to calculate from the structural formula. The number-average molecular weight of the specific compound is a polystyrene equivalent value measured by a gel permeation chromatography (GPC) method.

A boiling point of the specific compound is preferably 150°C to 1,000°C, more preferably 250°C to 900°C, and still more preferably 300°C to 800°C, and from the reason that a pixel in which the occurrence of chipping is further suppressed can be formed, particularly preferably 320°C to 700°C.

Specific examples of the specific compound include polyethylene glycol 200, polyethylene glycol 400, polyethylene glycol 1,000, polyethylene glycol 20,000, polyethylene glycol monomethyl ether 550, polyethylene glycol dimethyl ether 550, diethylene glycol monoethyl ether, triethylene glycol monoethyl ether, ethylene glycol monobutyl ether, triethylene glycol monobutyl ether, polypropylene glycol 400, dipropylene glycol monobutyl ether, tripropylene glycol monobutyl ether, diethylene glycol monophenyl ether, (2-butoxyethoxy)acetic acid, and 2-[2-(2-aminoethoxy)ethoxy]ethanol.

A content of the specific compound in the photosensitive composition is preferably 0.01% to 5.0% by mass. The upper limit thereof is preferably 2.0% by mass or less, more preferably 1.5% by mass or less, and still more preferably 1.0% by mass or less. The lower limit thereof is preferably 0.05% by mass or more. The specific compound may be used alone or in combination of two or more kinds thereof. In a case where two or more kinds thereof are used, the total amount thereof is preferably within the above-described range.

### <<Solvent>>

The photosensitive composition according to the embodiment of the present invention contains a solvent. Examples of the solvent include an organic solvent. Basically, the type of the solvent is not particularly limited as long as it satisfies solubility of the respective components or coating properties of the composition. Examples of the organic solvent include an ester solvent, a ketone solvent, an alcohol solvent, an amide solvent, an ether solvent, and a hydrocarbon solvent. With regard to the details of the organic solvent, reference can be made to paragraph No. 0223 of WO2015/166779A, the contents of which are incorporated herein by reference. In addition, an ester-based solvent in which a cyclic alkyl group is substituted or a ketone-based solvent in which a cyclic alkyl group is substituted can also be preferably used. Specific examples of the organic solvent include polyethylene glycol monomethyl ether, dichloromethane, methyl 3-ethoxypropionate, ethyl 3-ethoxypropionate, ethyl cellosolve acetate, ethyl lactate, diethylene glycol dimethyl ether, butyl acetate, methyl 3-methoxypropionate, 2-heptanone, 2-pentanone, 3-pentanone, 4-heptanone, cyclohexanone, 2-methylcyclohexanone, 3-methylcyclohexanone, 4-methylcyclohexanone, cycloheptanone, cyclooctanone, cyclohexyl acetate, cyclopentanone, ethylcarbitol acetate, butylcarbitol acetate, propylene glycol monomethyl ether, propylene glycol monomethyl ether acetate, 3-methoxy-N,N-dimethylpropanamide, 3-butoxy-N,N-dimethylpropanamide, propylene glycol diacetate, 3-methoxybutanol, methyl ethyl ketone, γ-butyrolactone, sulfolane, anisole, 1,4-diacetoxybutane, diethylene glycol monoethyl ether acetate, butane diacetate-1,3-diyl, dipropylene glycol methyl ether acetate, diacetone alcohol (also known as diacetone alcohol or 4-hydroxy-4-methyl-2-pentanone), 2-methoxypropyl acetate, 2-methoxy-1-propanol, and isopropyl alcohol. In this case, it may be preferable that the content of aromatic hydrocarbons (such as benzene, toluene, xylene, and ethylbenzene) as the organic solvent is low (for example, 50 parts per million (ppm) by mass or less, 10 ppm by mass or less, or 1 ppm by mass or less with respect to the total amount of the organic solvent) in consideration of environmental aspects and the like.

It is preferable that a metal content in the organic solvent is small. For example, the metal content in the organic solvent is preferably 10 mass ppb (parts per billion) or lower. An organic solvent having a metal content at a level of parts per trillion (ppt) by mass may be used as necessary, and such an organic solvent is provided by Toyo Gosei Co., Ltd. (The Chemical Daily, November 13, 2015).

Examples of a method for removing impurities such as a metal from the organic solvent include distillation (such as molecular distillation and thin-film distillation) and filtration using a filter. The filter pore size of the filter used for the filtration is preferably 10 µm or less, more preferably 5 µm or less, and still more preferably 3 µm or less. As a material of the filter, polytetrafluoroethylene, polyethylene, or nylon is preferable.

The organic solvent may include an isomer (a compound having the same number of atoms and a different structure). In addition, only one kind of isomers may be included, or a plurality of isomers may be included.

The organic solvent preferably has the content of peroxides of 0.8 mmol/L or less, and more preferably, the organic solvent does not substantially contain peroxides.

A content of the solvent in the photosensitive composition is preferably 10% to 95% by mass, more preferably 20% to 90% by mass, and still more preferably 30% to 90% by mass.

From the viewpoint of environmental regulation, it is preferable that the photosensitive composition according to the embodiment of the present invention does not substantially contain environmentally regulated substances. In the present invention, the description "does not substantially contain environmentally regulated substances" means that the content of the environmentally regulated substances in the photosensitive composition is 50 ppm by mass or less, preferably 30 ppm by mass or less, still more preferably 10 ppm by mass or less, and particularly preferably 1 ppm by mass or less. Examples of the environmentally regulated substances include benzenes; alkylbenzenes such as toluene and xylene; and halogenated benzenes such as chlorobenzene. These compounds are registered as environmentally regulated substances in accordance with Registration Evaluation Authorization and Restriction of Chemicals (REACH) rules, Pollutant Release and Transfer Register (PRTR) law, Volatile Organic Compounds (VOC) regulation, and the like, and strictly regulated in their usage and handling method. These compounds can be used as a solvent in a case of producing respective components used in the photosensitive composition, and may be incorporated into the photosensitive composition as a residual solvent. From the viewpoint of human safety and environmental considerations, it is preferable to reduce these substances as much as possible. Examples of a method for reducing the environmentally regulated substances include a method for reducing the environmentally regulated substances by distilling the environmentally regulated substances from a system by heating or depressurizing the system such that the temperature of the system is higher than a boiling point of the environmentally regulated substances. In addition, in a case of distilling a small amount of the environmentally regulated substances, it is also useful to azeotrope with a solvent having the boiling point equivalent to that of the above-described solvent in order to increase efficiency. In addition, in a case of containing a compound having radical polymerizability, in order to suppress the radical polymerization reaction proceeding during the distillation under reduced pressure to cause crosslinking between the molecules, a polymerization inhibitor or the like may be added and the distillation under reduced pressure is performed. These distillation methods can be performed at any stage of raw material, product (for example, resin solution after polymerization or polyfunctional monomer solution) obtained by reacting the raw material, photosensitive composition produced by mixing these compounds, or the like.

### <<Ionic compound>>

The photosensitive composition according to the embodiment of the present invention can contain a salt of a cation CX⁺ and an anion CZ⁻ (hereinafter, also referred to as an ionic compound).

In the ionic compound, a specific absorbance represented by Expression (Aλ) is preferably 5 or less, more preferably 3 or less, and still more preferably 1 or less. The specific absorbance represented by Expression (Aλ) is an indicator indicating a degree to which the ionic compound absorbs light in a visible range. As the specific absorbance represented by Expression (Aλ) is smaller, absorption of light in the visible range is lower. The lower limit of the specific absorbance is not limited. In a case where the lower limit of the specific absorbance is provided, the specific absorbance represented by Expression (Aλ) may be determined in a range of 0.001 or more.${E}^{1} = {A}^{1} / \left({c}^{1}\times {1}^{1}\right)$

In Expression (Aλ), E¹ represents the specific absorbance of the ionic compound at the maximum absorption wavelength in a wavelength range of 400 to 700 nm,
A¹ represents an absorbance of the ionic compound at the maximum absorption wavelength in a wavelength range of 400 to 700 nm,
l¹ represents a cell length in units of cm, and
c¹ represents a concentration of the ionic compound in a solution in units of mg/ml.

The absorbance represented by "A¹" in Expression (Aλ) is measured by the following method. A measurement sample is prepared using the ionic compound and a solvent in which the ionic compound is sufficiently dissolved. In a case where the ionic compound has sufficient solubility in methanol, methanol is used as the solvent. In a case where the ionic compound does not have sufficient solubility in methanol, cyclohexanone is used as the solvent. The absorbance of the above-described measurement sample at 25°C (room temperature) is measured using a cell having an optical path length of 1 cm.

A molecular weight of the ionic compound is preferably 80 to 5,000. The upper limit thereof is preferably 3,000 or less, more preferably 2,000 or less, still more preferably 1,500 or less, and particularly preferably 1,210 or less. The lower limit thereof is preferably 100 or more, and more preferably 200 or more.

Examples of the anion CZ⁻ in the ionic compound include an imide anion, a methide anion, a borate anion, an anion containing a phosphorus atom, and a sulfonate anion. Among these, an imide anion, a methide anion, or a borate anion is preferable, and an imide anion or a borate anion is still more preferable. In addition, the anion CZ⁻ is also preferably an anion containing at least one selected from a fluorine atom or a sulfur atom.

From the viewpoint of storage stability of the photosensitive composition, a pKa of a conjugate acid of the anion CZ⁻ in the ionic compound is preferably 0 or less, more preferably -5 or less, still more preferably -8 or less, even more preferably -10 or less, and particularly preferably -10.5 or less. The lower limit is not particularly limited, but may be -20 or more or may be -18 or more. For example, the pKa of the conjugate acid can be measured by a method described in J. Org. Chem. 2011, 76, pp. 391 to 395.

In the ionic compound, the cation CX⁺ may be any cation as long as it has a structure capable of offsetting the charge of the anion CZ⁻.

From the viewpoint of easily reducing the ionic bond energy with the anion CZ⁻, a molecular weight of the cation CX⁺ is preferably 2 to 500, more preferably 2 to 200, and still more preferably 6 to 90.

The cation CX⁺ is preferably a cation of a single metal atom, a carbocation, an ammonium cation, a phosphonium cation, or a sulfonium cation, and more preferably a cation of a single metal atom or an ammonium cation. In addition, it is also preferable that the cation CX⁺ is a divalent or higher valent cation. According to the aspect, a firmer film can be formed, and chipping or the like of the film after development can be more effectively suppressed.

Specific examples of the ionic compound include the following compounds.

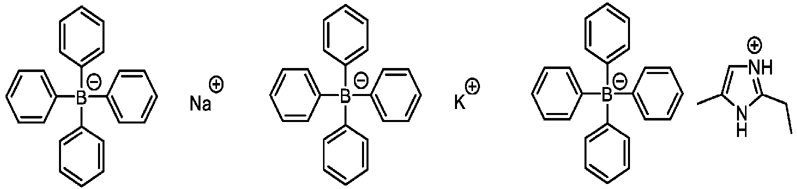

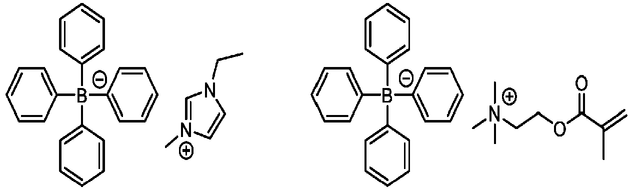

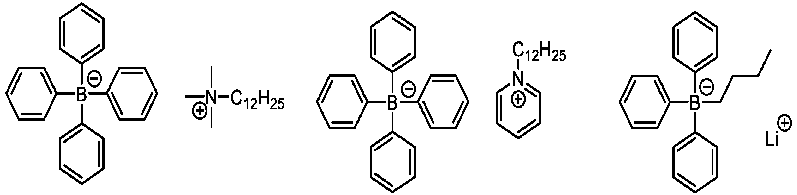

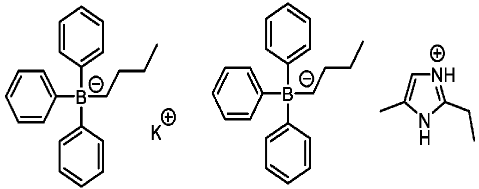

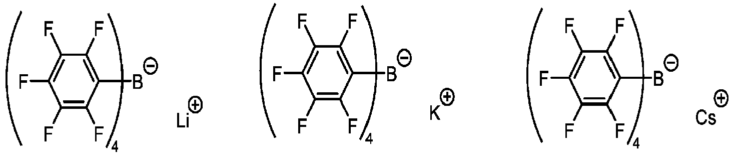

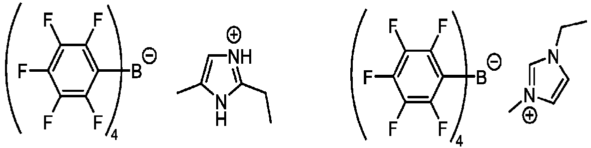

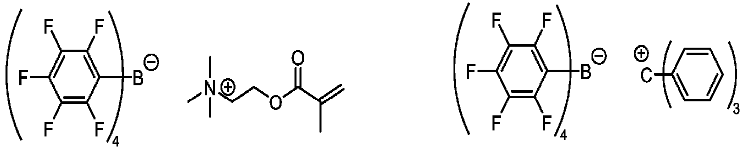

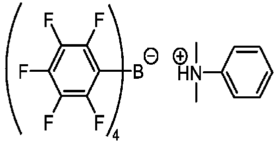

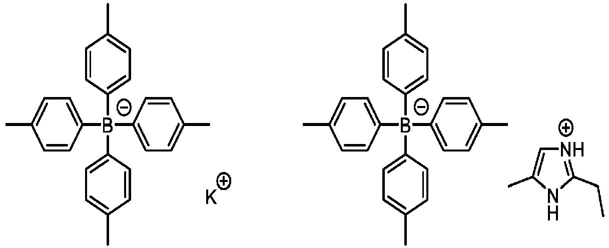

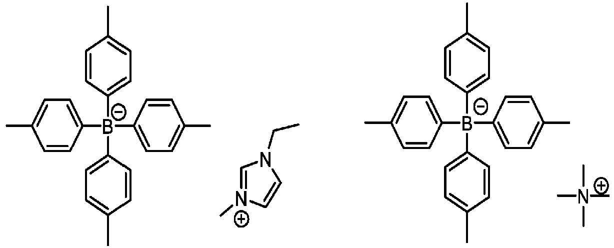

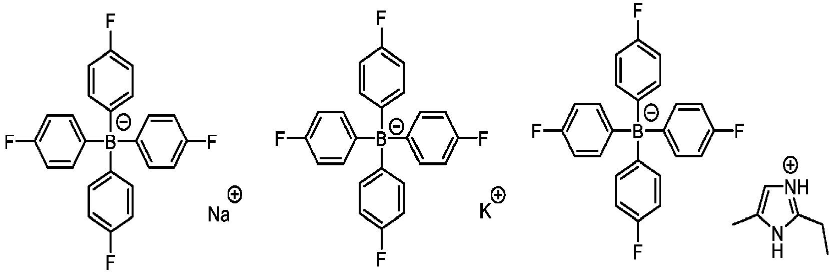

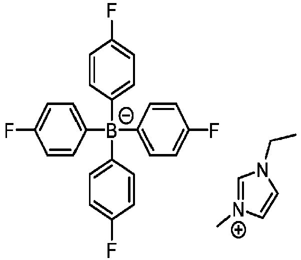

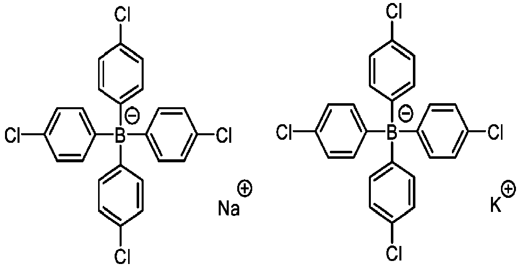

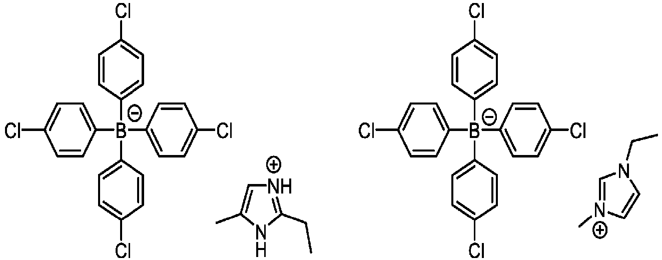

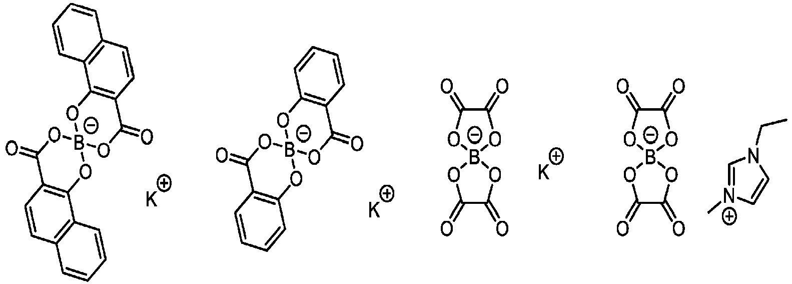

A content of the ionic compound in the total solid content of the photosensitive composition is preferably 0.1% to 15% by mass. The upper limit thereof is preferably 12% by mass or less, and more preferably 10% by mass or less. The lower limit thereof is preferably 0.5% by mass or more, and more preferably 1% by mass or more. The ionic compound may be used alone or in combination of two or more kinds thereof. In a case where two or more kinds thereof are used, the total amount thereof is preferably within the above-described range.

### <<Polyalkyleneimine>>

The photosensitive composition according to the embodiment of the present invention can also contain polyalkyleneimine. The polyalkyleneimine is used, for example, as a dispersion aid for the pigment. The dispersion aid refers to a material for increasing dispersibility of the coloring material such as a pigment in the photosensitive composition. The polyalkyleneimine is a polymer obtained by ring-opening polymerization of alkyleneimine. The polyalkyleneimine is preferably a polymer having a branched structure including each of a primary amino group, a secondary amino group, and a tertiary amino group. The number of carbon atoms in the alkyleneimine is preferably 2 to 6, more preferably 2 to 4, still more preferably 2 or 3, and particularly preferably 2.

A molecular weight of the polyalkyleneimine is preferably 200 or more and more preferably 250 or more. The upper limit thereof is preferably 100,000 or less, more preferably 50,000 or less, still more preferably 10,000 or less, and particularly preferably 2,000 or less. With regard to the value of the molecular weight of the polyalkyleneimine, in a case where the molecular weight can be calculated from a structural formula, the molecular weight of the polyalkyleneimine is a value calculated from the structural formula. On the other hand, in a case where the molecular weight of the specific amine compound cannot be calculated from the structural formula or is difficult to calculate, a value of a number-average molecular weight measured by a boiling point increase method is used. In addition, even in a case where the molecular weight of the polyalkyleneimine cannot be measured by the boiling point increase method or is difficult to be measured, a value of a number-average molecular weight measured by a viscosity method is used. In addition, in a case where the molecular weight of the polyalkyleneimine cannot be measured by the viscosity method or is difficult to be measured by the viscosity method, a value of a number-average molecular weight in terms of polystyrene through measurement by a gel permeation chromatography (GPC) method is used.

An amine value of the polyalkyleneimine is preferably 5 mmol/g or more, more preferably 10 mmol/g or more, and still more preferably 15 mmol/g or more.

Specific examples of the alkyleneimine include ethyleneimine, propyleneimine, 1,2-butyleneimine, and 2,3-butyleneimine, and ethyleneimine or propyleneimine is preferable and ethyleneimine is more preferable. The polyalkyleneimine is particularly preferably polyethyleneimine. In addition, the polyethyleneimine preferably includes the primary amino group in an amount of 10 mol% or more, more preferably includes the primary amino group in an amount of 20 mol% or more, and still more preferably includes the primary amino group in an amount of 30 mol% or more with respect to the total of the primary amino group, the secondary amino group, and the tertiary amino group. Examples of a commercially available product of the polyethyleneimine include EPOMIN SP-003, SP-006, SP-012, SP-018, SP-200, and P-1000 (all of which are manufactured by NIPPON SHOKUBAI CO., LTD.).

A content of the polyalkyleneimine in the total solid content of the photosensitive composition is preferably 0.1% to 5% by mass. The lower limit thereof is preferably 0.2% by mass or more, more preferably 0.5% by mass or more, and still more preferably 1% by mass or more. The upper limit is preferably 4.5% by mass or less, more preferably 4% by mass or less, and still more preferably 3% by mass or less. In addition, the content of the polyalkyleneimine is preferably 0.5 to 20 parts by mass with respect to 100 parts by mass of the pigment. The lower limit thereof is preferably 0.6 parts by mass or more, more preferably 1 part by mass or more, and still more preferably 2 parts by mass or more. The upper limit thereof is preferably 10 parts by mass or less and more preferably 8 parts by mass or less. The polyalkyleneimine may be used alone or in combination of two or more kinds thereof. In a case where two or more kinds thereof are used, the total amount thereof is preferably within the above-described range.

### <<Compound having cyclic ether group>>

The photosensitive composition according to the embodiment of the present invention can contain a compound having a cyclic ether group. Examples of the cyclic ether group include an epoxy group and an oxetanyl group. The epoxy group may be an alicyclic epoxy group. The alicyclic epoxy group means a monovalent functional group having a cyclic structure, in which an epoxy ring and a saturated hydrocarbon ring are fused. The compound having a cyclic ether group is preferably a compound having an epoxy group (hereinafter also referred to as an "epoxy compound"). Examples of the epoxy compound include a compound having one or more epoxy groups in one molecule, and a compound having two or more epoxy groups in one molecule is preferable. The epoxy compound is preferably a compound having 1 to 100 epoxy groups in one molecule. The upper limit of the number of epoxy groups included in the epoxy compound may be, for example, 10 or less or 5 or less. The lower limit of the epoxy group included in the epoxy compound is preferably 2 or more.

As the compound having a cyclic ether group, the compounds described in paragraph Nos. 0034 to 0036 of JP2013-011869A, the compounds described in paragraph Nos. 0147 to 0156 of JP2014-043556A, the compounds described in paragraph Nos. 0085 to 0092 of JP2014-089408A, the compounds described in JP2017-179172A, the xanthene-type epoxy resin described in JP2021-195421A, and the xanthene-type epoxy resin described in JP2021-195422A can be used.

The compound having a cyclic ether group may be a low-molecular-weight compound (for example, having a molecular weight of less than 2000, and further, a molecular weight of less than 1000) or a high-molecular-weight compound (macromolecule) (for example, having a molecular weight of 1000 or more, and in a case of a polymer, having a weight-average molecular weight of 1000 or more). A weight-average molecular weight of the compound having a cyclic ether group is preferably 200 to 100,000 and more preferably 500 to 50,000. The upper limit of the weight-average molecular weight is preferably 10,000 or less, more preferably 5,000 or less, and still more preferably 3,000 or less.

Examples of a commercially available product of the compound having a cyclic ether group include EHPE 3150 (manufactured by Daicel Corporation), EPICLON N-695 (manufactured by DIC Corporation), and MARPROOF G-0150M, G-0105SA, G-0130SP, G-0250SP, G-1005S, G-1005SA, G-1010S, G-2050M, G-01100, and G-01758 (all of which are manufactured by NOF Corporation., an epoxy group-containing polymer).

A content of the compound having a cyclic ether group in the total solid content of the photosensitive composition is preferably 0.1% to 20% by mass. The lower limit thereof is preferably 0.5% by mass or more, and more preferably 1% by mass or more. The upper limit is preferably 15% by mass or less and more preferably 10% by mass or less. The compound having a cyclic ether group may be used alone or in combination of two or more kinds thereof. In a case where two or more kinds thereof are used, the total amount thereof is preferably within the above-described range.

### <<Curing accelerator>>

The photosensitive composition according to the embodiment of the present invention can contain a curing accelerator. Examples of the curing accelerator include a thiol compound, a methylol compound, an amine compound, a phosphonium salt compound, an amidine salt compound, an amide compound, a base generator, an isocyanate compound, an alkoxysilane compound, and an onium salt compound. Specific examples of the curing accelerator include the compounds described in paragraph 0164 of WO2022/085485A and the compounds described in JP2021-181406A. A content of the curing accelerator in the total solid content of the photosensitive composition is preferably 0.3% to 8.9% by mass and more preferably 0.8% to 6.4% by mass.

### <<Ultraviolet absorber>>

The photosensitive composition according to the embodiment of the present invention can contain an ultraviolet absorber. Examples of the ultraviolet absorber include a conjugated diene compound, an aminodiene compound, a salicylate compound, a benzophenone compound, a benzotriazole compound, an acrylonitrile compound, a hydroxyphenyltriazine compound, an indole compound, a triazine compound, and a dibenzoyl compound. Specific examples of such a compound include the compounds described in paragraph No. 0179 of WO2022/085485A, the reactive triazine ultraviolet absorber described in JP2021-178918A, the ultraviolet absorber described in JP2022-007884A, the compounds described in KR10-2022-0014454A, and the compounds described in JP2023-013321A. A content of the ultraviolet absorber in the total solid content of the photosensitive composition is preferably 0.01% to 10% by mass and more preferably 0.01% to 5% by mass. The ultraviolet absorber may be used alone or in combination of two or more kinds thereof. In a case where two or more kinds thereof are used, the total amount thereof is preferably within the above-described range.

### <<Polymerization Inhibitor>>

The photosensitive composition according to the embodiment of the present invention can contain a polymerization inhibitor. Examples of the polymerization inhibitor include hydroquinone, p-methoxyphenol, di-tert-butyl-p-cresol, pyrogallol, tert-butylcatechol, benzoquinone, 4,4'-thiobis(3-methyl-6-tert-butylphenol), 2,2'-methylenebis(4-methyl-6-t-butylphenol), and an N-nitrosophenylhydroxylamine salt (for example, an ammonium salt and a cerous salt). Among these, p-methoxyphenol is preferable. A content of the polymerization inhibitor in the total solid content of the photosensitive composition is preferably 0.0001% to 5% by mass. The polymerization inhibitor may be used alone or in combination of two or more kinds thereof. In a case of two or more kinds thereof, the total amount thereof is preferably within the above-described range.

### <<Silane coupling agent>>

The photosensitive composition according to the embodiment of the present invention can contain a silane coupling agent. Examples of the silane coupling agent include a silane compound having a hydrolyzable group, and a silane compound having a hydrolyzable group and a functional group other than the hydrolyzable group is preferable. The hydrolyzable group refers to a substituent directly linked to a silicon atom and capable of forming a siloxane bond due to at least one of a hydrolysis reaction or a condensation reaction. Examples of the hydrolyzable group include a halogen atom, an alkoxy group, and an acyloxy group, and an alkoxy group is preferable. That is, it is preferable that the silane coupling agent is a compound containing an alkoxysilyl group. Examples of the functional group other than the hydrolyzable group include a vinyl group, a (meth)allyl group, a (meth)acryloyl group, a mercapto group, an epoxy group, an oxetanyl group, an amino group, a ureido group, a sulfide group, an isocyanate group, and a phenyl group, and an amino group, a (meth)acryloyl group, or an epoxy group is preferable. Specific examples of the silane coupling agent include the compounds described in paragraph 0177 of WO2022/085485A and the compounds described in JP2019-183020A. A content of the silane coupling agent in the total solid content of the photosensitive composition is preferably 0.1% to 15% by mass. The upper limit is preferably 10% by mass or less and more preferably 5% by mass or less. The lower limit thereof is preferably 0.5% by mass or more, and more preferably 1% by mass or more. The silane coupling agent may be used alone or in combination of two or more kinds thereof. In a case of two or more kinds thereof, the total amount thereof is preferably within the above-described range.

### <<Surfactant>>

The photosensitive composition according to the embodiment of the present invention can contain a surfactant. As the surfactants, various surfactants such as a fluorine-based surfactant, a nonionic surfactant, a cationic surfactant, an anionic surfactant, or a silicone-based surfactant can be used. The surfactant is preferably a silicone-based surfactant or a fluorine-based surfactant, and more preferably a silicone-based surfactant. With regard to the surfactant, surfactants described in paragraph Nos. 0238 to 0245 of WO2015/166779A can be referred to, the contents of which are incorporated herein by reference.

As the fluorine-based surfactant, the compounds described in paragraph Nos. 0167 to 0173 of WO2022/085485A can be used.

Examples of the nonionic surfactant include the compounds described in paragraph 0174 of WO2022/085485A.

Examples of the silicone-based surfactant include DOWSIL SH8400, SH8400 FLUID, FZ-2122, 67 Additive, 74 Additive, M Additive, and SF 8419 OIL (all manufactured by Dow Toray Co., Ltd.), TSF-4300, TSF-4445, TSF-4460, and TSF-4452 (all manufactured by Momentive Performance Materials Inc.), KP-341, KF-6000, KF-6001, KF-6002, and KF-6003 (all manufactured by Shin-Etsu Chemical Co., Ltd.), and BYK-307, BYK-322, BYK-323, BYK-330, BYK-333, BYK-3760, and BYK-UV3510 (all manufactured by BYK-Chemie). In addition, as the silicone-based surfactant, a compound having the following structure can also be used.

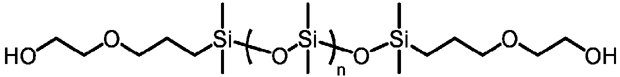

A content of the surfactant in the total solid content of the photosensitive composition is preferably 0.001% by mass to 5.0% by mass and more preferably 0.005% to 3.0% by mass. The surfactant may be used singly or in a combination of two or more kinds thereof. In a case of two or more kinds thereof, the total amount thereof is preferably within the above-described range.

### <<Antioxidant>>

The photosensitive composition according to the embodiment of the present invention can contain an antioxidant. Examples of the antioxidant include a phenol-based antioxidant, an amine-based antioxidant, a phosphorus-based antioxidant, and a sulfur-based antioxidant. Examples of the phenol-based antioxidant include a hindered phenol compound. The phenol-based antioxidant is preferably a compound having a substituent at a site (ortho position) adjacent to a phenolic hydroxy group. As the substituent, a substituted or unsubstituted alkyl group having 1 to 22 carbon atoms is preferable. As the antioxidant, a compound having a phenol group and a phosphite ester group in the same molecule is also preferable. Examples of the phosphorus antioxidant include tris[2-[[2,4,8,10-tetrakis(1,1-dimethylethyl)dibenzo[d,f][1,3,2]dioxaphosphepin-6-yl]oxy]ethyl ]amine, tris[2-[(4,6,9,11-tetra-tert-butyldibenzo[d,f][1,3,2]dioxaphosphepin-2-yl)oxy]ethyl]amine, ethyl bis(2,4-di-tert-butyl-6-methylphenyl)phosphite, and tris(2,4-di-tert-butylphenyl)phosphite. Examples of a commercially available product of the antioxidant include ADK STAB AO-20, ADK STAB AO-30, ADK STAB AO-40, ADK STAB AO-50, ADK STAB AO-50F, ADK STAB AO-60, ADK STAB AO-60G, ADK STAB AO-80, and ADK STAB AO-330 (all of which are manufactured by ADEKA Corporation), and JP-650 (manufactured by Johoku Chemical Co., Ltd.). As the antioxidant, compounds described in paragraph Nos. 0023 to 0048 of JP6268967B, compounds described in WO2017/006600A, compounds described in WO2017/164024A, or compounds described in KR10-2019-0059371A can also be used. A content of the antioxidant in the total solid content of the photosensitive composition is preferably 0.01% to 20% by mass and more preferably 0.3% to 15% by mass. The antioxidant may be used alone or in combination of two or more kinds thereof. In a case where two or more kinds thereof are used, the total amount thereof is preferably within the above-described range.

### <<Other components>>

Optionally, the photosensitive composition according to the embodiment of the present invention may contain a sensitizer, a plasticizer, and other auxiliary agents (for example, conductive particles, a filler, a defoamer, a flame retardant, a leveling agent, a peeling accelerator, an aromatic chemical, a surface tension adjuster, or a chain transfer agent). By appropriately containing these components, properties such as film properties can be adjusted. As these components, the compounds described in paragraph No. 0182 of WO2022/085485A can be used.

In order to adjust the refractive index of a film to be obtained, the photosensitive composition according to the embodiment of the present invention may contain a metal oxide. Examples of the metal oxide include TiO₂, ZrO₂, Al₂O₃, and SiO₂. The primary particle diameter of the metal oxide is preferably 1 to 100 nm, more preferably 3 to 70 nm, and still more preferably 5 to 50 nm. The metal oxide may have a core-shell structure. In addition, in this case, the core portion may be hollow.

The photosensitive composition according to the embodiment of the present invention may include a light-resistance improver. Examples of the light-resistance improver include the compounds described in paragraph No. 0183 of WO2022/085485A.

It is also preferable that the photosensitive composition according to the embodiment of the present invention does not substantially include terephthalic acid ester. Here, the "does not substantially include" means that the content of terephthalic acid ester is 1000 mass ppb or less in the total amount of the photosensitive composition, and it is more preferable to be 100 mass ppb or less and particularly preferable to be 0.

From the viewpoint of environmental regulation, it is preferable that a content of melamine in the photosensitive composition according to the embodiment of the present invention is 10,000 ppm by mass or less.

In the photosensitive composition according to the embodiment of the present invention, a liberated metal content is preferably 100 ppm or less, and more preferably 50 ppm or less. In addition, a liberated halogen content is preferably 100 ppm or less, and more preferably 50 ppm or less. Examples of a method for reducing liberated metals and halogens in the photosensitive composition include washing with ion exchange water, filtration, ultrafiltration, and purification with an ion exchange resin.

From the viewpoint of environmental regulation, sometimes the use of perfluoroalkyl sulfonic acid and a salt thereof, and perfluoroalkyl carboxylic acid and a salt thereof is restricted. In the photosensitive composition according to the embodiment of the present invention, in a case of reducing a content of the above-described compounds, the content of the perfluoroalkyl sulfonic acid (particularly, perfluoroalkyl sulfonic acid in which a perfluoroalkyl group has 6 to 8 carbon atoms) and a salt thereof and the perfluoroalkyl carboxylic acid (particularly, perfluoroalkyl carboxylic acid in which a perfluoroalkyl group has 6 to 8 carbon atoms) and a salt thereof is preferably in a range of 0.01 ppb to 1000 ppb, more preferably in a range of 0.05 ppb to 500 ppb, and still more preferably in a range of 0.1 ppb to 300 ppb with respect to the total solid content of the photosensitive composition. The photosensitive composition according to the embodiment of the present invention may be substantially free of the perfluoroalkyl sulfonic acid and a salt thereof and the perfluoroalkyl carboxylic acid and a salt thereof. For example, by using a compound which can substitute for the perfluoroalkyl sulfonic acid and a salt thereof and the perfluoroalkyl carboxylic acid and a salt thereof, a photosensitive composition which is substantially free of the perfluoroalkyl sulfonic acid and a salt thereof and the perfluoroalkyl carboxylic acid and a salt thereof may be selected. Examples of the compound which can substitute for the regulated compounds include a compound which is excluded from the regulation due to difference in number of carbon atoms of the perfluoroalkyl group. Here, what are described above do not prevent the use of the perfluoroalkyl sulfonic acid and a salt thereof and the perfluoroalkyl carboxylic acid and a salt thereof. The photosensitive composition according to the embodiment of the present invention may include the perfluoroalkyl sulfonic acid and a salt thereof and the perfluoroalkyl carboxylic acid and a salt thereof within the maximum allowable range.

The moisture content in the photosensitive composition according to the embodiment of the present invention is usually 3% by mass or less, preferably 0.01% to 1.5% by mass and more preferably in a range of 0.1% to 1.0% by mass. The moisture content can be measured by a Karl Fischer method.

The photosensitive composition according to the embodiment of the present invention can be used after viscosity is adjusted for the purposes of adjusting the state of a film surface (flatness or the like), adjusting a film thickness, or the like. A value of the viscosity can be appropriately selected as desired, and is, for example, preferably 0.3 mPa·s to 50 mPa·s, and more preferably 0.5 mPa·s to 20 mPa·s at 25°C. As for a method for measuring the viscosity, the viscosity can be measured, for example, with a temperature being adjusted to 25°C, using a cone plate-type viscometer.

### <<Storage container>>

A storage container for the photosensitive composition is not particularly limited, and a known storage container can be used. In addition, as the storage container, a container described in paragraph 0187 of WO2022/085485A can be used.

### <Method for preparing photosensitive composition>

The photosensitive composition according to the embodiment of the present invention can be prepared by mixing the above-described components with each other. In the preparation of the photosensitive composition, all the components may be dissolved and/or dispersed at the same time in a solvent to prepare the photosensitive composition, or the respective components may be appropriately prepared as two or more solutions or dispersion liquids in advance and mixed to prepare the photosensitive composition upon use (during coating), as desired.

In the preparation of the photosensitive composition, a process for dispersing the pigment is preferably included. In the process for dispersing the pigment, examples of a mechanical force which is used for dispersing the pigment include compression, pressing, impact, shear, and cavitation. Specific examples of these processes include a beads mill, a sand mill, a roll mill, a ball mill, a paint shaker, a microfluidizer, a high-speed impeller, a sand grinder, a flow jet mixer, high-pressure wet atomization, and ultrasonic dispersion. In addition, in the pulverization of the pigment in a sand mill (beads mill), it is preferable to perform a treatment under the condition for increasing a pulverization efficiency by using beads having small diameters; increasing the filling rate of the beads; or the like. Incidentally, it is preferable to remove coarse particles by filtration, centrifugation, or the like after the pulverization treatment. In addition, as the process and the dispersing machine for dispersing the pigment, the process and the dispersing machine described in "Dispersion Technology Comprehension, published by Johokiko Co., Ltd., July 15, 2005", "Actual comprehensive data collection on dispersion technology and industrial application centered on suspension (solid/liquid dispersion system), published by Publication Department, Management Development Center, October 10, 1978", and paragraph No. 0022 of JP2015-157893A can be suitably used. In addition, in the process for dispersing the pigment, a refining treatment of particles in a salt milling step may be performed. A material, a device, process conditions, and the like used in the salt milling step can be found in, for example, JP2015-194521A and JP2012-046629A. Examples of a material for the beads used for the dispersion include zirconia, agate, quartz, titania, tungsten carbide, silicon nitride, alumina, stainless steel, and glass. In addition, as the beads, an inorganic compound having a Mohs hardness of 2 or more can also be used. The photosensitive composition may contain 1 to 10,000 ppm of the above-described beads.

It is preferable that, in the preparation of the photosensitive composition, the photosensitive composition is filtered through a filter for the purpose of removing foreign matters, reducing defects, or the like. Examples of the type of the filter used for the filtration and the filtration method include the filter and the filtration method described in paragraph Nos. 0196 to 0199 of WO2022/085485A.

### <Film>

A film according to an embodiment of the present invention is a film obtained from the above-described photosensitive composition according to the embodiment of the present invention. The film according to the embodiment of the present invention can be used for an optical filter such as a color filter, an infrared transmitting filter, and an infrared cut filter.

A film thickness of the film according to the embodiment of the present invention can be adjusted according to the purpose. For example, the film thickness is preferably 20 µm or less, more preferably 10 µm or less, and still more preferably 5 µm or less. The lower limit of the film thickness is preferably 0.1 µm or more, more preferably 0.2 µm or more, and still more preferably 0.3 µm or more.

In a case where the film according to the embodiment of the present invention is used as a color filter, the film according to the embodiment of the present invention preferably has a hue of green, red, blue, cyan, magenta, or yellow. In addition, the film according to the embodiment of the present invention can be preferably used as a colored pixel of a color filter. Examples of the colored pixel include a red pixel, a green pixel, a blue pixel, a magenta pixel, a cyan pixel, and a yellow pixel.

### <Optical filter>

The film according to the embodiment of the present invention can be used for an optical filter. Examples of the type of the optical filter include a color filter, an infrared cut filter, and an infrared transmitting filter; and a color filter is preferable. The color filter preferably has the film according to the embodiment of the present invention as a pixel thereof, and more preferably has the film according to the embodiment of the present invention as a colored pixel.

In the optical filter, a protective layer may be provided on the surface of the film according to the embodiment of the present invention. By providing the protective layer, various functions such as oxygen shielding, low reflection, hydrophilicity/hydrophobicity, and shielding of light (ultraviolet rays, infrared rays, and the like) having a specific wavelength can be imparted. A thickness of the protective layer is preferably 0.01 to 10 µm and more preferably 0.1 to 5 µm. Examples of a method for forming the protective layer include a method of forming the protective layer by applying a resin composition for forming a protective layer, a chemical vapor deposition method, and a method of attaching a molded resin with an adhesive. Examples of components constituting the protective layer include a (meth)acrylic resin, an ene-thiol resin, a polycarbonate resin, a polyether resin, a polyarylate resin, a polysulfone resin, a polyethersulfone resin, a polyphenylene resin, a polyarylene ether phosphine oxide resin, a polyimide resin, a polyamidoimide resin, a polyolefin resin, a cyclic olefin resin, a polyester resin, a styrene resin, a polyol resin, a polyvinylidene chloride resin, a melamine resin, a urethane resin, an aramid resin, a polyamide resin, an alkyd resin, an epoxy resin, a modified silicone resin, a fluororesin, a polyacrylonitrile resin, a cellulose resin, Si, C, W, Al₂O₃, Mo, SiO₂, and Si₂N₄; and two or more kinds of these components may be contained. For example, in a case of a protective layer for oxygen shielding, it is preferable that the protective layer contains a polyol resin, SiO₂, and Si₂N₄. In addition, in a case of a protective layer for low reflection, it is preferable that the protective layer contains a (meth)acrylic resin and a fluororesin.

In a case of forming the protective layer by applying a resin composition, as a method for applying the resin composition, a known method such as a spin coating method, a casting method, a screen printing method, and an inkjet method can be used. As the organic solvent included in the resin composition, a known organic solvent (for example, propylene glycol 1-monomethyl ether 2-acetate, cyclopentanone, ethyl lactate, and the like) can be used. In a case of forming the protective layer by a chemical vapor deposition method, as the chemical vapor deposition method, a known chemical vapor deposition method (thermochemical vapor deposition method, plasma chemical vapor deposition method, and photochemical vapor deposition method) can be used.

The protective layer may contain, as desired, an additive such as organic or inorganic fine particles, an absorber of light (for example, ultraviolet rays, infrared rays, and the like) having a specific wavelength, a refractive index adjusting agent, an antioxidant, an adhesive agent, and a surfactant. Examples of the organic or inorganic fine particles include polymer fine particles (for example, silicone resin fine particles, polystyrene fine particles, and melamine resin fine particles), titanium oxide, zinc oxide, zirconium oxide, indium oxide, aluminum oxide, titanium nitride, titanium oxynitride, magnesium fluoride, hollow silica, silica, calcium carbonate, and barium sulfate. As the absorber of light having a specific wavelength, a known absorber can be used. The content of these additives can be appropriately adjusted, but is preferably 0.1% to 70% by mass and still more preferably 1% to 60% by mass with respect to the total mass of the protective layer.

As the protective layer, protective layers described in paragraph Nos. 0073 to 0092 of JP2017-151176A can also be used.

The optical filter may have a structure in which each pixel is embedded in a space partitioned in, for example, a lattice form by a partition wall.

### <Method for manufacturing optical filter>

A method for manufacturing an optical filter using the photosensitive composition according to the embodiment of the present invention will be described. The method for manufacturing an optical filter includes a step of forming a composition layer on a support using the photosensitive composition according to the embodiment of the present invention, and
a step of forming a pattern on the composition layer by a photolithography method.

The pattern forming method by the photolithography method preferably includes a step of exposing the composition layer in a patterned manner and a step of removing a non-exposed portion of the composition layer by development.

In the step of forming a composition layer, the composition layer is formed on a support using the photosensitive composition according to the embodiment of the present invention. The support is not particularly limited, and can be appropriately selected depending on applications. Examples thereof include a glass substrate and a silicon substrate, and a silicon substrate is preferable. In addition, a charge coupled device (CCD), a complementary metal-oxide semiconductor (CMOS), a transparent conductive film, or the like may be formed on the silicon substrate. In some cases, a black matrix for isolating each pixel is formed on the silicon substrate. In addition, a base layer may be provided on the silicon substrate for improving adhesiveness to an upper layer, preventing the diffusion of materials, or planarizing the surface of the substrate. A surface contact angle of the base layer is preferably 20° to 70° in a case of being measured with diiodomethane. In addition, the surface contact angle of the base layer is preferably 30° to 80° in a case of being measured with water.

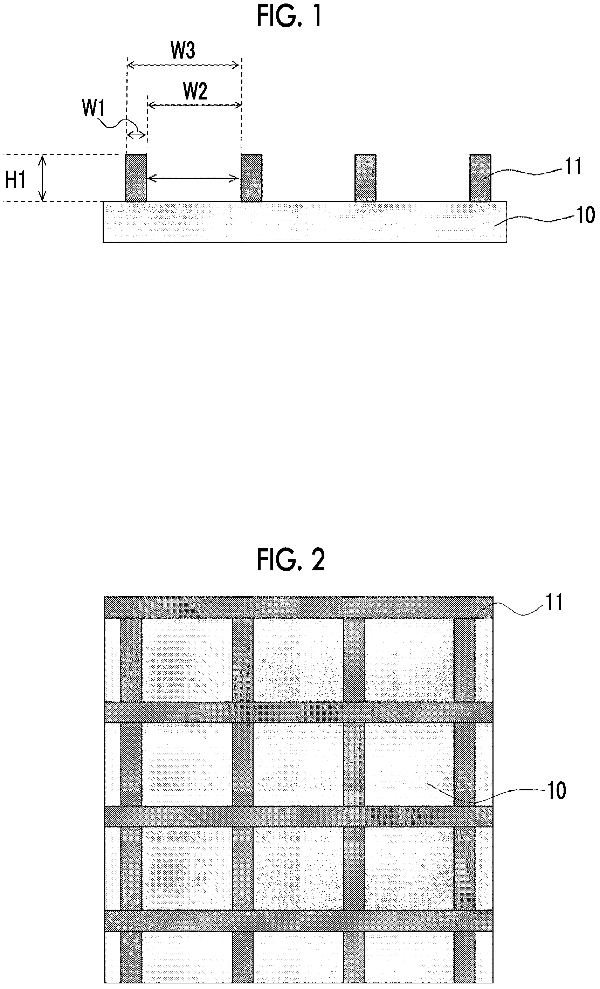

A support having a partition wall can also be used as the support. FIG. 1 is a side cross-sectional view showing an embodiment of the support having a partition wall, and FIG. 2 is a plan view of the support as seen from directly above. In FIG. 1, a partition wall 11 is formed on a surface of a support 10. As shown in FIG. 2, a plurality of regions partitioned by the partition wall 11 are provided on the surface of the support 10. In FIG. 2, the partition wall 11 is formed in a lattice shape on the surface of the support 10, and the shape of the region partitioned by the partition wall 11 on the support 10 (hereinafter, also referred to as the shape of an opening of the partition wall) is square, but the shape of the opening of the partition wall 11 is not particularly limited, and may be, for example, rectangular, circular, elliptical, or polygonal. In addition, in FIG. 1, the partition wall 11 has a columnar shape, but the shape of the partition wall is not limited to a columnar shape and may be a forward taper shape or a reverse taper shape. In addition, the partition wall may have a shape in which a width thereof increases or decreases stepwise from the support side toward the distal end. The forward tapered shape means a shape in which the width of the partition wall is continuously reduced from the support side toward the distal end; the reverse tapered shape means a shape in which the width of the partition wall is continuously increased from the support side toward the distal end; and the columnar shape means a shape in which the partition wall has substantially the same width on the support side and the distal end side.

A width W1 of the partition wall 11 is preferably 20 to 500 nm. The lower limit thereof is preferably 30 nm or more, more preferably 40 nm or more, and still more preferably 50 nm or more. The upper limit thereof is preferably 300 nm or less, more preferably 200 nm or less, and still more preferably 100 nm or less.

A thickness (height) H1 of the partition wall 11 is preferably 200 nm or more, more preferably 300 nm or more, and still more preferably 400 nm or more. The upper limit thereof is preferably 200% or less of the thickness of the pixel, more preferably 150% or less of the thickness of the pixel, and still more preferably substantially the same as the thickness of the pixel.

A height-to-width ratio (height/width) of the partition wall 11 is preferably 1 to 100, more preferably 5 to 50, and still more preferably 5 to 30.

In the present specification, the thickness of the partition wall means a length of the partition wall in a vertical direction, and the width of the partition wall means a length of the partition wall in a horizontal direction.

A pitch W3 of the partition wall 11 disposed on the support 10 is preferably 400 to 1200 nm. The lower limit of the pitch W3 is preferably 450 nm or more, and more preferably 500 nm or more. The upper limit of the pitch W3 is preferably 1000 nm or less, more preferably 900 nm or less, and still more preferably 800 nm or less. In the present specification, the pitch of the partition wall is the total value of the width W1 of the partition wall and a width W2 of a partition wall opening portion 12 (distance between facing surfaces of the partition walls arranged to face each other).

A width W2 of the partition wall opening portion 12 is preferably 300 to 1100 nm. The lower limit is preferably 400 nm or more and more preferably 450 nm or more. The upper limit is preferably 1000 nm or less and more preferably 900 nm or less. The width W2 of the partition wall opening portion 12 corresponds to the width of the pixel formed between the partition walls. In a case where the width W2 of the partition wall opening portion 12 is within the above-described range, it is possible to achieve miniaturization and higher resolution of the solid-state imaging element.

A material for the partition wall 11 is not particularly limited. Examples thereof include an organic material such as a siloxane resin and a fluororesin, and inorganic particles such as silica particles and magnesium fluoride. From the reason that it is possible to increase strength of the partition wall, the partition wall 11 preferably includes silica particles.

The partition wall 11 can be formed by using a known method in the related art. For example, the partition wall can be formed as follows.

First, a partition wall material layer is formed on the support. The partition wall material layer can be formed, for example, by applying a composition (composition for forming a partition wall) including inorganic particles such as silica particles to the support, and then curing the composition. Examples of such a composition include compositions described in paragraph Nos. 0012 to 0077 and 0093 to 0105 of WO2019/017280A and compositions described in paragraph Nos. 0089 to 0091 of WO2019/111748A, the contents of which are incorporated herein by reference.

The partition wall material layer can also be formed by forming a film formed of an inorganic material such as silicon dioxide on the support by a vapor deposition method such as a chemical vapor deposition (CVD) and a vacuum vapor deposition, or a method such as sputtering.

Next, using a mask having a pattern which follows the shape of the partition wall, a resist pattern is formed on the partition wall material layer.

Next, using the resist pattern as a mask, the partition wall material layer is etched to form a pattern. Examples of the etching method include a dry etching method and a wet etching method. Etching by the dry etching method can be performed under conditions described in paragraph Nos. 0128 to 0133 of JP2016-014856A. Next, the resist pattern is peeled off from the partition wall material layer. In this way, the partition wall can be formed.

Although not shown, an undercoat layer may be provided on the surfaces of the partition wall 11 and the support 10. By providing the undercoat layer, the adhesiveness between the pixel and the partition wall can be improved. Furthermore, it is possible to suppress diffusion of the components in the pixel into the partition wall and to increase the strength of the partition wall. As a material for the undercoat layer, various inorganic materials and organic materials can be used. Examples of the organic material include acrylic resin, polystyrene resin, polyimide resin, and organic spin on glass (SOG) resin. In addition, the undercoat layer can also be formed of a composition containing a compound having an ethylenically unsaturated bond-containing group. In addition, the undercoat layer can also be formed of an organic silane compound such as 1,1,1,3,3,3-hexamethyldisilazane. Examples of the ethylenically unsaturated bond-containing group include a vinyl group, a (meth)allyl group, a (meth)acryloyl group, and a styryl group, and a (meth)allyl group or a (meth)acryloyl group is preferable. The compound having an ethylenically unsaturated bond-containing group may be either a monomer or a resin such as a polymer. Examples of the inorganic material include silicon dioxide and aluminum oxide. The undercoat layer can be formed by a known method in the related art. In a case of forming the undercoat layer composed of an organic material, for example, the undercoat layer can be formed by applying a composition containing an organic material (composition for an undercoat layer) onto the partition wall and drying the composition. In a case of forming the undercoat layer composed of an inorganic material, for example, the undercoat layer can be formed by forming a film of the inorganic material constituting the undercoat layer on the surface of the partition wall by a vapor deposition method such as chemical vapor deposition (CVD) and vacuum evaporation, or a method such as sputtering.

In the formation of the composition layer, a known method can be used as a method of applying the photosensitive composition. Examples thereof include a dropping method (drop casting); a slit coating method; a spray method; a roll coating method; a spin coating method (spin coating); a cast coating method; a slit and spin method; a pre-wet method (for example, a method described in JP2009-145395A), various printing methods such as an ink jet (for example, on-demand type, piezo type, thermal type), a discharge printing such as nozzle jet, a flexo printing, a screen printing, a gravure printing, a reverse offset printing, and a metal mask printing; a transfer method using molds and the like; and a nanoimprinting method. In addition, the method of applying the composition described in paragraph No. 0207 of WO2022/085485A can also be used.

The composition layer formed on the support may be dried (pre-baked). In a case of producing a film by a low-temperature process, the pre-baking may not be performed. In a case of performing the pre-baking, the pre-baking temperature is preferably 150°C or lower, more preferably 120°C or lower, and still more preferably 110°C or lower. A lower limit thereof may be set to, for example, 50°C or higher, or to 80°C or higher. The pre-baking time is preferably 10 to 300 seconds, more preferably 40 to 250 seconds, and still more preferably 80 to 220 seconds. Pre-baking can be performed using a hot plate, an oven, or the like.

Next, the composition layer is exposed in a patterned manner (exposure step). For example, the composition layer can be patternwise exposed using a stepper exposure machine or a scanner exposure machine through a mask having a predetermined mask pattern. Thus, the exposed portion can be cured.

Examples of the radiation (light) which can be used during the exposure include g-rays and i-rays. In addition, light having a wavelength of 150 to 300 nm can also be used. Examples of the light having a wavelength of 150 to 300 nm include KrF ray (wavelength: 248 nm) and ArF ray (wavelength: 193 nm), and KrF ray (wavelength: 248 nm) is preferable. The light having a wavelength of 150 to 300 nm is preferably excimer laser light having a wavelength of 150 to 300 nm. In addition, a long-wave light source of 300 nm or more can also be used for the exposure.

In the exposure step, it is preferable to irradiate the composition layer with light having a wavelength of 150 to 300 nm (preferably, excimer laser light having a wavelength of 150 to 300 nm) to expose the composition layer in a patterned manner.

During exposure, the exposure may be performed by continuous irradiation with light or may be performed by pulsed irradiation (pulse exposure). The pulse exposure refers to an exposing method in which exposing is performed by repeated light irradiation and resting in a short cycle (for example, millisecond-level or less).

An irradiation amount (exposure amount) is, for example, preferably 0.03 to 2.5 J/cm² and more preferably 0.05 to 1.0 J/cm². The oxygen concentration during the exposure can be appropriately selected, and the exposure may also be performed, for example, in a low-oxygen atmosphere having an oxygen concentration of 19% by volume or less (for example, 15% by volume, 5% by volume, and substantially oxygen-free) or in a high-oxygen atmosphere having an oxygen concentration of more than 21% by volume (for example, 22% by volume, 30% by volume, and 50% by volume), in addition to an atmospheric air. In addition, the exposure illuminance can be appropriately set, and can be usually selected from a range of 1,000 W/m² to 100,000 W/m² (for example, 5,000 W/m², 15,000 W/m², or 35,000 W/m²). Appropriate conditions of each of the oxygen concentration and the exposure illuminance may be combined, and for example, a combination of the oxygen concentration of 10% by volume and the illuminance of 10,000 W/m², a combination of the oxygen concentration of 35% by volume and the illuminance of 20,000 W/m², or the like is available.

Next, the non-exposed portion of the composition layer is removed by development to form a pattern (pixel). Removal of the non-exposed portion of the composition layer can be performed by development using a developer. As a result, the composition layer of the non-exposed portion in the exposure step is eluted into the developer, and only a photocured portion remains. The temperature of the developer is preferably, for example, 20°C to 30°C. The development time is preferably 20 to 180 seconds. In addition, in order to further improve residues removing properties, a step of shaking the developer off per 60 seconds and supplying a new developer may be repeated multiple times.

Examples of the developer include an organic solvent and an alkali developer, and an alkali developer is preferably used. As the developer and the cleaning (rinsing) method after the development, the developer and the cleaning method described in paragraph No. 0214 of WO2022/085485A can be used.

After the development, it is preferable to carry out an additional exposure treatment or a heating treatment (post-baking) after carrying out drying. The additional exposure treatment or the post-baking is a curing treatment after development in order to complete curing. A heating temperature in the post-baking is, for example, preferably 100°C to 300°C and more preferably 200°C to 270°C. The film after development is post-baked continuously or batchwise using a heating unit such as a hot plate, a convection oven (hot air circulation dryer), and a high-frequency heater under the above-described conditions. In a case of performing the additional exposure treatment, light used for the exposure is preferably light having a wavelength of 400 nm or less. In addition, the additional exposure treatment may be carried out by the method described in KR10-2017-0122130A.

### <Solid-state imaging element>

A solid-state imaging element according to an embodiment of the present invention has the film according to the embodiment of the present invention. The configuration of the solid-state imaging element is not particularly limited as long as the solid-state imaging element is configured to include the film according to the embodiment of the present invention and functions as a solid-state imaging element. Examples of the configuration include the following configurations.

The solid-state imaging element is configured to have a plurality of photodiodes constituting a light receiving area of the solid-state imaging element (a charge coupled device (CCD) image sensor, a complementary metal-oxide semiconductor (CMOS) image sensor, or the like), and a transfer electrode formed of polysilicon or the like on a substrate; have a light shielding film having openings only over the light receiving section of the photodiodes on the photodiodes and the transfer electrodes; have a device-protective film formed of silicon nitride or the like, which is formed to coat the entire surface of the light shielding film and the light receiving section of the photodiodes, on the light shielding film; and have a color filter on the device-protective film. Furthermore, the solid-state imaging element may also be configured, for example, such that it has a light collecting unit (for example, a microlens, which is the same hereinafter) on a device-protective film under a color filter (a side closer to the substrate), or has a light collecting unit on a color filter. In addition, the color filter may have a structure in which each colored pixel is embedded in a space partitioned in, for example, a lattice form by a partition wall. In this case, it is preferable that the partition wall has a lower refractive index than each colored pixel. Examples of an imaging device having such a structure include the devices described in JP2012-227478A, JP2014-179577A, and WO2018/043654A. In addition, as described in JP2019-211559A, an ultraviolet absorbing layer may be provided in the structure of the solid-state imaging element to improve light resistance. An imaging device including the solid-state imaging element according to the embodiment of the present invention can also be used as a vehicle camera or a surveillance camera, in addition to a digital camera or electronic apparatus (mobile phones or the like) having an imaging function.

### <Image display device>

The image display device according to an embodiment of the present invention has the film according to the embodiment of the present invention. Examples of the image display device include a liquid crystal display device or an organic electroluminescent display device. The definitions of image display devices or the details of the respective image display devices are described in, for example, "Electronic Display Device (Akio Sasaki, Kogyo Chosakai Publishing Co., Ltd., published in 1990)", "Display Device (Sumiaki Ibuki, Sangyo Tosho Co., Ltd.)", and the like. In addition, the liquid crystal display device is described in, for example, "Liquid Crystal Display Technology for Next Generation (edited by Tatsuo Uchida, Kogyo Chosakai Publishing Co., Ltd., published in 1994)". The liquid crystal display device to which the present invention can be applied is not particularly limited, and can be applied to, for example, liquid crystal display devices employing various systems described in the "Liquid Crystal Display Technology for Next Generation".

### Examples

Hereinafter, the present invention will be described more specifically with reference to examples. Materials, using amounts, proportions, treatment details, treatment procedures, and the like shown in the following examples can be appropriately changed without departing from the gist of the present invention. Accordingly, the scope of the present invention is not limited to the following specific examples. In the structural formulae shown below, Et represents an ethyl group, and iPr represents an isopropyl group.

### <Production of dispersion liquid>

A mixed solution obtained by mixing the materials shown in the following table was mixed and dispersed for 3 hours using a beads mill (using zirconia beads having a diameter of 0.1 mm), and then subjected to a dispersion treatment at a pressure of 2,000 MPa and a flow rate of 500 g/min using a high-pressure disperser NANO-3000-10 (manufactured by Nippon BEE Chemical Co., Ltd.) equipped with a decompression mechanism. The dispersion treatment was repeated 10 times to obtain each dispersion liquid.

**[Table 1]**

| | Coloring material | | | | | | | | | | Dispersant | | Solvent | | | |
|---|---|---|---|---|---|---|---|---|---|---|---|---|---|---|---|---|
| | Pigment or dye | | | | | | Pigment derivative | | | | | | | | | |
| | Type | Part by mass | Type | Part by mass | Type | Part by mass | Type | Part by mass | Type | Part by mass | Type | Part by mass | Type | Part by mass | Type | Part by mass |
| Dispersion liquid G-1 | PG36 | 6.0 | PY150 | 4.8 | - | - | Syn-1 | 1.2 | - | - | B-1 | 14.0 | S-1 | 74.0 | - | - |
| Dispersion liquid G-2 | PG36 | 6.0 | PY150 | 4.8 | - | - | Syn-2 | 1.2 | - | - | B-2 | 14.0 | S-1 | 74.0 | - | - |
| Dispersion liquid G-3 | PG36 | 7.2 | PY150 | 2.4 | PY185 | 1.2 | Syn-1 | 1.2 | - | - | B-1 | 14.0 | S-1 | 74.0 | - | - |
| Dispersion liquid G-4 | PG36 | 7.2 | PY150 | 2.4 | PY185 | 1.2 | Syn-2 | 1.2 | - | - | B-2 | 14.0 | S-1 | 74.0 | | - |
| Dispersion liquid G-5 | PG58 | 6.0 | PV185 | 4.8 | - | - | Syn-1 | 1.2 | - | - | B-1 | 14.0 | S-1 | 74.0 | - | - |
| Dispersion liquid G-6 | PG58 | 6.0 | PY185 | 4.8 | - | - | Syn-2 | 1.2 | - | - | B-2 | 14.0 | S-1 | 74.0 | - | - |
| Dispersion liquid G-7 | PG58 | 7.2 | PY150 | 2.4 | PY185 | 1.2 | Syn-1 | 1.2 | - | - | B-1 | 14.0 | S-1 | 74.0 | | |
| Dispersion liquid G-8 | PG58 | 7.2 | PY150 | 2.4 | PY185 | 1.2 | Syn-2 | 1.2 | - | - | B-2 | 14.0 | S-1 | 74.0 | - | - |
| Dispersion liquid G-9 | PG36 | 6.0 | PY139 | 4.8 | - | - | Syn-1 | 1.2 | - | - | B-1 | 14.0 | S-1 | 74.0 | - | - |
| Dispersion liquid G-10 | PG36 | 6.0 | PY185 | 4.8 | - | - | Syn-1 | 1.2 | - | - | B-1 | 14.0 | S-1 | 74.0 | - | - |
| Dispersion liquid G-11 | PG7 | 3.0 | PG36 | 6.4 | PY139 | 1.4 | Syn-1 | 1.2 | - | - | B-1 | 14.0 | S-1 | 74.0 | - | - |
| Dispersion liquid R-1 | PR254 | 7.2 | PY139 | 3.6 | - | - | Syn-1 | 1.2 | - | - | B-3 | 14.0 | S-1 | 60.0 | S-2 | 14.0 |
| Dispersion liquid R-2 | PR254 | 3.6 | PR272 | 3.6 | PY139 | 3.6 | Syn-1 | 1.2 | - | - | B-3 | 14.0 | S-1 | 60.0 | S-2 | 14.0 |
| Dispersion liquid R-3 | PR254 | 7.2 | PY139 | 3.6 | - | - | Syn-1 | 1.2 | - | - | B-4 | 14.0 | S-1 | 60.0 | S-2 | 14.0 |
| Dispersion liquid R-4 | PR254 | 3.6 | PR272 | 3.6 | PY139 | 3.6 | Syn-1 | 1.2 | - | - | B-4 | 14.0 | S-1 | 60.0 | S-2 | 14.0 |
| Dispersion liquid R-5 | PR254A | 0.9 | PY139A | 2.7 | PV2A | 7.2 | Syn-1 | 1.2 | - | - | B-1 | 14.0 | S-1 | 74.0 | - | - |
| Dispersion liquid R-6 | PR254A | 0.9 | PY139A | 2.7 | PV19A | 7.2 | Syn-1 | 1.2 | - | - | B-1 | 14.0 | S-1 | 74.0 | - | - |
| Dispersion liquid R-7 | PR254A | 0.9 | PY139A | 2.7 | PV23A | 7.2 | Syn-1 | 1.2 | - | - | B-1 | 14.0 | S-1 | 74.0 | - | - |
| Dispersion liquid R-8 | PR264 | 0.9 | PY139A | 2.7 | PV37 | 7.2 | Syn-1 | 1.2 | - | - | B-1 | 14.0 | S-1 | 74.0 | - | - |
| Dispersion liquid R-9 | PR264 | 0.9 | PY139A | 2.7 | PV19B | 7.2 | Syn-1 | 1.2 | - | - | B-1 | 14.0 | S-1 | 74.0 | - | - |
| Dispersion liquid R-10 | PR264 | 0.9 | PY139A | 2.7 | PV23A | 7.2 | Syn-1 | 1.2 | - | - | B-1 | 14.0 | S-1 | 74.0 | - | - |
| Dispersion liquid B-1 | PB15:6 | 8.7 | PV23 | 0.5 | Dye-1 | 1.6 | Syn-3 | 1.2 | - | - | B-3 | 14.0 | S-1 | 60.0 | S-3 | 14.0 |
| Dispersion liquid B-2 | PB15:6 | 9.0 | PV23 | 1.8 | - | - | Syn-3 | 1.2 | - | - | B-3 | 14.0 | S-1 | 60.0 | S-3 | 14.0 |
| Dispersion liquid B-3 | PB15:6 | 9.0 | PV23 | 1.8 | - | - | Syn-3 | 1.0 | Syn-4 | 0.2 | B-3 | 14.0 | S-1 | 60.0 | S-3 | 14.0 |
| Dispersion liquid B-4 | PB15:6 | 9.0 | PV23 | 1.8 | - | - | Syn-3 | 1.0 | Syn-4 | 0.2 | B-4 | 14.0 | S-1 | 60.0 | S-3 | 14.0 |
| Dispersion liquid B-5 | PB15:4 | 9.0 | PV23 | 1.8 | - | - | Syn-3 | 1.0 | Syn-4 | 0.2 | B-1 | 14.0 | S-1 | 60.0 | S-3 | 14.0 |
| Dispersion liquid B-6 | PB15:6 | 9.0 | PV2 | 1.8 | - | - | Syn-3 | 1.0 | Syn-4 | 0.2 | B-1 | 14.0 | S-1 | 60.0 | S-3 | 14.0 |
| Dispersion liquid B-7 | PB15:6 | 9.0 | PV19 | 1.8 | - | - | Syn-3 | 1.0 | Syn-4 | 0.2 | B-1 | 14.0 | S-1 | 60.0 | S-3 | 14.0 |
| Dispersion liquid CG-1 | PG58 | 6.0 | PY185 | 4.8 | - | - | Syn-1 | 1.2 | - | - | CB-1 | 14.0 | S-1 | 74.0 | - | - |

Details of the materials indicated by the abbreviations in the above table are as follows.

### (Pigment)

PG7: C. I. Pigment Green 7 (phthalocyanine compound, green pigment)
PG36: C. I. Pigment Green 36 (Heliogen Green L 9362, manufactured by Sun Chemical Corporation, phthalocyanine compound, green pigment)
PG58: C. I. Pigment Green 58 (phthalocyanine compound, green pigment)
PY139: C. I. Pigment Yellow 139 (isoindoline compound, yellow pigment)
PY139A: C. I. Pigment Yellow 139 (Paliotol Yellow L 2140 HD, manufactured by Sun Chemical Corporation, isoindoline compound, yellow pigment)
PY150: C. I. Pigment Yellow 150 (azo compound, yellow pigment)
PY185: C. I. Pigment Yellow 185 (Paliotol Yellow L 1155, manufactured by Sun Chemical Corporation, isoindoline compound, yellow pigment)
PR254: C. I. Pigment Red 254 (diketopyrrolopyrrole compound, red pigment)
PR254A: C. I. Pigment Red 254 (Irgazin Red K 3842, manufactured by Sun Chemical Corporation, diketopyrrolopyrrole compound, red pigment)
PR264: C. I. Pigment Red 264 (Irgazin Rubine K 4082, manufactured by Sun Chemical Corporation, diketopyrrolopyrrole compound, red pigment)
PR272: C. I. Pigment Red 272 (diketopyrrolopyrrole compound, red pigment)
PB15:4: C. I. Pigment Blue 15:4 (phthalocyanine compound, blue pigment)
PB15:6: C. I. Pigment Blue 15:6 (Heliogen Blue D 6700 T, manufactured by Sun Chemical Corporation, phthalocyanine compound, blue pigment)
PV2: C. I. Pigment Violet 2 (violet pigment)
PV2A: C. I. Pigment Violet 2 (Fanal Violet D 5460, manufactured by Sun Chemical Corporation, violet pigment)
PV19: C. I. Pigment Violet 19 (violet pigment)
PV19A: C. I. Pigment Violet 19 (Cinquasia Violet K5350, manufactured by Sun Chemical Corporation, violet pigment)
PV19B: C. I. Pigment Violet 19 (Fastogen Super Red 7100Y, manufactured by Sun Chemical Corporation, violet pigment)
PV23: C. I. Pigment Violet 23 (dioxazine compound, violet pigment)
PV23A: C. I. Pigment Violet 23 (Pigmosol AGRO Violet 5890, manufactured by Sun Chemical Corporation, dioxazine compound, violet pigment)
PV37: C. I. Pigment Violet 37 (Cromophtal Violet K 5700, manufactured by Sun Chemical Corporation, violet pigment)

### (Dye)

Dye-1: dye having the following structure (xanthene compound, violet dye)

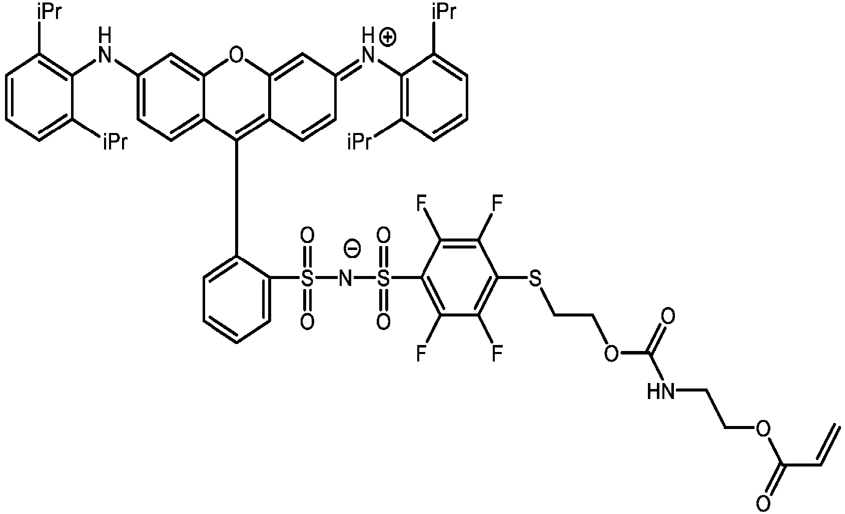

### (Pigment Derivative)

Syn-1: compound having the following structure 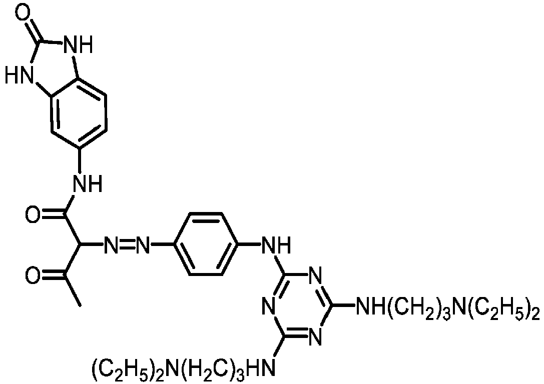
Syn-2: compound having the following structure 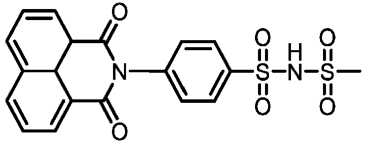
Syn-3: compound having the following structure 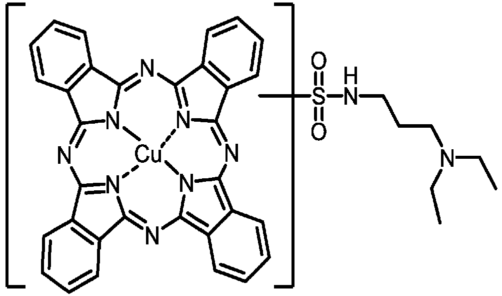
Syn-4: compound having the following structure

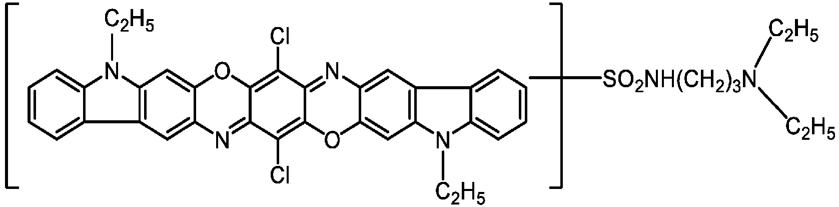

### (Dispersant)

B-1: 30% by mass propylene glycol monomethyl ether acetate (PGMEA) solution of a resin having the following structure (the numerical value appended to the main chain indicates the molar ratio of the constitutional unit, and the numerical value appended to the side chain indicates the number of the constitutional units; weight-average molecular weight: 20,000; acid value: 48.7 mgKOH/g)

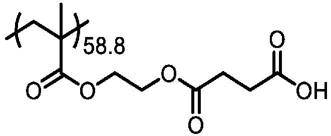

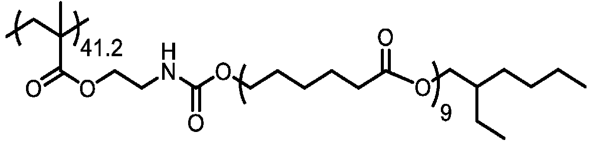

B-2: 30% by mass PGMEA solution of a polymer obtained by reacting 5 parts by mass of a compound b-1, 5 parts by mass of a compound b-2, and 90 parts by mass of a compound b-3 (acid value: 28 mgKOH/g; amine value: 72.4 mgKOH/g; weight-average molecular weight: 5,000)

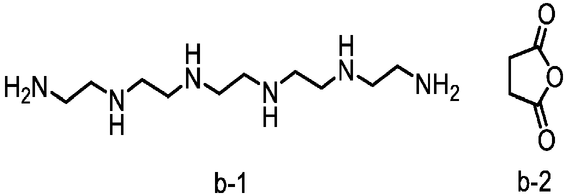

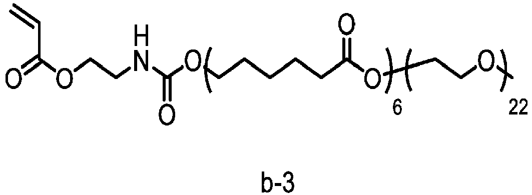

The resin B-2 has the following structure.

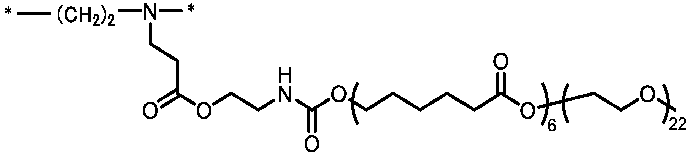

B-3: 30% by mass PGMEA solution of a resin having the following structure (the numerical value appended to the main chain indicates the molar ratio of the constitutional unit, and the numerical value appended to the side chain indicates the number of the constitutional units; weight-average molecular weight: 20,000; acid value: 70.1 mgKOH/g)

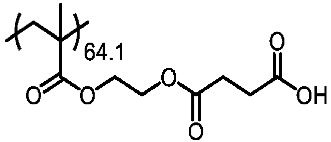

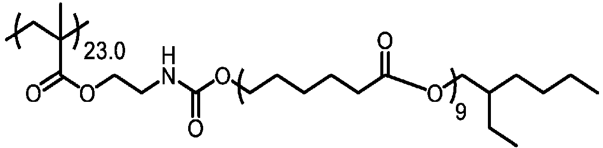

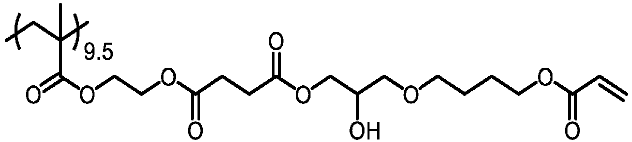

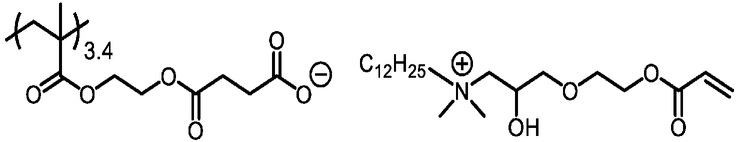

B-4: 30% by mass PGMEA solution of PLYSURF A212C (manufactured by DKS Co., Ltd.; acid value: 100 to 120 mgKOH/g)
CB-1: 30% by mass PGMEA solution of a resin having the following structure (weight-average molecular weight: 10,000)

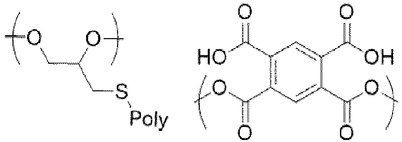

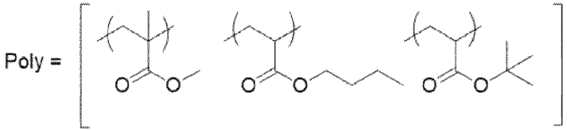

### (Solvent)

S-1: Propylene glycol monomethyl ether acetate (PGMEA)
S-2: cyclopentanone
S-3: cyclohexanone

### <Production of photosensitive composition>

The materials shown in the following tables were mixed with each other in the parts by mass shown in the following tables, stirred, and then filtered through a nylon filter (manufactured by Nihon Pall Corporation) having a pore diameter of 0.45 µm to produce a photosensitive composition. In the following tables, the value of the content of the specific compound in the photosensitive composition is described in the column of "Concentration of specific compound (% by mass)", and the value of the content of the coloring material (the total content of the pigment, the dye, and the pigment derivative) in the total solid content of the photosensitive composition is described in the column of "Concentration of coloring material (% by mass)". The total solid content of the photosensitive composition is the total mass of the components excluding the solvent.

**[Table 2]**

| | Dispersion liquid | | Binder resin | | Polymerizable monomer | | | |
|---|---|---|---|---|---|---|---|---|
| | Type | Part by mass | Type | Part by mass | Type | Part by mass | Type | Part by mass |
| Example 1 | Dispersion liquid R-2 | 65.1 | C-3 | 2.5 | M-1 | 0.9 | - | - |
| Example 2 | Dispersion liquid R-2 | 65.1 | C-3 | 2.5 | M-1 | 0.9 | - | - |
| Example 3 | Dispersion liquid R-2 | 65.1 | C-3 | 2.5 | M-1 | 0.9 | - | - |
| Example 4 | Dispersion liquid R-2 | 65.1 | C-3 | 2.5 | M-1 | 0.9 | - | - |
| Example 5 | Dispersion liquid R-2 | 65.1 | C-3 | 2.5 | M-1 | 0.9 | - | - |
| Example 6 | Dispersion liquid R-2 | 65.1 | C-3 | 2.5 | M-1 | 0.9 | - | - |
| Example 7 | Dispersion liquid R-2 | 65.1 | C-3 | 2.5 | M-1 | 0.9 | - | - |
| Example 8 | Dispersion liquid R-2 | 65.1 | C-3 | 2.5 | M-1 | 0.9 | - | - |
| Example 9 | Dispersion liquid R-2 | 65.1 | C-3 | 2.5 | M-1 | 0.9 | - | - |
| Example 10 | Dispersion liquid R-2 | 65.1 | C-3 | 2.5 | M-1 | 0.9 | - | - |
| Example 11 | Dispersion liquid R-2 | 65.1 | C-3 | 2.5 | M-1 | 0.9 | - | - |
| Example 12 | Dispersion liquid R-2 | 65.1 | C-3 | 2.5 | M-1 | 0.9 | - | - |
| Example 13 | Dispersion liquid R-2 | 65.1 | C-1 | 2.5 | M-1 | 0.9 | - | - |
| Example 14 | Dispersion liquid R-2 | 65.1 | C-3 | 2.5 | M-2 | 0.9 | - | - |
| Example 15 | Dispersion liquid R-2 | 65.1 | C-3 | 2.5 | M-3 | 0.9 | - | - |
| Example 16 | Dispersion liquid R-2 | 65.1 | C-3 | 2.5 | M-1 | 0.9 | - | - |
| Example 17 | Dispersion liquid R-5 | 60.0 | C-1 | 5.7 | M-1 | 0.7 | - | - |
| Example 18 | Dispersion liquid R-6 | 60.0 | C-1 | 5.7 | M-1 | 0.7 | - | - |
| Example 19 | Dispersion liquid R-7 | 60.0 | C-1 | 5.7 | M-1 | 0.7 | - | - |
| Example 20 | Dispersion liquid R-8 | 60.0 | C-1 | 5.7 | M-1 | 0.7 | - | - |
| Example 21 | Dispersion liquid R-9 | 60.0 | C-1 | 5.7 | M-1 | 0.7 | - | - |
| Example 22 | Dispersion liquid R-10 | 60.0 | C-1 | 5.7 | M-1 | 0.7 | - | - |
| Example 23 | Dispersion liquid B-1 | 63.0 | C-2 | 1.0 | M-1 | 1.0 | M-4 | 0.4 |
| Example 24 | Dispersion liquid B-1 | 63.0 | C-2 | 1.0 | M-1 | 1.0 | M-4 | 0.4 |
| Example 25 | Dispersion liquid B-1 | 63.0 | C-2 | 1.0 | M-1 | 1.0 | M-4 | 0.4 |
| Example 26 | Dispersion liquid B-1 | 63.0 | C-2 | 1.0 | M-1 | 1.0 | M-4 | 0.4 |
| Example 27 | Dispersion liquid B-1 | 63.0 | C-2 | 1.0 | M-1 | 1.0 | M-4 | 0.4 |
| Example 28 | Dispersion liquid B-1 | 63.0 | C-2 | 1.0 | M-1 | 1.0 | M-4 | 0.4 |
| Example 29 | Dispersion liquid B-1 | 63.0 | C-2 | 1.0 | M-1 | 1.0 | M-4 | 0.4 |
| Example 30 | Dispersion liquid B-1 | 63.0 | C-2 | 1.0 | M-1 | 1.0 | M-4 | 0.4 |
| Example 31 | Dispersion liquid B-1 | 63.0 | C-2 | 1.0 | M-1 | 1.0 | M-4 | 0.4 |
| Example 32 | Dispersion liquid B-1 | 63.0 | C-2 | 1.0 | M-1 | 1.0 | M-4 | 0.4 |
| Example 33 | Dispersion liquid B-1 | 63.0 | C-2 | 1.0 | M-1 | 1.0 | M-4 | 0.4 |
| Example 34 | Dispersion liquid B-1 | 63.0 | C-2 | 1.0 | M-1 | 1.0 | M-4 | 0.4 |
| Example 35 | Dispersion liquid B-1 | 63.0 | C-2 | 1.0 | M-1 | 1.0 | M-4 | 0.4 |
| Example 36 | Dispersion liquid B-1 | 63.0 | C-2 | 1.0 | M-1 | 1.0 | M-4 | 0.4 |
| Example 37 | Dispersion liquid B-1 | 63.0 | C-2 | 1.0 | M-1 | 1.0 | M-4 | 0.4 |
| Example 38 | Dispersion liquid B-1 | 63.0 | C-2 | 1.0 | M-1 | 1.0 | M-4 | 0.4 |
| Example 39 | Dispersion liquid G-1 | 67.7 | C-3 | 0.2 | M-1 | 1.1 | - | - |
| Example 40 | Dispersion liquid G-1 | 67.7 | C-3 | 0.2 | M-1 | 1.1 | - | - |

**[Table 3]**

| | Photopolymerization initiator | | Polymerization inhibitor | | Additive | | | | Specific compound | |
|---|---|---|---|---|---|---|---|---|---|---|
| | Type | Part by mass | Type | Part by mass | Type | Part by mass | Type | Part by mass | Type | Part by mass |
| Example 1 | I-1 | 0.3 | In-1 | 0.0004 | - | - | - | - | P-1 | 0.5 |
| Example 2 | I-1 | 0.3 | In-1 | 0.0004 | - | - | - | - | P-2 | 0.5 |
| Example 3 | I-1 | 0.3 | In-1 | 0.0004 | - | - | - | - | P-3 | 0.5 |
| Example 4 | I-1 | 0.3 | In-1 | 0.0004 | - | - | - | - | P-4 | 0.5 |
| Example 5 | I-1 | 0.3 | In-1 | 0.0004 | - | - | - | - | P-5 | 0.5 |
| Example 6 | I-1 | 0.3 | In-1 | 0.0004 | - | - | - | - | P-6 | 0.5 |
| Example 7 | I-1 | 0.3 | In-1 | 0.0004 | - | - | - | - | P-7 | 0.5 |
| Example 8 | I-1 | 0.3 | In-1 | 0.0004 | - | - | - | - | P-8 | 0.5 |
| Example 9 | I-1 | 0.3 | In-1 | 0.0004 | - | - | - | - | P-9 | 0.5 |
| Example 10 | I-1 | 0.3 | In-1 | 0.0004 | - | - | - | - | P-10 | 0.5 |
| Example 11 | I-1 | 0.3 | In-1 | 0.0004 | - | - | - | - | P-2 | 0.3 |
| Example 12 | I-1 | 0.3 | In-1 | 0.0004 | - | - | - | - | P-2 | 0.1 |
| Example 13 | I-1 | 0.3 | In-1 | 0.0004 | - | - | - | - | P-2 | 0.5 |
| Example 14 | I-1 | 0.3 | In-1 | 0.0004 | - | - | - | - | P-2 | 0.5 |
| Example 15 | I-1 | 0.3 | In-1 | 0.0004 | - | - | - | - | P-2 | 0.5 |
| Example 16 | I-2 | 0.3 | In-1 | 0.0004 | - | - | - | - | P-2 | 0.5 |
| Example 17 | I-3 | 0.3 | In-1 | 0.0004 | A-5 | 0.1 | - | - | P-2 | 0.5 |
| Example 18 | I-3 | 0.3 | In-1 | 0.0004 | A-5 | 0.1 | - | - | P-2 | 0.5 |
| Example 19 | I-3 | 0.3 | In-1 | 0.0004 | A-5 | 0.1 | - | - | P-2 | 0.5 |
| Example 20 | I-3 | 0.3 | In-1 | 0.0004 | A-5 | 0.1 | - | - | P-2 | 0.5 |
| Example 21 | I-3 | 0.3 | In-1 | 0.0004 | A-5 | 0.1 | - | - | P-2 | 0.5 |
| Example 22 | I-3 | 0.3 | In-1 | 0.0004 | A-5 | 0.1 | - | - | P-2 | 0.5 |
| Example 23 | I-1 | 0.3 | In-1 | 0.0004 | A-1 | 0.3 | A-3 | 0.1 | P-1 | 0.5 |
| Example 24 | I-1 | 0.3 | In-1 | 0.0004 | A-1 | 0.3 | A-3 | 0.1 | P-2 | 0.5 |
| Example 25 | I-1 | 0.3 | In-1 | 0.0004 | A-1 | 0.3 | A-3 | 0.1 | P-3 | 0.5 |
| Example 26 | I-1 | 0.3 | In-1 | 0.0004 | A-1 | 0.3 | A-3 | 0.1 | P-4 | 0.5 |
| Example 27 | I-1 | 0.3 | In-1 | 0.0004 | A-1 | 0.3 | A-3 | 0.1 | P-5 | 0.5 |
| Example 28 | I-1 | 0.3 | In-1 | 0.0004 | A-1 | 0.3 | A-3 | 0.1 | P-6 | 0.5 |
| Example 29 | I-1 | 0.3 | In-1 | 0.0004 | A-1 | 0.3 | A-3 | 0.1 | P-7 | 0.5 |
| Example 30 | I-1 | 0.3 | In-1 | 0.0004 | A-1 | 0.3 | A-3 | 0.1 | P-8 | 0.5 |
| Example 31 | I-1 | 0.3 | In-1 | 0.0004 | A-1 | 0.3 | A-3 | 0.1 | P-9 | 0.5 |
| Example 32 | I-1 | 0.3 | In-1 | 0.0004 | A-1 | 0.3 | A-3 | 0.1 | P-10 | 0.5 |
| Example 33 | I-1 | 0.3 | In-1 | 0.0004 | A-1 | 0.3 | A-3 | 0.1 | P-2 | 0.3 |
| Example 34 | I-1 | 0.3 | In-1 | 0.0004 | A-1 | 0.3 | A-2 | 0.1 | P-2 | 0.1 |
| Example 35 | I-1 | 0.3 | In-1 | 0.0004 | A-1 | 0.3 | A-6 | 0.1 | P-2 | 0.5 |
| Example 36 | I-1 | 0.3 | In-1 | 0.0004 | A-1 | 0.3 | A-2 | 0.1 | P-2 | 0.5 |
| Example 37 | I-1 | 0.3 | In-1 | 0.0004 | A-1 | 0.3 | A-4 | 0.1 | P-2 | 0.5 |
| Example 38 | I-2 | 0.3 | In-1 | 0.0004 | A-1 | 0.3 | A-4 | 0.1 | P-2 | 0.5 |
| Example 39 | I-1 | 0.4 | In-1 | 0.0004 | - | - | - | - | P-1 | 0.5 |
| Example 40 | I-1 | 0.4 | In-1 | 0.0004 | - | - | - | - | P-2 | 0.5 |

**[Table 4]**

| | Surfactant | | Solvent | | | | Concentration of specific compound (% by mass) | Concentration of coloring material (% by mass) |
|---|---|---|---|---|---|---|---|---|
| | Type | Part by mass | Type | Part by mass | Type | Part by mass | | |
| Example 1 | W-1 | 0.02 | S-1 | 30.7 | - | - | 0.5 | 60.0 |
| Example 2 | W-1 | 0.02 | S-1 | 30.7 | - | - | 0.5 | 60.0 |
| Example 3 | W-1 | 0.02 | S-1 | 30.7 | - | - | 0.5 | 60.0 |
| Example 4 | W-1 | 0.02 | S-1 | 30.7 | - | - | 0.5 | 60.0 |
| Example 5 | W-1 | 0.02 | S-1 | 30.7 | - | - | 0.5 | 60.0 |
| Example 6 | W-1 | 0.02 | S-1 | 30.7 | - | - | 0.5 | 60.0 |
| Example 7 | W-1 | 0.02 | S-1 | 30.7 | - | - | 0.5 | 60.0 |
| Example 8 | W-1 | 0.02 | S-1 | 30.7 | - | - | 0.5 | 60.0 |
| Example 9 | W-1 | 0.02 | S-1 | 30.7 | - | - | 0.5 | 60.0 |
| Example 10 | W-1 | 0.02 | S-1 | 30.7 | - | - | 0.5 | 60.0 |
| Example 11 | W-1 | 0.02 | S-1 | 30.9 | - | - | 0.3 | 61.0 |
| Example 12 | W-1 | 0.02 | S-1 | 31.1 | - | - | 0.1 | 61.9 |
| Example 13 | W-1 | 0.02 | S-1 | 30.7 | - | - | 0.5 | 60.0 |
| Example 14 | W-1 | 0.02 | S-1 | 30.7 | - | - | 0.5 | 60.0 |
| Example 15 | W-1 | 0.02 | S-1 | 30.7 | - | - | 0.5 | 60.0 |
| Example 16 | W-1 | 0.02 | S-1 | 30.7 | - | - | 0.5 | 60.0 |
| Example 17 | W-1 | 0.01 | S-1 | 32.7 | - | - | 0.5 | 55.2 |
| Example 18 | W-1 | 0.01 | S-1 | 32.7 | - | - | 0.5 | 55.2 |
| Example 19 | W-1 | 0.01 | S-1 | 32.7 | - | - | 0.5 | 55.2 |
| Example 20 | W-1 | 0.01 | S-1 | 32.7 | - | - | 0.5 | 55.2 |
| Example 21 | W-1 | 0.01 | S-1 | 32.7 | - | - | 0.5 | 55.2 |
| Example 22 | W-1 | 0.01 | S-1 | 32.7 | - | - | 0.5 | 55.2 |
| Example 23 | W-1 | 0.02 | S-1 | 15.0 | S-3 | 18.5 | 0.5 | 57.6 |
| Example 24 | W-1 | 0.02 | S-1 | 15.0 | S-3 | 18.5 | 0.5 | 57.6 |
| Example 25 | W-1 | 0.02 | S-1 | 15.0 | S-3 | 18.5 | 0.5 | 57.6 |
| Example 26 | W-1 | 0.02 | S-1 | 15.0 | S-3 | 18.5 | 0.5 | 57.6 |
| Example 27 | W-1 | 0.02 | S-1 | 15.0 | S-3 | 18.5 | 0.5 | 57.6 |
| Example 28 | W-1 | 0.02 | S-1 | 15.0 | S-3 | 18.5 | 0.5 | 57.6 |
| Example 29 | W-1 | 0.02 | S-1 | 15.0 | S-3 | 18.5 | 0.5 | 57.6 |
| Example 30 | W-1 | 0.02 | S-1 | 15.0 | S-3 | 18.5 | 0.5 | 57.6 |
| Example 31 | W-1 | 0.02 | S-1 | 15.0 | S-3 | 18.5 | 0.5 | 57.6 |
| Example 32 | W-1 | 0.02 | S-1 | 15.0 | S-3 | 18.5 | 0.5 | 57.6 |
| Example 33 | W-1 | 0.02 | S-1 | 15.2 | S-3 | 18.5 | 0.3 | 58.5 |
| Example 34 | W-1 | 0.02 | S-1 | 15.4 | S-3 | 18.5 | 0.1 | 59.4 |
| Example 35 | W-1 | 0.02 | S-1 | 15.0 | S-3 | 18.5 | 0.5 | 57.6 |
| Example 36 | W-1 | 0.02 | S-1 | 15.0 | S-3 | 18.5 | 0.5 | 57.6 |
| Example 37 | W-1 | 0.02 | S-1 | 15.0 | S-3 | 18.5 | 0.5 | 57.6 |
| Example 38 | W-1 | 0.02 | S-1 | 15.0 | S-3 | 18.5 | 0.5 | 57.6 |
| Example 39 | W-1 | 0.02 | S-1 | 30.1 | - | - | 0.5 | 62.3 |
| Example 40 | W-1 | 0.02 | S-1 | 30.1 | - | - | 0.5 | 62.3 |

**[Table 5]**

| | Dispersion liquid | | Binder resin | | Polymerizable monomer | | | |
|---|---|---|---|---|---|---|---|---|
| | Type | Part by mass | Type | Part by mass | Type | Part by mass | Type | Part by mass |
| Example 41 | Dispersion liquid G-1 | 67.7 | C-3 | 0.2 | M-1 | 1.1 | - | - |
| Example 42 | Dispersion liquid G-1 | 67.7 | C-3 | 0.2 | M-1 | 1.1 | - | - |
| Example 43 | Dispersion liquid G-1 | 67.7 | C-3 | 0.2 | M-1 | 1.1 | - | - |
| Example 44 | Dispersion liquid G-1 | 67.7 | C-3 | 0.2 | M-1 | 1.1 | - | - |
| Example 45 | Dispersion liquid G-1 | 67.7 | C-3 | 0.2 | M-1 | 1.1 | - | - |
| Example 46 | Dispersion liquid G-1 | 67.7 | C-3 | 0.2 | M-1 | 1.1 | - | - |
| Example 47 | Dispersion liquid G-1 | 67.7 | C-3 | 0.2 | M-1 | 1.1 | - | - |
| Example 48 | Dispersion liquid G-1 | 67.7 | C-3 | 0.2 | M-1 | 1.1 | - | - |
| Example 49 | Dispersion liquid G-1 | 67.7 | C-3 | 0.2 | M-1 | 1.1 | - | - |
| Example 50 | Dispersion liquid G-1 | 67.7 | C-3 | 0.2 | M-1 | 1.1 | - | - |
| Example 51 | Dispersion liquid G-1 | 67.7 | C-2 | 0.2 | M-1 | 1.1 | - | - |
| Example 52 | Dispersion liquid G-1 | 67.7 | C-3 | 0.2 | M-2 | 1.1 | - | - |
| Example 53 | Dispersion liquid G-1 | 67.7 | C-3 | 0.2 | M-3 | 1.1 | - | - |
| Example 54 | Dispersion liquid G-1 | 67.7 | C-3 | 0.2 | M-1 | 1.1 | - | - |
| Example 55 | Dispersion liquid CG-1 | 67.7 | CC-1 | 0.2 | CM-1 | 1.1 | - | - |
| Example 56 | Dispersion liquid R-2 | 65.1 | C-3 | 2.5 | M-1 | 0.9 | - | - |
| Example 57 | Dispersion liquid R-2 | 65.1 | C-3 | 2.5 | M-1 | 0.9 | - | - |
| Comparative Example 1 | Dispersion liquid CG-1 | 67.7 | CC-1 | 0.2 | CM-1 | 1.1 | - | - |

**[Table 6]**

| | Photopolymerization initiator | | Polymerization inhibitor | | Additive | | | | Specific compound | |
|---|---|---|---|---|---|---|---|---|---|---|
| | Type | Part by mass | Type | Part by mass | Type | Part by mass | Type | Part by mass | Type | Part by mass |
| Example 41 | I-1 | 0.4 | In-1 | 0.0004 | - | - | - | - | P-3 | 0.5 |
| Example 42 | I-1 | 0.4 | In-1 | 0.0004 | - | - | - | - | P-4 | 0.5 |
| Example 43 | I-1 | 0.4 | In-1 | 0.0004 | - | - | - | - | P-5 | 0.5 |
| Example 44 | I-1 | 0.4 | In-1 | 0.0004 | - | - | - | - | P-6 | 0.5 |
| Example 45 | I-1 | 0.4 | In-1 | 0.0004 | - | - | - | - | P-7 | 0.5 |
| Example 46 | I-1 | 0.4 | In-1 | 0.0004 | - | - | - | - | P-8 | 0.5 |
| Example 47 | I-1 | 0.4 | In-1 | 0.0004 | - | - | - | - | P-9 | 0.5 |
| Example 48 | I-1 | 0.4 | In-1 | 0.0004 | - | - | - | - | P-10 | 0.5 |
| Example 49 | I-1 | 0.4 | In-1 | 0.0004 | - | - | - | - | P-2 | 0.3 |
| Example 50 | I-1 | 0.4 | In-1 | 0.0004 | - | - | - | - | P-2 | 0.1 |
| Example 51 | I-1 | 0.4 | In-1 | 0.0004 | - | - | - | - | P-2 | 0.5 |
| Example 52 | I-1 | 0.4 | In-1 | 0.0004 | - | - | - | - | P-2 | 0.5 |
| Example 53 | I-1 | 0.4 | In-1 | 0.0004 | - | - | - | - | P-2 | 0.5 |
| Example 54 | I-2 | 0.4 | In-1 | 0.0004 | - | - | - | - | P-2 | 0.5 |
| Example 55 | CI-1 | 0.4 | In-1 | 0.0004 | - | - | - | - | P-2 | 0.5 |
| Example 56 | I-1 | 0.3 | In-1 | 0.0004 | - | - | - | - | P-11 | 0.5 |
| Example 57 | I-1 | 0.3 | In-1 | 0.0004 | - | - | - | - | P-12 | 0.5 |
| Comparative Example 1 | CI-1 | 0.4 | In-1 | 0.0004 | - | - | - | - | - | - |

**[Table 7]**

| | Surfactant | | Solvent | | | | Concentration of specific compound (% by mass) | Concentration of coloring material (% by mass) |
|---|---|---|---|---|---|---|---|---|
| | Type | Part by mass | Type | Part by mass | Type | Part by mass | | |
| Example 41 | W-1 | 0.02 | S-1 | 30.1 | - | - | 0.5 | 62.3 |
| Example 42 | W-1 | 0.02 | S-1 | 30.1 | - | - | 0.5 | 62.3 |
| Example 43 | W-1 | 0.02 | S-1 | 30.1 | - | - | 0.5 | 62.3 |
| Example 44 | W-1 | 0.02 | S-1 | 30.1 | - | - | 0.5 | 62.3 |
| Example 45 | W-1 | 0.02 | S-1 | 30.1 | - | - | 0.5 | 62.3 |
| Example 46 | W-1 | 0.02 | S-1 | 30.1 | - | - | 0.5 | 62.3 |
| Example 47 | W-1 | 0.02 | S-1 | 30.1 | - | - | 0.5 | 62.3 |
| Example 48 | W-1 | 0.02 | S-1 | 30.1 | - | - | 0.5 | 62.3 |
| Example 49 | W-1 | 0.02 | S-1 | 30.3 | - | - | 0.3 | 63.2 |
| Example 50 | W-1 | 0.02 | S-1 | 30.5 | - | - | 0.1 | 64.2 |
| Example 51 | W-1 | 0.02 | S-1 | 30.1 | - | - | 0.5 | 62.3 |
| Example 52 | W-1 | 0.02 | S-1 | 30.1 | - | - | 0.5 | 62.3 |
| Example 53 | W-1 | 0.02 | S-1 | 30.1 | - | - | 0.5 | 62.3 |
| Example 54 | W-1 | 0.02 | S-1 | 30.1 | - | - | 0.5 | 62.3 |
| Example 55 | W-1 | 0.02 | S-1 | 30.6 | - | - | 0.5 | 64.7 |
| Example 56 | W-1 | 0.02 | S-1 | 30.7 | - | - | 0.5 | 60.0 |
| Example 57 | W-1 | 0.02 | S-1 | 30.7 | - | - | 0.5 | 60.0 |
| Comparative Example 1 | W-1 | 0.02 | S-1 | 30.6 | - | - | 0.0 | 64.7 |

The details of the materials shown by the abbreviations in the tables showing the formulation of the above-described photosensitive composition are as follows.

### (Dispersion liquid)

Dispersion liquids R-2, R-5 to R-10, B-1, G-1, and CG-1: dispersion liquids R-2, R-5 to R-10, B-1, G-1, and CG-1 described above

### (Binder resin)

C-1: 30% by mass propylene glycol monomethyl ether acetate (PGMEA) solution of a resin having the following structure (the numerical value appended to the main chain indicates the molar ratio of the constitutional unit; weight-average molecular weight: 11,000; acid value: 69 mgKOH/g)

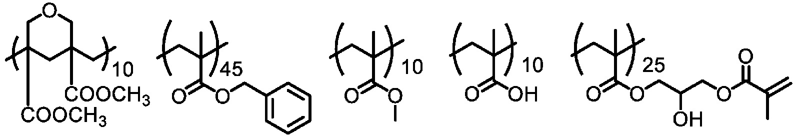

C-2: 30% by mass propylene glycol monomethyl ether acetate (PGMEA) solution of a resin having the following structure (the numerical value appended to the main chain indicates the molar ratio of the constitutional unit; weight-average molecular weight: 11,000; acid value: 195.4 mgKOH/g)

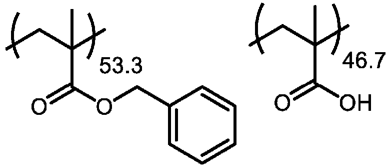

C-3: 30% by mass PGMEA solution of a resin having the following structure (the numerical value appended to the main chain indicates the molar ratio of the constitutional unit, and the numerical value appended to the side chain indicates the number of the constitutional units; weight-average molecular weight: 20,000; acid value: 94.7 mgKOH/g; C=C value: neutral/salt = 0.62/0.12 (mmol/g))

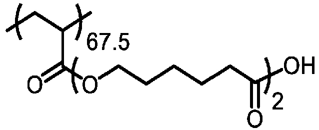

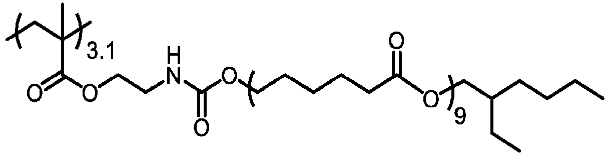

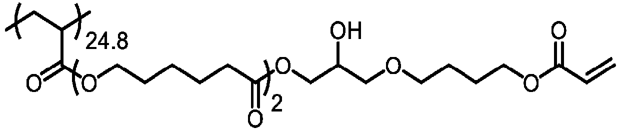

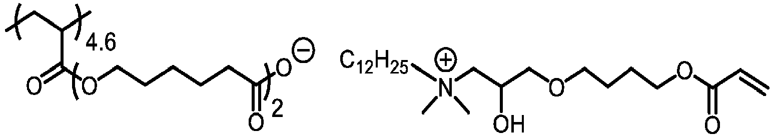

CC-1: 30% by mass PGMEA solution of a resin having the following structure (weight-average molecular weight: 20,000)

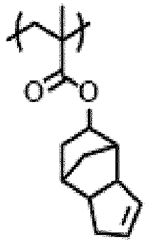

### (Polymerizable monomer (polymerizable compound))

M-1: KAYARAD DPHA (manufactured by Nippon Kayaku Co., Ltd.; compound having an ethylenically unsaturated bond-containing group)
M-2: NK ESTER A-TMMT (manufactured by Shin-Nakamura Chemical Co., Ltd., compound having an ethylenically unsaturated bond-containing group)
M-3: M-305 (manufactured by Toagosei Co., Ltd., compound having an ethylenically unsaturated bond-containing group)
M-4: M-350 (manufactured by Toagosei Co., Ltd., compound having an ethylenically unsaturated bond-containing group)
CM-1: NK ESTER A-DPH-12ET (manufactured by Shin-Nakamura Chemical Co., Ltd., compound having an ethylenically unsaturated bond-containing group)

### (Photopolymerization initiator)

I-1 to I-3 and CI-1: compounds having the following structures

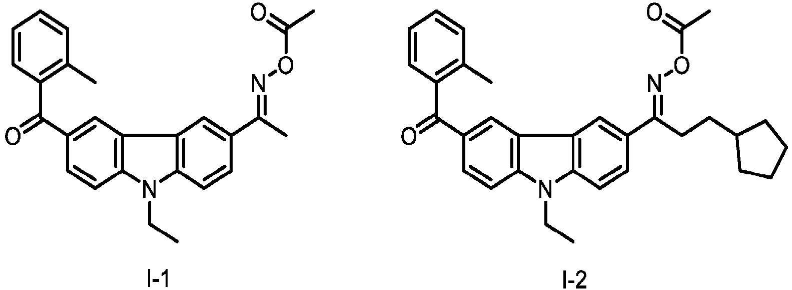

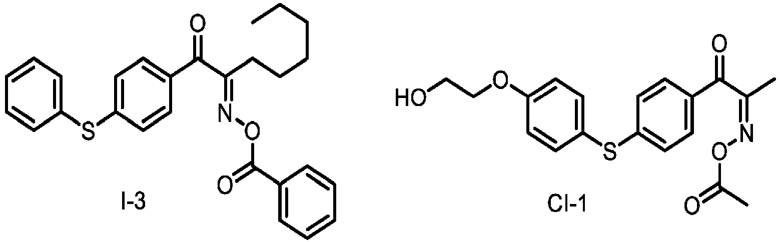

### (Polymerization inhibitor)

In-1: p-methoxyphenol

### (Additive)

A-1: compound having the following structure (molecular weight: 2,300, compound having a cyclic ether group)
A-2 to A-6: compounds having the following structures

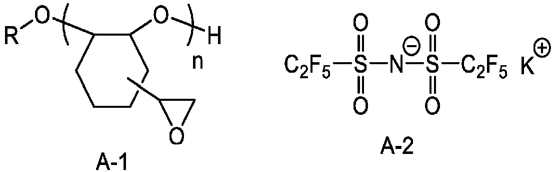

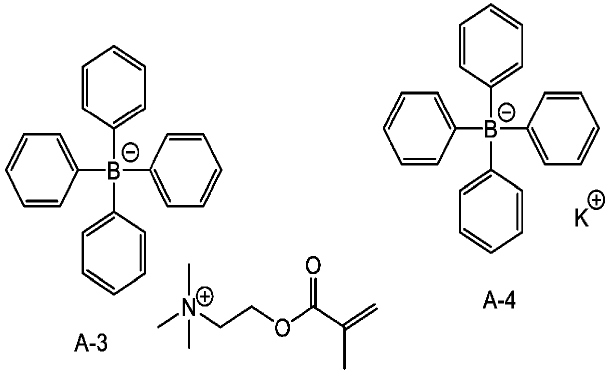

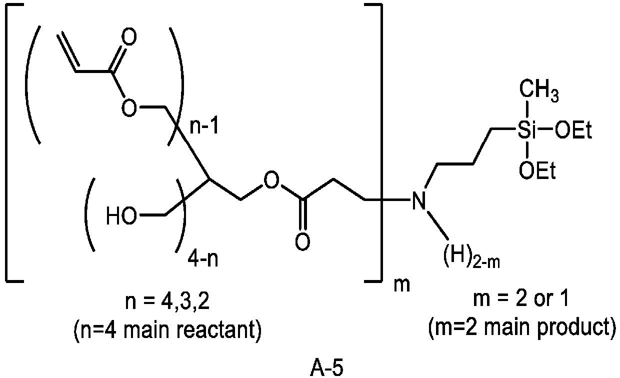

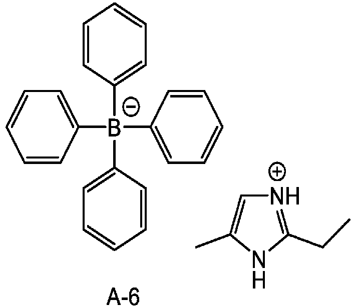

### (Specific Compound)

P-1: polyethylene glycol 200 (compound having the following structure, number-average molecular weight: 200)
P-2: polyethylene glycol 400 (compound having the following structure, number-average molecular weight: 400)
P-3: polyethylene glycol 1,000 (compound having the following structure, number-average molecular weight: 1,000)
P-4: polyethylene glycol 20,000 (compound having the following structure, number-average molecular weight: 20,000)
P-5: polyethylene glycol monomethyl ether 550 (compound having the following structure, number-average molecular weight: 550)
P-6: polyethylene glycol dimethyl ether 550 (compound having the following structure, number-average molecular weight: 550)
P-7: diethylene glycol monoethyl ether (compound having the following structure, molecular weight: 134)
P-8: triethylene glycol monoethyl ether (compound having the following structure, molecular weight: 178)
P-9: ethylene glycol monobutyl ether (compound having the following structure, molecular weight: 118)
P-10: triethylene glycol monobutyl ether (compound having the following structure, molecular weight: 206)
P-11: (2-butoxyethoxy)acetic acid (compound having the following structure, molecular weight: 176)
P-12: 2-[2-(2-aminoethoxy)ethoxy]ethanol (compound having the following structure, molecular weight: 149)

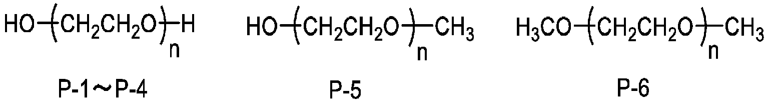

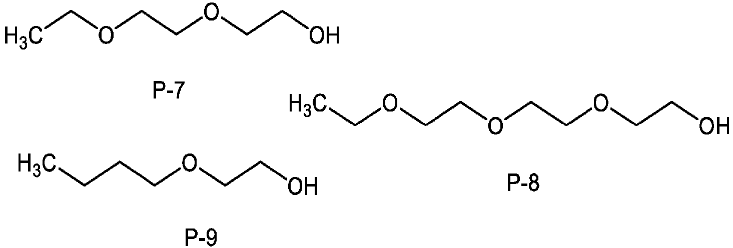

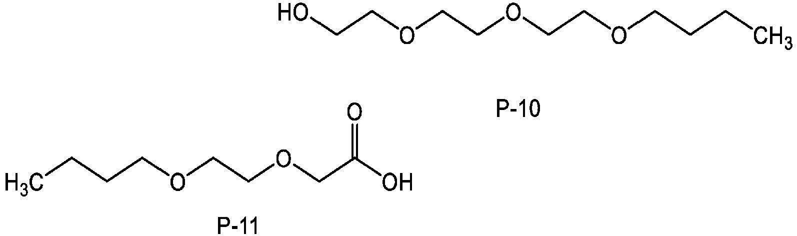

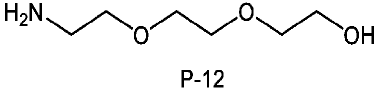

### (Surfactant)

W-1: KF-6001 (manufactured by Shin-Etsu Chemical Co., Ltd.)

### (Solvent)

S-1: Propylene glycol monomethyl ether acetate (PGMEA)
S-3: cyclohexanone

### <Evaluations>

### (Pixel chipping)

A composition for an undercoat layer (CT-4000, manufactured by Fujifilm Electronic Materials Co., Ltd.) was applied onto a silicon wafer (substrate A) having a diameter of 8 inches or a support (substrate B) on which partition walls having a height of 0.5 µm and a width of 0.15 µm were formed in a lattice shape at an interval of 1.0 µm, such that a film thickness was 0.1 µm, by a spin coating method, and heated at 220°C for 1 hour using a hot plate to form an undercoat layer. Each photosensitive composition was applied onto the silicon wafer with the undercoat layer using a spin coater (manufactured by Mikasa Seisakusho Ltd.) such that the film thickness after pre-baking was 0.6 µm, thereby forming a coating film. Next, the coating film was heated (pre-baked) at 100°C for 2 minutes using a hot plate. Next, the film was exposed through a mask having a Bayer pattern of 1.0 µm square at an exposure amount of 1,000 mJ/cm², using an i-ray stepper exposure apparatus FPA-3000i5+ (manufactured by Canon Inc.). Next, puddle development was performed at 23°C for 60 seconds using a 0.3% by mass of tetramethylammonium hydroxide (TMAH) aqueous solution. Thereafter, the coating film was rinsed by a spin shower, and further washed with pure water to form pixels. The silicon wafer on which the pixels were formed was divided, platinum vacuum evaporation was performed, and then a cross-sectional scanning electron microscope (SEM) image of the pixels was obtained using a scanning electron microscope (manufactured by Hitachi High-Tech Corporation). 100 pixels were extracted from the obtained surface SEM image, the number of pixels in which chipping having a size of 0.1 µm or more was observed on the pixel surface was measured, and the pixel chipping was evaluated according to the following evaluation standard. In the tables, "-" means that the evaluation was not performed. That is, the evaluation of the pixel chipping on the substrate B was performed only for Examples 1 to 10 and 55 to 57 and Comparative Example 1.

### -Evaluation standard-

5: among 100 pixels, the number of pixels in which chipping having a size of 0.1 µm or more was observed was 0.
4: among 100 pixels, the number of pixels in which chipping having a size of 0.1 µm or more was observed was 1 or more and less than 5.
3: among 100 pixels, the number of pixels in which chipping having a size of 0.1 µm or more was observed was 5 or more and less than 10.
2: among 100 pixels, the number of pixels in which chipping having a size of 0.1 µm or more was observed was 10 or more and less than 50.
1: among 100 pixels, the number of pixels in which chipping having a size of 0.1 µm or more was observed was 50 or more.

### (Sensitivity)

A composition for an undercoat layer (CT-4000, manufactured by Fujifilm Electronic Materials Co., Ltd.) was applied onto a silicon wafer having a diameter of 8 inches by a spin coating method such that a film thickness was 0.1 µm, and then heated at 220°C for 1 hour using a hot plate to form an undercoat layer. Each photosensitive composition was applied onto the silicon wafer with the undercoat layer using a spin coater (manufactured by Mikasa Co., Ltd.) such that the film thickness after pre-baking was 0.6 µm, thereby forming a coating film. Next, the coating film was heated (pre-baked) at 100°C for 2 minutes using a hot plate. Next, the coating film was exposed through a mask having a Bayer pattern of 1.0 µm square using an i-ray stepper exposure device FPA-3000 i5+ (manufactured by Canon Inc.). Next, puddle development was performed at 23°C for 60 seconds using a 0.3% by mass of tetramethylammonium hydroxide (TMAH) aqueous solution. Thereafter, the coating film was rinsed by a spin shower, and further washed with pure water to form pixels. The upper surface of the pixel was observed using a scanning electron microscope (SEM) to evaluate a line width of the pixel according to the following evaluation standard. In the tables, "-" means that the evaluation was not performed.

### -Evaluation standard-

5: exposure amount at which the line width reached 1.0 µm was less than 100 mJ.
4: exposure amount at which the line width reached 1.0 µm was 100 mJ or more and less than 300 mJ.
3: exposure amount at which the line width reached 1.0 µm was 300 mJ or more and less than 1,000 mJ.
2: exposure amount at which the line width reached 1.0 µm was 1,000 mJ or more and less than 2,000 mJ.
1: exposure amount at which the line width reached 1.0 µm was 2,000 mJ or more.

### (Developability)

A composition for an undercoat layer (CT-4000, manufactured by Fujifilm Electronic Materials Co., Ltd.) was applied onto a glass wafer having a diameter of 8 inches by a spin coating method such that a film thickness was 0.1 µm, and then heated at 220°C for 1 hour using a hot plate to form an undercoat layer. Each photosensitive composition was applied onto the silicon wafer with the undercoat layer using a spin coater (manufactured by Mikasa Co., Ltd.) such that the film thickness after pre-baking was 0.6 µm, thereby forming a coating film. Next, puddle development was performed at 23°C for 60 seconds using a 0.3% by mass tetramethylammonium hydroxide aqueous solution. Thereafter, rinsing with a spin shower and water washing with pure water were performed to obtain a glass wafer after development. The maximum value (ΔAbs) of the difference in absorbance at 400 to 700 nm between the glass wafer after development and the glass wafer with an undercoat layer, on which the photosensitive composition was not applied, was measured, and the developability was evaluated according to the following evaluation standard. The smaller the ΔAbs, the better the developability. In the tables, "-" means that the evaluation was not performed.

### -Evaluation standard-

5: ΔAbs was 0.01 or less.
4: ΔAbs was more than 0.01 and 0.02 or less.
3: ΔAbs was more than 0.02 and 0.03 or less.
2: ΔAbs was more than 0.03 and 0.04 or less.
1: ΔAbs was more than 0.04.

**[Table 8]**

| | Pixel chipping | | Sensitivity | Developability |
|---|---|---|---|---|
| | Substrate A | Substrate B | | |
| Example 1 | 5 | 5 | 5 | 3 |
| Example 2 | 5 | 5 | 5 | 3 |
| Example 3 | 4 | 3 | 5 | 3 |
| Example 4 | 3 | 3 | 5 | 3 |
| Example 5 | 4 | 3 | 4 | 4 |
| Example 6 | 4 | 3 | 3 | 5 |
| Example 7 | 4 | 3 | 4 | 4 |
| Example 8 | 4 | 3 | 4 | 4 |
| Example 9 | 4 | 3 | 4 | 4 |
| Example 10 | 3 | 3 | 4 | 4 |
| Example 11 | 5 | - | 5 | 4 |
| Example 12 | 5 | - | 5 | 5 |
| Example 13 | 5 | - | 5 | 3 |
| Example 14 | 5 | - | 5 | 3 |
| Example 15 | 5 | - | 5 | 3 |
| Example 16 | 5 | - | 5 | 3 |
| Example 17 | 5 | - | 5 | 3 |
| Example 18 | 5 | - | 5 | 3 |
| Example 19 | 5 | - | 5 | 3 |
| Example 20 | 5 | - | 5 | 3 |
| Example 21 | 5 | - | 5 | 3 |
| Example 22 | 5 | - | 5 | 3 |
| Example 23 | 5 | - | 5 | 3 |
| Example 24 | 5 | - | 5 | 3 |
| Example 25 | 4 | - | 5 | 3 |
| Example 26 | 3 | - | 5 | 3 |
| Example 27 | 4 | - | 4 | 4 |
| Example 28 | 4 | - | 3 | 5 |
| Example 29 | 4 | - | 4 | 4 |
| Example 30 | 4 | - | 4 | 4 |
| Example 31 | 4 | - | 4 | 4 |
| Example 32 | 3 | - | 4 | 4 |
| Example 33 | 5 | - | 5 | 4 |
| Example 34 | 5 | - | 5 | 5 |
| Example 35 | 5 | - | 5 | 4 |
| Example 36 | 5 | - | 5 | 4 |
| Example 37 | 5 | - | 5 | 4 |
| Example 38 | 5 | - | 5 | 4 |
| Example 39 | 5 | - | 5 | 3 |
| Example 40 | 5 | - | 5 | 3 |

**[Table 9]**

| | Pixel chipping | | Sensitivity | Developability |
|---|---|---|---|---|
| | Substrate A | Substrate B | | |
| Example 41 | 4 | - | 5 | 3 |
| Example 42 | 3 | - | 5 | 3 |
| Example 43 | 4 | - | 4 | 4 |
| Example 44 | 4 | - | 3 | 5 |
| Example 45 | 4 | - | 4 | 4 |
| Example 46 | 4 | - | 4 | 4 |
| Example 47 | 4 | - | 4 | 4 |
| Example 48 | 3 | - | 4 | 4 |
| Example 49 | 5 | - | 5 | 4 |
| Example 50 | 5 | - | 5 | 5 |
| Example 51 | 5 | - | 5 | 3 |
| Example 52 | 5 | - | 5 | 3 |
| Example 53 | 5 | - | 5 | 3 |
| Example 54 | 5 | - | 5 | 3 |
| Example 55 | 5 | 5 | 5 | 3 |
| Example 56 | 4 | 2 | 4 | 4 |
| Example 57 | 4 | 2 | 4 | 4 |
| Comparative Example 1 | 2 | 1 | - | - |

As shown in the above tables, in Examples, the occurrence of the chipping of the pixel could be suppressed.

### (Examples 1001 to 1048)

A photosensitive composition was produced in the same manner as in Examples 1 to 16, except that the dispersion liquid R-2 of Examples 1 to 16 was replaced with the dispersion liquid R-1, R-3, or R-4; and each evaluation was performed under the same conditions, and as a result, the same evaluation results as in each of Examples were obtained.

### (Examples 3001 to 3096)

A photosensitive composition was produced in the same manner as in Examples 23 to 38, except that the dispersion liquid B-1 of Examples 23 to 38 was replaced with the dispersion liquid B-2, B-3, B-4, B-5, B-6, or B-7; and each evaluation was performed under the same conditions, and as a result, the same evaluation results as in each of Examples were obtained.

### (Examples 5001 to 5160)

A photosensitive composition was produced in the same manner as in Examples 39 to 54, except that the dispersion liquid G-1 of Examples 39 to 54 was replaced with the dispersion liquid G-2, G-3, G-4, G-5, G-6, G-7, G-8, G-9, G-10, or G-11; and each evaluation was performed under the same conditions, and as a result, the same evaluation results as in each of Examples were obtained.

### <Production of composition for partition wall>

### (Compositions 1 to 3 and 6 to 8 for partition wall)

Each component was mixed to have the following formulation (the numerical value of the blending amount is in terms of parts by mass), and filtration was performed using a DFA4201NIEY (0.45 µm nylon filter) manufactured by Nihon Pall Corporation to produce compositions 1 to 3 and 6 to 8 for a partition wall.

**[Table 10]**

| | Silica particle solution | | Surfactant | | Silane coupling agent | | Solvent | |
|---|---|---|---|---|---|---|---|---|
| | Type | Blending amount | Type | Blending amount | Type | Blending amount | Type | Blending amount |
| Composition for partition wall 1 | P1 | 44.8 | W-11 | 0.2 | - | - | S-11 | 8 |
| | | | | | | | S-13 | 43 |
| | | | | | | | S-14 | 2 |
| | | | | | | | S-15 | 1 |
| | | | | | | | S-16 | 1 |
| Composition for partition wall 2 | P2 | 44.8 | W-11 | 0.2 | - | - | S-11 | 8 |
| | | | | | | | S-12 | 43 |
| | | | | | | | S-14 | 2 |
| | | | | | | | S-15 | 1 |
| | | | | | | | S-16 | 1 |
| Composition for partition wall 3 | P1 | 44.8 | W-11 | 0.2 | - | - | S-11 | 8 |
| | | | | | | | S-12 | 30 |
| | | | | | | | S-14 | 2 |
| | | | | | | | S-15 | 1 |
| | | | | | | | S-16 | 1 |
| | | | | | | | S-17 | 13 |
| Composition for partition wall 6 | P3 | 26.1 | W-12 | 0.01 | SC-1 | 0.6 | S-11 | 14 |
| | | | | | | | S-12 | 55 |
| | | | | | | | S-14 | 2.3 |
| | | | | | | | S-15 | 1 |
| | | | | | | | S-16 | 1 |
| Composition for partition wall 7 | P1 | 12.5 | W-11 | 0.05 | - | - | S-11 | 31 |
| | | | | | | | S-12 | 23 |
| | | | | | | | S-13 | 31 |
| | | | | | | | S-15 | 1.55 |
| | | | | | | | S-16 | 0.5 |
| | | | | | | | S-18 | 0.2 |
| | | | | | | | S-19 | 0.2 |
| Composition for partition wall 8 | P1 | 12.5 | W-11 | 0.05 | - | - | S-11 | 9 |
| | | | | | | | S-12 | 33 |
| | | | | | | | S-13 | 43 |
| | | | | | | | S-15 | 1.55 |
| | | | | | | | S-16 | 0.5 |
| | | | | | | | S-18 | 0.2 |
| | | | | | | | S-19 | 0.2 |

The raw materials shown above in the table are as follows.

### (Silica particle solution)

P1: silica particle solution which was prepared by adding 3.0 g of trimethylmethoxysilane as a hydrophobizing treatment agent to 100.0 g of a propylene glycol monomethyl ether acetate solution (silica particle concentration: 20% by mass) of silica particles (beaded silica) in which a plurality of spherical silicas having an average particle diameter of 15 nm were linked in a beaded shape by metal oxide-containing silica (linking material), and reacting the mixture at 20°C for 6 hours. As the average particle diameter of the spherical silica in the silica particle solution P1, the number average of circle-equivalent diameters in a projection image of the spherical portions of 50 spherical silicas measured by a transmission electron microscope (TEM) was calculated and obtained. In addition, in the silica particle solution P1, by a method of TEM observation, it was investigated whether or not the silica particle solution included silica particles having a shape in which a plurality of spherical silicas were connected in a beaded shape.

P2: THRULYA 4110 (manufactured by JGC C&C, a solution of silica particles (silica particles having a hollow structure) having an average particle diameter of 60 nm and a concentration of solid contents of 20 mass% in terms of SiO₂
P3: silica particle solution P3 prepared by the following method

100 g of a silica sol having an average particle diameter of 5 nm and an SiO₂ concentration of 20% by mass and 1,900 g of pure water were mixed to prepare a reaction mother liquor, and the reaction mother liquor was heated to 80°C. The pH of the reaction mother liquor was 10.5, and 9,000 g of a sodium silicate aqueous solution of 1.17% by mass and 9,000 g of a sodium aluminate aqueous solution of 0.83% by mass were simultaneously added to the same mother liquor as SiO₂ and Al2O3, respectively. During the period, the temperature of the reaction solution was maintained at 80°C. The pH of the reaction solution increased to 12.5 immediately after the addition of the sodium silicate and the sodium aluminate, and then hardly changed. After the addition was completed, the reaction solution was cooled to room temperature and washed with an ultrafiltration membrane to prepare a SiO₂·Al₂O₃ primary particle dispersion liquid having a concentration of solid contents of 20% by mass. Next, 500 g of the SiO₂·Al₂O₃ primary particle dispersion liquid was collected, 1,700 g of pure water was added thereto, and the mixture was heated to 98°C. While maintaining this temperature, 50,400 g of sodium sulfate having a concentration of 0.5% by mass was added thereto, and then 3,000 g of a sodium silicate aqueous solution having a concentration of 1.17% by mass as SiO₂ and 9,000 g of a sodium aluminate aqueous solution having a concentration of 0.5% by mass as Al₂O₃ were added thereto to obtain a composite oxide fine particle dispersion liquid. The composite oxide fine particle dispersion liquid was washed with an ultrafiltration membrane to obtain a composite oxide fine particle dispersion liquid having a concentration of solid contents of 13% by mass. 1,125 g of pure water was added to 500 g of the composite oxide fine particle dispersion liquid, and concentrated hydrochloric acid (35.5%) was further added dropwise thereto to adjust the pH to 1.0, and a de-aluminum treatment was performed. Next, the aluminum salt dissolved in the ultrafiltration membrane was separated while adding 10 L of a hydrochloric acid aqueous solution having a pH of 3 and 5 L of pure water, and the aluminum salt was washed to obtain a dispersion liquid of silica-based fine particles (1) having a concentration of solid contents of 20% by mass. 500 g of pure water, 1,750 g of ethanol, and 626 g of 28% ammonia water were added to 1,500 g of an aqueous dispersion liquid of the silica-based fine particles (1), and the obtained mixed solution was heated to 35°C, and then 104 g of ethyl silicate (SiO₂: 28% by mass) was added thereto. Next, 5 L of pure water was added thereto, and the mixture was washed with an ultrafiltration membrane to prepare a dispersion liquid of silica-based fine particles (2) having a concentration of solid contents of 20% by mass. Next, the dispersion liquid of the silica-based fine particles (2) was subjected to a hydrothermal treatment at 200°C for 11 hours, and then washed with an ultrafiltration membrane while adding 5 L of pure water to adjust the concentration of solid contents to 20% by mass. Using an ultrafiltration membrane, the dispersion medium of the dispersion liquid was substituted with propylene glycol monomethyl ether to prepare an organosol having a concentration of solid contents of 20% by mass. The organosol is an organosol in which hollow silica fine particles having an average particle diameter of 23 nm are dispersed (hereinafter, referred to as "hollow silica sol A"). 200 g of the hollow silica sol A (silica concentration of solid contents: 20% by mass) was prepared, and the solvent substitution with methanol was performed using an ultrafiltration membrane to prepare 100 g of an organosol having a SiO₂ content of 20% by mass (moisture content: 0.5% by mass with respect to the SiO₂ content). 28% ammonia aqueous solution was added thereto such that the ammonia content was 100 ppm by mass with respect to 100 g of the organosol, and the mixture was sufficiently mixed. Next, 4 g of methacrylsilane (KBM503 manufactured by Shin-Etsu Chemical Co., Ltd.) (equivalent to 20 parts by mass with respect to 100 parts by mass of the SiO₂ content) was added thereto to obtain a reaction solution (moisture content: 0.6% by mass with respect to the SiO2 content). The mixture was heated to 50°C, and heated at 50°C for 15 hours while being stirred. After the heating was completed, the reaction solution was cooled to normal temperature and washed with an ultrafiltration membrane to prepare a silica particle solution P3 consisting of coated hollow fine particles having a SiO2 concentration of 20% by mass.

### (Surfactant)

W-11: compound having the following structure (silicone-based nonionic surfactant, carbinol-modified silicone compound, weight-average molecular weight = 3000, kinematic viscosity at 25°C = 45 mm²/s) 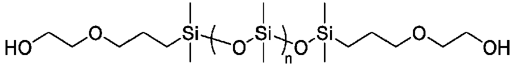
W-12: compound having the following structure

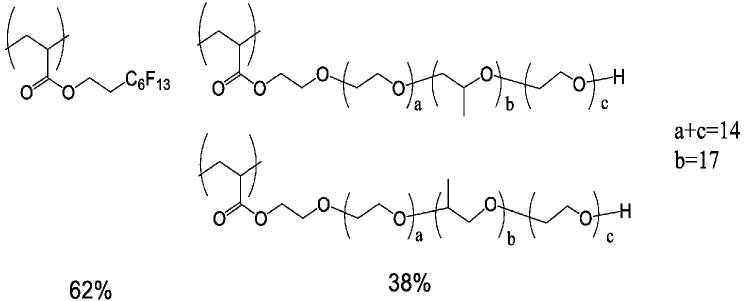

### (Silane coupling agent)

SC-1: additive A-5 described above

### (Solvent)

S-11: 1,4-butanediol diacetate
S-12: propylene glycol monomethyl ether acetate
S-13: propylene glycol monomethyl ether
S-14: methanol
S-15: ethanol
S-16: water
S-17: compound having the following structure 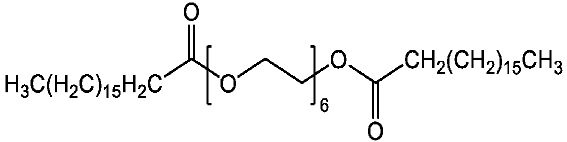
S-18: 1-propanol
S-19: 2-propanol

### (Composition 4 for partition wall)

300 g of powder of a cation exchange resin (WK-40, manufactured by Mitsubishi Chemical Corporation) was added to 1000 g of an aqueous solution containing 40% by mass of tetrapropylammonium hydroxide (TPAOH, manufactured by Lion Corporation), and the mixture was stirred at a rate of 100 rpm for 1 hour under a room temperature condition, and then the added cation exchange resin powder was filtered and removed. Next, 2100 g of powder of an anion exchange resin (SAT-10, manufactured by Mitsubishi Chemical Corporation) was added thereto, and the mixture was stirred at a rate of 100 rpm for 1 hour under a room temperature condition, and then the added anion exchange resin powder was filtered and removed. Ultra-pure water was added to the obtained aqueous solution of tetrapropylammonium hydroxide (TPAOH) to adjust the concentration to 10% by mass, and the amounts of compounds of alkali metal elements of sodium (Na) and potassium (K) and compounds of halogen group elements of bromine (Br) and chlorine (Cl), which were contained as impurities in the aqueous solution, were measured by atomic absorption spectrometry (Polarization Zeeman atomic absorption spectrometer Z-5710, manufactured by Hitachi, Ltd.) and ion chromatography (DIONEX 2020i, manufactured by Thermo Fisher Scientific, Inc.). Furthermore, ultrapure water was added to the aqueous solution of tetrapropylammonium hydroxide (commercially available product) before the ion exchange treatment to adjust the concentration to 10% by mass, and then the content of impurities contained therein was measured in the same manner. As a result, the amounts of impurities contained in the aqueous solution before the ion exchange treatment were 50 ppm by mass of sodium, 2500 ppm by mass of potassium, 2250 ppm by mass of bromine, and 13 ppm by mass of chlorine in terms of elements, whereas the contents of impurities contained in the aqueous solution after the ion exchange treatment were 10 ppb by mass or less of sodium (detection limit), 10 ppb by mass of potassium (detection limit), 1 ppm by mass or less of bromine, and 1 ppm by mass or less of chlorine in terms of elements. Next, tetraethyl orthosilicate (TEOS, manufactured by Tama Chemicals Co., Ltd.), methyltrimethoxysilane (MTMS, manufactured by Shin-Etsu Chemical Co., Ltd.), and ethanol (ETOH, manufactured by FUJIFILM Wako Pure Chemical Corporation) having a concentration of 99.5% by mass were mixed, and this mixed solution was kept at a temperature of 20°C and stirred at a rate of 150 rpm for 30 minutes. A highly purified aqueous solution of tetrapropylammonium hydroxide (containing 10% by mass of TPAOH) was added dropwise to the mixed solution over 10 minutes, and the mixture was further stirred at a rate of 200 rpm for 1 hour at a temperature of 20°C. Thereafter, the mixture was heated to a temperature of 50°C, and hydrolysis of the silica-based film-forming component (TEOS and MTMS) was carried out for 20 hours while stirring at a rate of 200 rpm under this temperature condition. Next, the ethanol in the mixed solution containing the hydrolysate of the silica-based film-forming component was subjected to a step of solvent substitution with propylene glycol monopropyl ether using a rotary evaporator, and then the concentration of the silicon compound consisting of the hydrolysates of tetraethyl orthosilicate (TEOS) and methyltrimethoxysilane (MTMS) was adjusted to obtain a liquid composition containing 12% by mass of the compound in terms of SiO₂ conversion. The liquid composition was used as a composition 4 for a partition wall.

### (Composition 5 for partition wall)

0.05 g (0.4 mmol) of methyltrimethoxysilane (KBM-13, manufactured by Shin-Etsu Chemical Co., Ltd.), 0.66 g (3.0 mmol) of trifluoropropyltrimethoxysilane (KBM-7103, manufactured by Shin-Etsu Chemical Co., Ltd.), 0.10 g (0.4 mmol) of trimethoxysilylpropyl succinic anhydride (KBM-967, manufactured by Shin-Etsu Chemical Co., Ltd.), 7.97 g (34 mmol) of γ-acryloxypropyltrimethoxysilane (KBM-5103, manufactured by Shin-Etsu Chemical Co., Ltd.), and 224.37 g of an isopropyl alcohol dispersion liquid (IPA-ST-UP, manufactured by Nissan Chemical Corporation) of silica particles having a concentration of 15.6% by mass were mixed in a 500 ml three-neck flask, and 163.93 g of ethylene glycol mono-t-butyl ether was added thereto. A phosphoric acid aqueous solution obtained by dissolving 0.088 g of phosphoric acid in 4.09 g of water was added thereto over 3 minutes while stirring at room temperature. Thereafter, the flask was immersed in an oil bath at 40°C and stirred for 60 minutes, and then the temperature of the oil bath was raised to 115°C over 30 minutes. One hour after the start of the temperature increase, the internal temperature of the solution reached 100°C, and the solution was heated and stirred for 2 hours from there (the internal temperature was 100°C to 110°C), thereby obtaining a composition 4 for a partition wall. The concentration of solid contents of the obtained composition 4 for a partition wall was 24.3% by mass, and the contents of polysiloxane and silica particles in the solid contents were 15% by mass and 85% by mass, respectively.

### <Production of composition for forming undercoat layer>

### (Composition 1 for forming undercoat layer)

0.1 parts by mass of a resin A having the following structure (weight-average molecular weight: 20,000, the numerical value described together with the main chain indicates a mass ratio of a repeating unit), 0.01 parts by mass of an epoxy compound (the above-described additive A-1), 0.01 parts by mass of a surfactant (KF-6000, manufactured by Shin-Etsu Chemical Co., Ltd.), and 99.88 parts by mass of propylene glycol monomethyl ether acetate were mixed to produce a composition 1 for forming an undercoat layer.

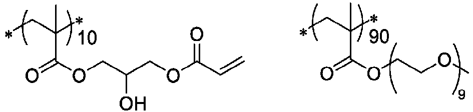

### (Composition 2 for forming undercoat layer)

0.7 parts by mass of a resin (CYCLOMER P (ACA) 230AA, manufactured by Daicel-Allnex Ltd.), 0.8 parts by mass of a surfactant (KF-6000, manufactured by Shin-Etsu Chemical Co., Ltd.), and 98.5 parts by mass of propylene glycol monomethyl ether acetate were mixed to produce a composition 2 for forming an undercoat layer.

### (Composition 3 for forming undercoat layer)

0.3 parts by mass of the above-described resin A, 0.02 parts by mass of a polymerizable compound (KAYARAD DPHA, manufactured by Nippon Kayaku Co., Ltd.), 0.01 parts by mass of a surfactant (KF-6000, manufactured by Shin-Etsu Chemical Co., Ltd.), and 99.67 parts by mass of propylene glycol monomethyl ether acetate were mixed to produce a composition 3 for forming an undercoat layer.

### <Production of lens material composition>

### (Lens material composition 1)

10 parts by mass of a resin having the following structure (weight-average molecular weight: 19,000, the numerical value added to the main chain indicates a molar ratio of a repeating unit), 0.01 parts by mass of a surfactant (FTERGENT DFX-18, manufactured by NEOS COMPANY LIMITED), 51.4 parts by mass of propylene glycol monomethyl ether acetate, and 22.0 parts by mass of propylene glycol monomethyl ether were mixed to produce a lens material composition 1.

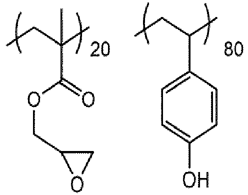

### <Production of Solid-State Imaging Element>

As a support, a silicon wafer having a diameter of 8 inches (20.32 cm) on which a silicon photodiode had been formed was used. Any one of the compositions 1 to 8 for a partition wall was applied onto the surface of the silicon wafer on the side on which the silicon photodiode was formed by a spin coating method so that the film thickness was 350 nm after post-baking, and then heated using a hot plate at 100°C for 120 seconds and at 200°C for 300 seconds to form a film. In a case where the composition 5 for a partition wall was used, the film was formed by further heating at 300°C for 10 minutes. These films were patterned by a dry etching method under the conditions described in paragraph Nos. 0128 to 0133 of JP2016-014856A to form partition walls in a lattice shape at a pitch of 0.7 µm.

Any one of the compositions 1 to 3 for an undercoat layer produced above was applied onto the surface of the silicon wafer on which the partition walls were formed and the surface of the partition walls by a spin coating method, and the silicon wafer and the surface of the partition walls were heated using a hot plate at 100°C for 2 minutes and at 230°C for 2 minutes to form an undercoat layer having a film thickness of 10 nm.

Next, a composition for forming pixels of the first color was applied onto the surface of the silicon wafer on which the partition walls were formed by a spin coating method, and then the silicon wafer was heated using a hot plate at 100°C for 2 minutes to form a composition layer of the first color. Next, using an i-ray stepper exposure device FPA-3000 i5+ (manufactured by Canon Inc.), the above-described composition layer was exposed through a mask having a Bayer pattern at an exposure amount of 150 mJ/cm². Next, puddle development was performed on the composition layer at 23°C for 60 seconds using a 0.3% by mass aqueous solution of tetramethylammonium hydroxide (TMAH). Thereafter, rinsing by a spin shower and water washing using pure water were performed, and the silicon wafer was further heated using a hot plate at 220°C for 5 minutes to form pixels of the first color in regions partitioned by the partition walls on the silicon wafer. The composition for forming pixels of the second color and the composition for forming pixels of the third color were also developed and exposed by the same method as the composition for forming pixels of the first color, and pixels of the second color and pixels of the third color were sequentially formed in a region partitioned by the partition walls on the silicon wafer to form an optical filter. As the composition for forming pixels of the first color, the photosensitive composition of Example 1 was used. As the composition for forming pixels of the second color, the photosensitive composition of Example 39 was used. As the composition for forming pixels of the third color, the photosensitive composition of Example 23 was used.

Next, the lens material composition 1 was applied onto the optical filter by a spin coating method, the optical filter was heated using a hot plate at 100°C for 2 minutes, and then the optical filter was heated using a hot plate at 200°C for 5 minutes to form a lens material composition layer having a film thickness of 1.2 µm. Thereafter, a microlens was formed by processing the lens material composition layer, using a known transfer method employing etch-back, so that the height from the lens top to the lens bottom became 400 nm, thereby producing a solid-state imaging element.

The compositions 1 to 8 for a partition wall, used for producing the solid-state imaging element, can also be used as a low refractive index material for a metamaterial, a low refractive index material for a metasurface, an optical member including a metasurface, a low refractive index material for a color filter, or a low refractive index material for an antireflection layer.

### Explanation of References

10: support
11: partition wall

## Claims

1. A photosensitive composition comprising:
a coloring material;
a resin;
a polymerizable compound;
a photopolymerization initiator;
a solvent; and
a compound A represented by Formula (1), 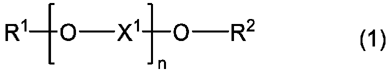
in Formula (1), R¹ and R² each independently represent a hydrogen atom, an alkyl group having 1 to 6 carbon atoms, an aryl group having 6 to 12 carbon atoms, a group having 1 to 6 carbon atoms, which includes an acid group, or a group having 1 to 6 carbon atoms, which includes an amino group, X¹ represents a linear or branched alkylene group, n represents an integer of 1 or more, and in a case where n is 2 or more, a plurality of X¹'s may be the same or different from each other.

2. The photosensitive composition according to claim 1, wherein at least one of X¹'s in Formula (1) is an ethylene group, and R¹ and R² are each independently a hydrogen atom or an alkyl group having 1 to 6 carbon atoms.

3. The photosensitive composition according to claim 1, wherein X¹ in Formula (1) is an ethylene group, and R¹ and R² are each independently a hydrogen atom or an alkyl group having 1 to 6 carbon atoms.

4. The photosensitive composition according to any one of claims 1 to 3, wherein R¹ and R² in Formula (1) are hydrogen atoms.

5. The photosensitive composition according to any one of claims 1 to 3, wherein a molecular weight of the compound A is 150 to 2,000.

6. The photosensitive composition according to any one of claims 1 to 3, wherein a content of the compound A in the photosensitive composition is 0.01% to 5.0% by mass.

7. The photosensitive composition according to any one of claims 1 to 3, wherein a content of the coloring material is 55% by mass or more with respect to a total solid content of the photosensitive composition.

8. A film formed of the photosensitive composition according to any one of claims 1 to 3.

9. An optical filter comprising: the film according to claim 8.

10. A method for manufacturing an optical filter, comprising:
forming a composition layer on a support using the photosensitive composition according to any one of claims 1 to 3; and
forming a pattern on the composition layer by a photolithography method.

11. A solid-state imaging element comprising: the film according to claim 8.

12. An image display device comprising: the film according to claim 8.
